# EUROPEAN PATENT SPECIFICATION

(11) **EP 0 598 241 B1**
(45) Date of publication and mention of the grant of the patent: **04.02.1998**
(21) Application number: 93117072.4
(22) Date of filing: 21.10.1993
(51) Int. Cl.: G03C 8/06, G03F 7/06, G03F 7/07, G03C 1/06

(54) **Lithographic printing material**
Lithographisches Druckmaterial
Matériau d'impression lithographique

(30) Priority: 17.11.1992 JP 331072/92
(43) Date of publication of application: 25.05.1994
(73) Proprietor: FUJI PHOTO FILM CO., LTD., Kanagawa (JP)
(72) Inventor: Takagi, Yoshihiro, Fuji Photo Film Co., Ltd., Kanagawa (JP)
(74) Representative: Grünecker, Kinkeldey, Stockmair & Schwanhäusser Anwaltssozietät

(56) References cited:
- EP-A- 0 481 562
- EP-A- 0 496 127
- US-A- 4 276 364
- US-A- 4 358 528
- US-A- 5 035 984

## Description

This invention relates to a silver salt lithographic or planographic printing material, especially, to a lithographic printing material adapted to provide a negative transfer silver image. More particularly, it relates to a silver salt lithographic printing material having excellent photographic characteristics which can be processed by a silver salt diffusion transfer process into a printing plate having minimized scumming, improved ink receptivity and improved printing endurance.

There are known in the prior art a number of lithographic printing materials utilizing a silver salt transfer process. Typical printing materials have integrated together a photosensitive photographic element and a printing image element in the form of a physical development nucleus layer as disclosed in, for example, Japanese Patent Publication (JP-B) No. 42453/1971 and 30562/1973. However, they use conventional negative emulsions so that a transferred silver image forms a positive image. Systems for producing a transferred silver image as a negative image are also described in JP-B 13587/1986, 06108/1982, 26019/1981, and 26019/1981, and Japanese Patent Application Kokai (JP-A) No. 173247/1986. These systems, however, are unacceptable in practice because of low sensitivity, shortage of transferred silver, and unsatisfactory properties as printing plates including ink receptivity, printing endurance, and scumming.

In accordance with the recent advance of the computer technology, attention is now paid to a direct printing plate forming technique wherein direct exposure of a final image is done from a laser or light-emitting diode light source through an image setter. In the case of scanning exposure by e.g. laser, a lithographic printing material adapted to produce a transferred silver image of the negative type has the reduced risk of scumming because the only requirement is to expose image portions including characters, dots and lines and thus the exposed area is small. Another advantage is ease of matching with output machines such as image setters among which the negative output type is predominant. However, in practice, there are available no acceptable lithographic printing materials of the negative type because none of them can satisfy the requirements of sensitivity and printing characteristics.

One method for producing transfer silver images of the negative type uses direct reversal emulsions. The direct reversal emulsions include pre-fogged emulsions and internal latent image type emulsions. The pre-fogged emulsions have the drawbacks that sensitivity is low, it is difficult to render them red and infrared sensitive, no reversal image is available if a developing agent is incorporated therein, and they cannot be treated with activators which are substantially free of a developing agent. The internal latent image type emulsions are described in US Patent Nos. 2,592,250, 2,466,957, 2,497,875, 2,588,982, 3,317,322, 3,761,266, 3,761,276, and 3,796,577. They have high sensitivity, but suffer from the drawback that reversal becomes difficult with a developer containing a silver halide solvent.

JP-A 065951/1980 discloses a method for forming a negative image in accordance with a diffusion transfer technique of the peeling type using an internal latent image type emulsion. The developer described therein, however, is a viscous developer containing hydroxyethyl cellulose at pH 13.1 and no reference is made to treatment with an activator which is substantially free of a developing agent and conventional treatment. Lithographic printing material is not contemplated in this method.

In general, a lithographic printing plate has a printing surface including a lipophilic image area capable of receiving ink and an ink-repellent non-image area. Lithographic printing material utilizing a silver salt diffusion transfer technique uses a silver image precipitated on the printing plate surface by the diffusion transfer technique as the lipophilic image area and an area where no silver image is precipitated as the hydrophilic or ink-repellent non-image area. Lithographic printing is usually carried out using such a lithographic printing material, by supplying water and ink simultaneously to the plate surface so that the image area receives ink and the non-image area receives water both preferentially whereupon the ink on the image area is transmitted to an ink-receptive sheet, typically paper. Printed matter is obtained in this way.

The key to satisfactory printed matter is a definite difference between image and non-image areas, that is, a definite difference between hydrophobic and hydrophilic properties.

If the method of JP-A 065951/1980 is applied to lithographic printing material without modification, treatment with a viscous developer containing hydroxyethyl cellulose of a high molecular weight results in formation of a cellulose coating on the surface, which obstructs in establishing a difference between hydrophobic and hydrophilic properties, failing to provide satisfactory printing characteristics. On use of such a viscous developer, the solution is coated from a pot or the solution is spread by introducing it between a plate material and a spreading paper and squeezing the assembly by a roller. This prohibits a free choice from different sizes of plate material.

The negative diffusion transfer method using internal latent image type emulsions requires rapid fogging development because treatment is carried out in the presence of silver halide solvents. If the silver halide is dissolved prior to the completion of fogging development, then there is not obtained a good reversal image and hence, a transferred silver image of the negative type. It is thus important to take a step to secure a time lag between fogging development and dissolution of silver halide. Then the fogging agent must have strong nucleation activity. There is also a need for a nucleation accelerator capable of promoting nucleation. There is a strong need for a method for performing such rapid development.

EP 481562 Al discloses to divide a developer into two whereby reversal development with a surface developer free of a silver halide solvent is followed by diffusion transfer development with a developer containing a silver halide solvent. This allegedly prevents any deterioration of reversal development caused by the presence of a silver halide solvent in the developer. There is a desire to develop a lithographic printing material capable of lending itself to this system.

As described above, there is a need to have a lithographic printing material which can be processed into any desired size of printing plate by various types of silver salt diffusion transfer techniques and which independent of the type of processing technique, has high sensitivity and stability of processing, produces a negative transferred silver image having improved printability, and lends itself to rapid processing. None of prior art systems of the negative image type have been used in practice because a satisfactory reversal image cannot be obtained. There is a need for improvement in this regard.

EP 496127 A1 discloses an imaging element comprising on a support (i) a layer of a direct positive type silver halide emulsion, (ii) a substantially non-light sensitive layer containing a silver salt, (iii) a layer of physical development nuclei, the layer (i) being provided between the layers (ii) and (iii), and (iv) optionally comprising a hydrophilic layer between the layer of a direct positive silver halide emulsion and the substantially non-light sensitive layer and/or the layer of physical development nuclei. This document also discloses a method for obtaining a lithographic printing plate therewith.

Therefore, an object of the present invention is to provide a lithographic printing material for producing a negative transferred silver image by utilizing a silver salt diffusion transfer process which has high sensitivity and high resolving power and offers improved printing endurance and ink receptivity. Another object of the present invention is to provide a lithographic printing material which can accommodate to various high illuminance light sources such as laser light of various wavelengths and lend itself to various processing systems.

The above objects have been solved by providinq a lithographic printing material comprising at least an undercoat layer, a silver halide emulsion layer of the internal latent image type, and a physical development nucleus layer on a support, which is processed by a silver salt diffusion transfer process to provide a negative transfer silver image, wherein
there is contained at least one nucleating agent selected from compounds of the following general formula (I): 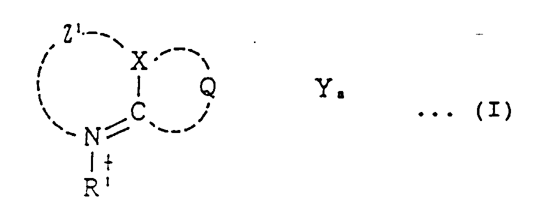 wherein
Z¹ is a group of non-metallic atoms necessary to form a five- or six-membered heterocyclic ring which may have an aromatic or heterocyclic ring fused thereto,
R¹ is an aliphatic radical,
X is a radical represented by 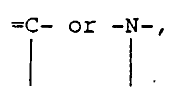
Q is a group of non-metallic atoms necessary to form a 4 to 12-membered non-aromatic hydrocarbon ring or a non-aromatic heterocyclic ring,
at least one of R¹, the substituent on Z¹, and the substituent on Q containing an alkynyl radical,
at least one of R¹, Z¹, and Q may have a radical capable of promoting adsorption to silver halide,
Y is an electric charge balancing counter ion, and
letter n has a value necessary to provide an electric charge balance, and compounds of the following general formula (II): 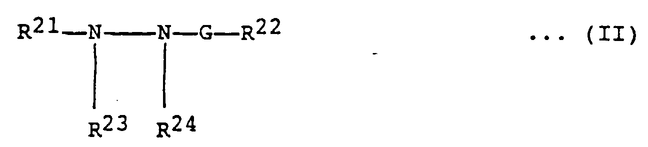 wherein
R²¹ is an aliphatic, aromatic or heterocyclic radical,
R²² is selected from the group consisting of a hydrogen atom, an alkyl, aralkyl, aryl, alkoxy, aryloxy, and amino radical,
G is selected from the group consisting of a carbonyl radical, sulfonyl radical, sulfoxy radical, phosphoryl radical, and iminomethylene radical: HN=C<,
both R²³ and R²⁴ are hydrogen atoms, or one of R²³ and R²⁴ is a hydrogen atom and the other is an alkylsulfonyl, arylsulfonyl or acyl radical, and
G, R²³, and R²⁴ may form with the hydrazine nitrogen atoms a hydrazone structure of the formula: >N-N=C<,
wherein said silver halide emulsion layer further contains at least one sensitizing dye selected from the group consisting of the compounds represented by formulae (IV) and (V): 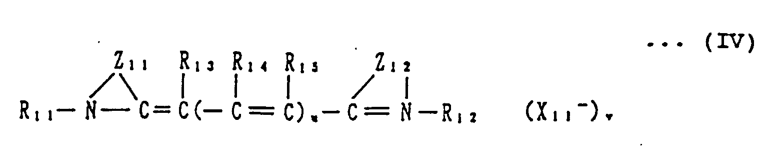 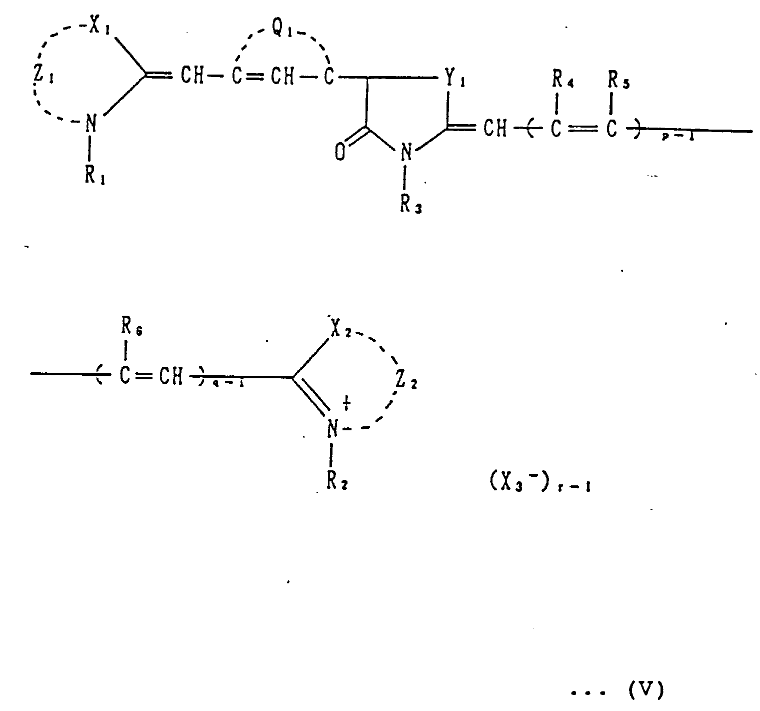
in formula (IV), Z₁₁ and Z₁₂, which may be identical or different, each represent a group of atoms forming a five or six-membered nitrogeneous heterocyclic ring with the nitrogen and carbon atoms, and letter u is equal to 0 or 1, R₁₁ and R₁₂, which may be identical or different, each represent a substituted or unsubstituted alkyl or alkenyl radical having up to 10 carbon atoms in total, R₁₃ and R₁₅ represent hydrogen atoms, or R₁₃ and R₁₁ taken together and R₁₅ and R₁₂ taken together may form a five or six-membered ring, R₁₄ is a hydrogen atom or a lower alkyl radical which may have a substituent, X₁₁ is an acid anion residue, letter v is equal to 0 or 1, and in the case of an internal salt, v is 0,
in formula (V), X₁ and X₂, which may be identical or different, each represent an oxygen atom, sulfur atom, selenium atom, a radical of the formula: >N-R₇ wherein R₇ is an alkyl radical or a radical of the formula: 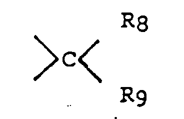
wherein R₈ and R₉ are alkyl radicals, Z₁ and Z₂, which may be identical or different, each represent a group of atoms necessary to form a five-membered nitrogenous heterocyclic ring, R₁ and R₂, which may be identical or different, each represent an alkyl or alkenyl radical, R₃ is an alkyl, alkenyl or aryl radical, R₄, R₅ and R₆, which may be identical or different, each represent a hydrogen atom, halogen atom, alkyl radical or aryl radical, Y₁ represents a sulfur atom, an oxygen atom or a radical of the formula: >N-R₁₀ wherein R₁₀ is an alkyl radical, Q₁ is a group of atoms necessary to form a five or six-membered ring by connecting to the carbon atoms of the methylene linkage, X₃ is an acid anion, and letters p, q and r each are equal to 1 or 2.

The nucleating agent is preferably contained in said silver halide emulsion layer.

The lithographic printing material of the present invention is processed by a silver salt diffusion transfer process to provide a negative transfer silver image. The lithographic printing material includes on a support at least one silver halide emulsion layer which is composed of a silver halide emulsion of the internal latent image type. The nucleating agent of formula (I) or (II) may be contained in any layer disposed on the emulsion layer side of the support. This ensures rapid fogging development to produce an acceptable reversal image, resulting in a negative transferred silver image.

Prior art diffusion transfer processes using an internal latent image type emulsion have the drawback that since a silver halide solvent is used, the silver halide is dissolved prior to the completion of fogging development, failing to produce an acceptable reversal image. The present invention overcomes this problem by using the specific nucleating agent to provide a time lag between fogging development and silver halide dissolution.

The lithographic printing material of the invention can be processed not only with a developer containing a silver halide solvent, but also with other types of developers or activators to produce a negative transferred silver image.

As a result, the lithographic printing material of the invention has high sensitivity and a high resolving power and offers improved printing endurance and ink receptivity. By changing the sensitizing dye in the silver halide emulsion layer, the material can be subject to exposure to laser light of various wavelengths and thus accommodate to exposure by a high illuminance light source. Therefore, a lithographic printing material capable of producing a negative transferred silver image can be used in practice. This is accomplished by using an internal latent image type emulsion and selecting a nucleating agent of formula (I) or (II) among many nucleating agents.

The nucleating agents of formulae (I) and (II) are described in further detail.

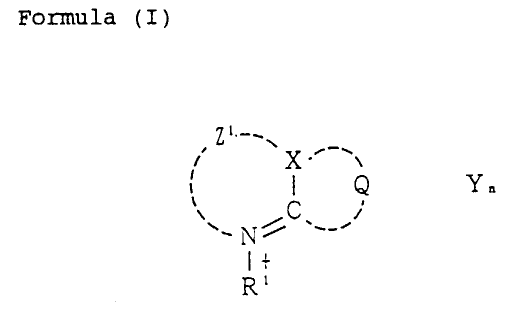

In formula (I), Z¹ is a group of non-metallic atoms necessary to form a five- or six-membered heterocyclic ring which may have an aromatic or heterocyclic ring fused thereto;
R¹ is an aliphatic radical; X is a radical represented by 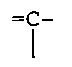 or 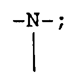 Q is a group of non-metallic atoms necessary to form a 4 to 12-membered non-aromatic hydrocarbon ring or non-aromatic heterocyclic ring; at least one of R¹, the substituent on Z¹, and the substituent on Q containing an alkynyl radical; at least one of R¹, Z¹, and Q may have a radical capable of promoting adsorption to silver halide; Y is an electric charge balancing counter ion; and letter n has a value necessary to provide an electric charge balance.

The heterocyclic rings completed by Z¹ include quinolinium, benzimidazolium, pyridinium, thiazolium, selenazolium, imidazolium, tetrazolium, indolenium, pyrrolidinium, phenanthridinium, isoquinolinium, and naphthopyridinium nuclei. Z¹ may have a substituent, for example, an alkyl radical, alkenyl radical, aralkyl radical, aryl radical, alkynyl radical, hydroxy radical, alkoxy radical, aryloxy radical, halogen atom, amino radical, alkylthio radical, arylthio radical, acyloxy radical, acylamino radical, sulfonyl radical, sulfonyloxy radical, sulfonylamino radical, carboxyl radical, acyl radical, carbamoyl radical, sulfamoyl radical, sulfo radical, cyano radical, ureido radical, urethane radical, carbonate radical, hydrazine radical, hydrazone radical, and imino radical. The substituent on Z¹ is at least one selected from the foregoing examples and where there is more than one substituent, they may be identical or different. The substituent may be further replaced by such a substituent.

The substituent on Z¹ may have a heterocyclic quaternary ammonium radical completed by Z¹ through an appropriate linkage L¹ to be described later. In this case, a so-called dimer structure is formed.

Preferred examples of the heterocyclic nucleus completed by Z¹ include quinolinium, benzimidazolium, pyridinium, acridinium, phenanthridinium, naphthopyridinium, and isoquinolinium nuclei. Among these, quinolinium, naphthopyridinium, and benzimidazolium nuclei are more preferred, and quinolinium nuclei are most preferred.

The aliphatic radicals represented by R¹ include unsubstituted alkyl radicals having 1 to 18 carbon atoms and substituted alkyl radicals in which the alkyl moiety has 1 to 18 carbon atoms. The substituents on the alkyl radical are the same as the substituents on Z¹. Preferred radicals of R¹ are alkynyl radicals, especially propargyl radicals.

Q is a group of non-metallic atoms necessary to form a 4 to 12-membered non-aromatic hydrocarbon ring or non-aromatic heterocyclic ring. These rings may be replaced by a substituent similar to the substituents on Z¹.

The non-aromatic hydrocarbon rings are formed where X is a carbon atom and include such rings as cyclopentane, cyclohexane, cyclohexene, cycloheptane, indane, and tetralin. The non-aromatic heterocyclic rings may have nitrogen, oxygen, sulfur or selenium as the hetero atom. Where X is a carbon atom, there are included such rings as tetrahydrofuran, tetrahydropyran, butyrolactone, pyrrolidone, and tetrahydrothiophene. Where X is a nitrogen atom, there are included such rings as pyrrolidine, piperidine, pyridone, piperazine, perhydrothiadine, tetrahydroquinoline, and indoline.

Preferred ring nuclei formed by Q are those where X is a carbon atom, especially cyclopentane, cyclohexane, cycloheptane, cyclohexeneindane, tetrahydropyran, and tetrahydrothiophene.

At least one of R¹, the substituent on Z¹, and the substituent on Q contains an alkynyl radical. The alkynyl radicals, which have been partially described herein, are preferably those having 2 to 18 carbon atoms, for example, ethynyl, propargyl, 2-butynyl, 1-methylpropargyl, 1,1-dimethylpropargyl, 3-butynyl, and 4-pentynyl radicals. They may be replaced by a substituent similar to the substituents on Z¹. Preferred alkynyl radicals are propargyl radicals. Most preferably R¹ is a propargyl radical.

At least one of R¹, Z¹, and Q may have a radical capable of promoting adsorption to silver halide. The adsorption promoting radical is preferably represented by X¹-(L¹)m'-wherein X¹ is a radical capable of promoting adsorption to silver halide; L¹ is a divalent linkage; and m' is equal to 0 or 1.

The adsorption promoting radicals represented by X¹ include thioamide, mercapto, and five or six-membered nitrogenous heterocyclic radicals. They may be replaced by a substituent similar to the substituents on Z¹. Preferred thioamide radicals are non-cyclic thioamide radicals such as thiourethane and thioureido radicals. Preferred mercapto radicals are heterocyclic mercapto radicals such as 5-mercaptotetrazole, 3-mercapto-1,2,4-triazole, 2-mercapto-1,3,4-thiadiazole, and 2-mercapto-1,3,4-oxadiazole. Preferred five or six-membered nitrogenous heterocyclic radicals are those based on a combination of nitrogen, oxygen, sulfur and carbon atoms, more preferably capable of forming imino silver, for example, benzotriazole and aminothiazole.

L¹ is a divalent linkage which includes an atom or a group of atoms selected from C, N, S and O. Illustrative divalent linkages include alkylene radicals, alkenylene radicals, alkynylene radicals, arylene radicals, -O-, -S-, -NH-, -N=, -CO-, and -SO₂- alone or in a combination thereof, while all these radicals may have a substituent. Exemplary combinations are given below.

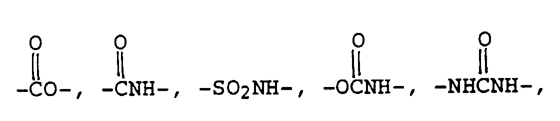

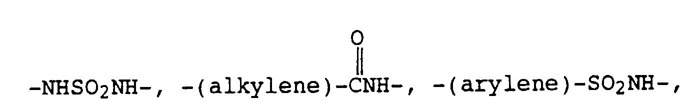

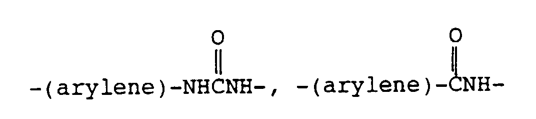

Y is an electric charge balancing counter ion, for example, a bromide ion, chloride ion, iodide ion, p-toluene sulfonate ion, ethylsulfonate ion, perchlorate ion, trifluoromethanesulfonate ion, thiocyan ion, BF₄⁻, and PF₆⁻.

Preferred among the compounds of formula (I) are those having a radical capable of promoting adsorption to silver halide, especially those wherein the adsorption promoting radical X¹ is a thioamide, azole or heterocyclic mercapto radical. Examples of these compounds and their synthesis are described, for example, in JP-A 301942/1988 and the publications cited therein.

Illustrative, non-limiting examples of the compound of formula (I) are given below.

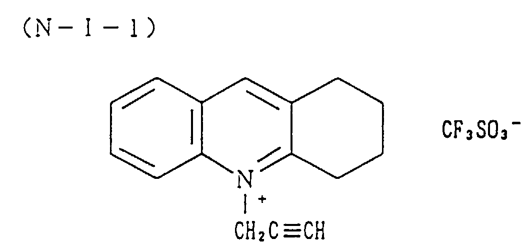

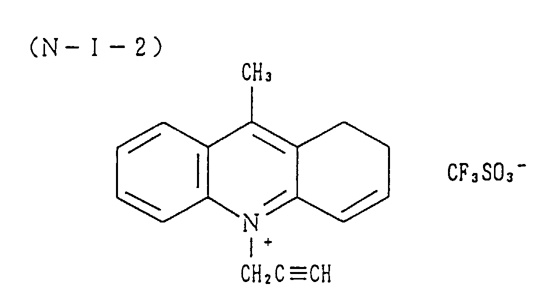

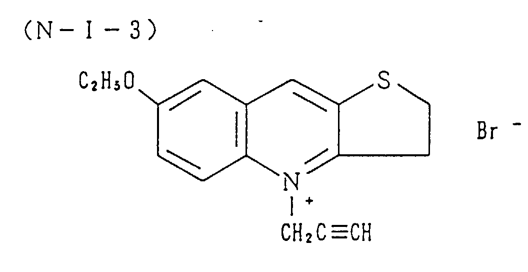

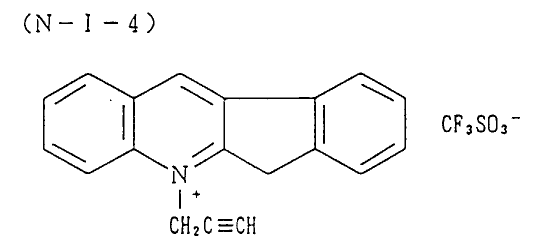

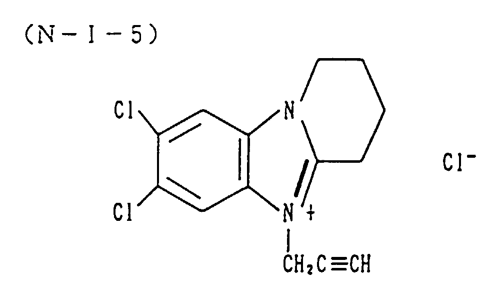

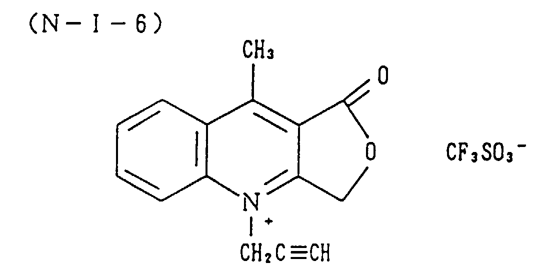

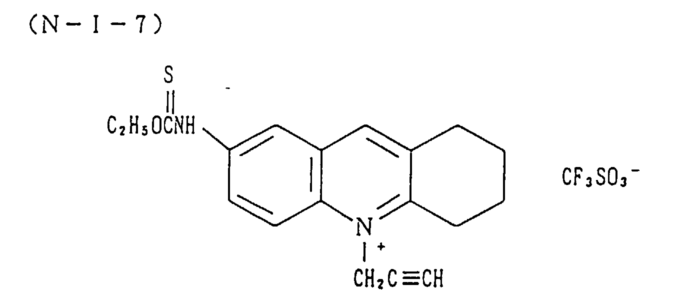

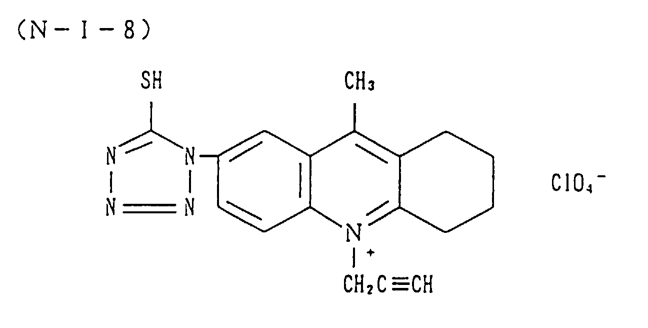

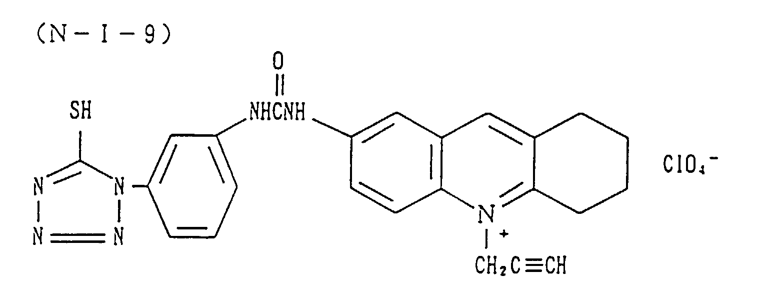

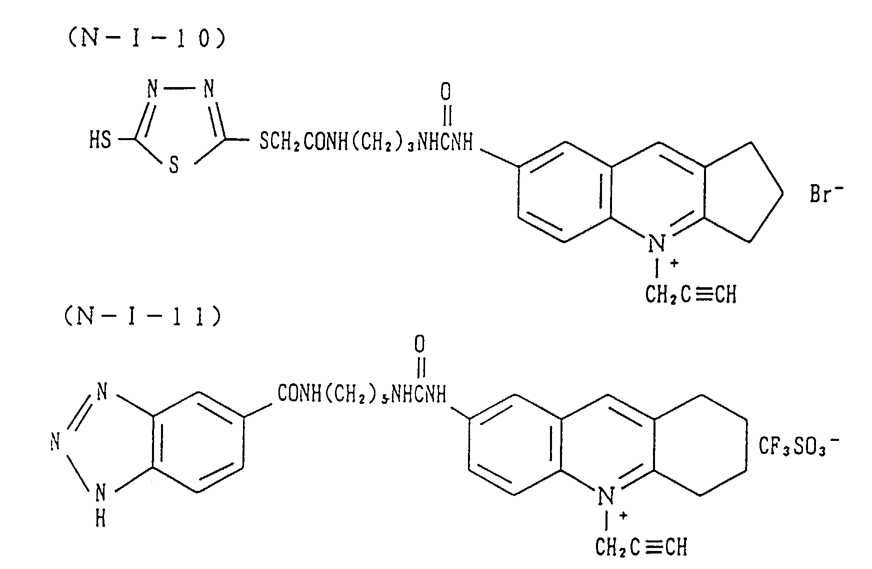

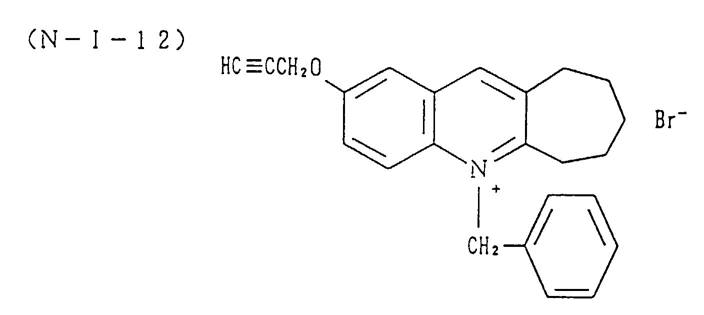

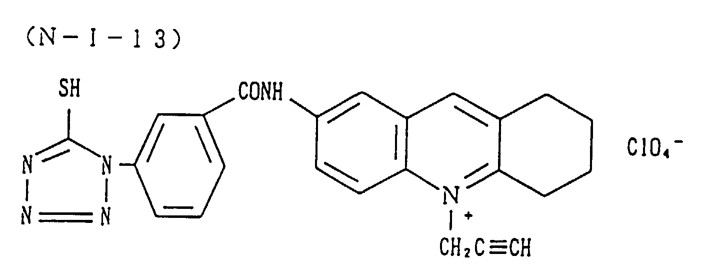

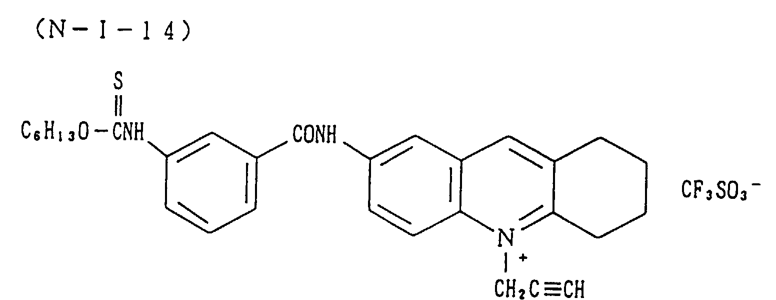

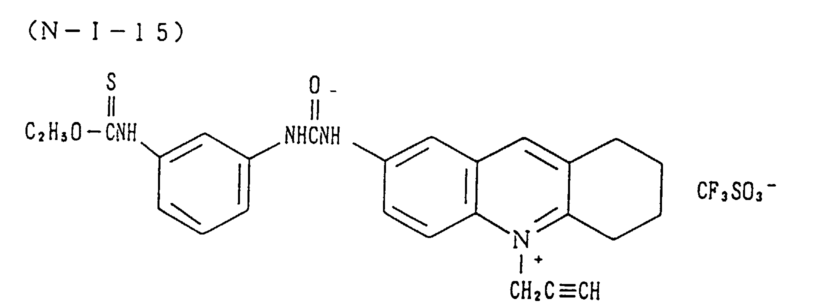

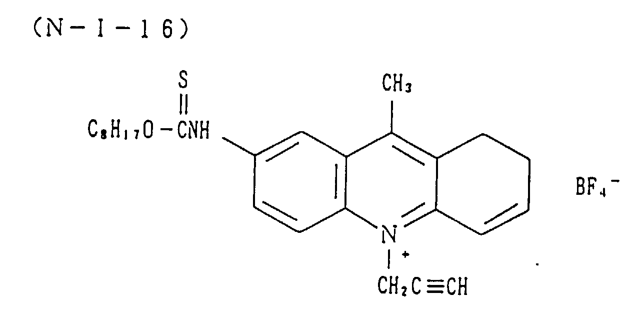

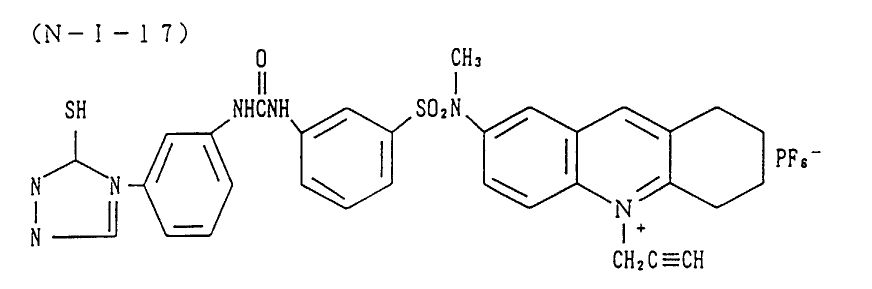

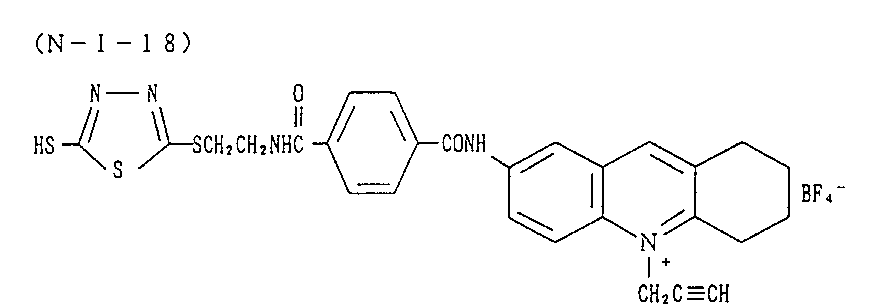

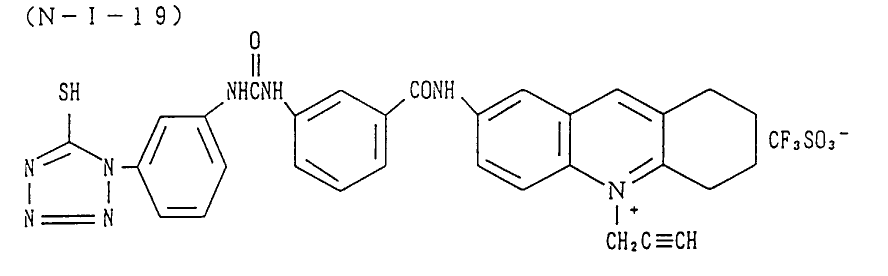

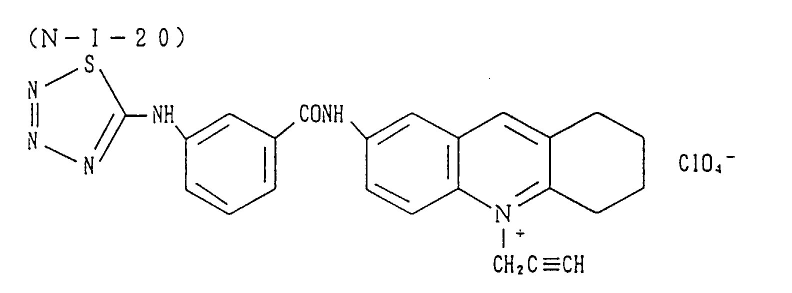

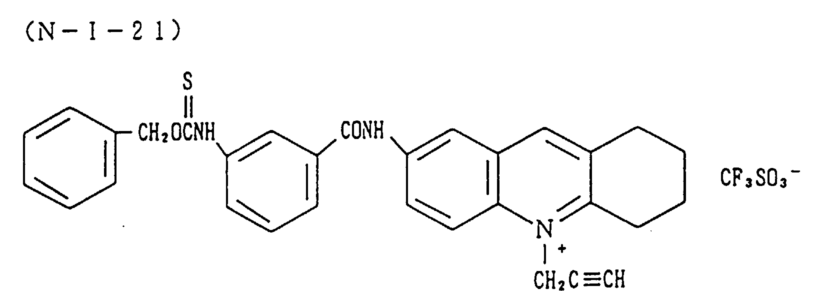

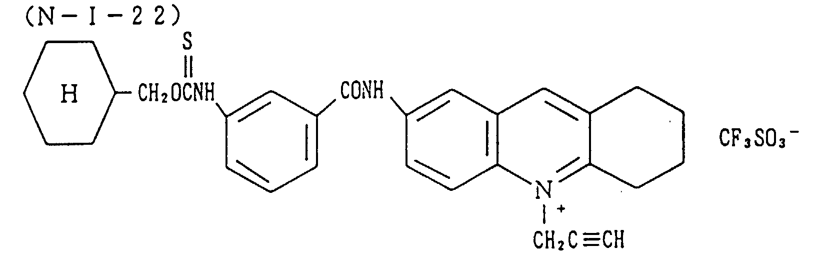

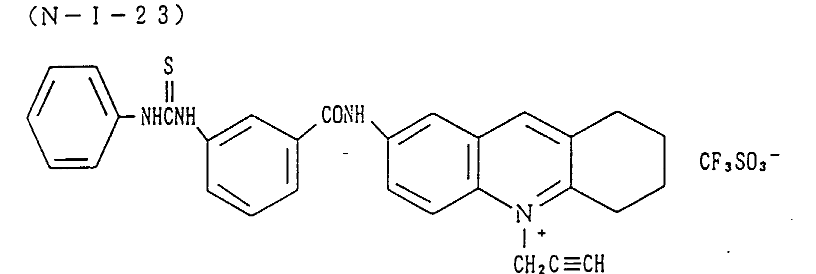

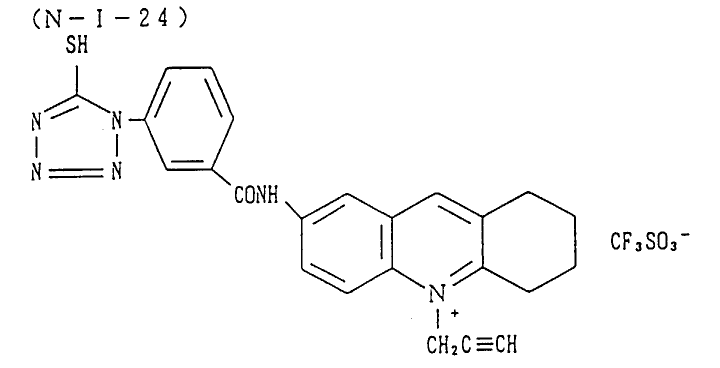

The aforementioned compounds can be synthesized by the methods described, for example, in the patents cited in Research Disclosure, No. 22534 (January 1983, pages 50-54) and US Patent No. 4,471,044 or analogous methods.

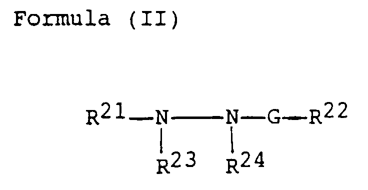

In formula (II), R²¹ is an aliphatic, aromatic or heterocyclic radical; R²² is selected from the group consisting of a hydrogen atom, an alkyl, aralkyl, aryl, alkoxy, aryloxy, and amino radical; G is selected from the group consisting of a carbonyl radical, sulfonyl radical, sulfoxy radical, phosphoryl radical, and iminomethylene radical: HN=C<; both R²³ and R²⁴ are hydrogen atoms, or one of R²³ and R²⁴ is a hydrogen atom and the other is an alkylsulfonyl, arylsulfonyl or acyl radical; and G, R²³, and R²⁴ may form with the hydrazine nitrogen atoms a hydrazone structure of the formula: >N-N=C<. All these radicals may have a substituent thereon if possible.

The aliphatic radicals represented by R²¹ include linear, branched or cyclic alkyl, alkenyl and alkynyl radicals. The aromatic radicals represented by R²¹ include monocyclic and dicyclic aryl radicals, for example, phenyl and naphthyl radicals. The heterocyclic radicals represented by R²¹ include 3- to 10-membered saturated or unsaturated heterocyclic rings containing at least one of N, O and S atoms, which may be monocyclic or form a condensed ring with another aromatic or heterocyclic ring. Preferred heterocyclic rings are five- or six-membered aromatic heterocyclic rings, for example, pyridyl, quinolinyl, imidazolyl, and benzimidazolyl radicals.

The radicals represented by R²¹ may have a substituent. Examples of the substituent include alkyl radicals, aralkyl radicals, alkoxy radicals, alkyl or aryl-substituted amino radicals, acylamino radicals, sulfonylamino radicals, ureido radicals, urethane radicals, aryloxy radicals, sulfamoyl radicals, carbamoyl radicals, aryl radicals, alkylthio radicals, arylthio radicals, sulfonyl radicals, sulfinyl radicals, hydroxy radicals, halogen atoms, cyano radicals, sulfo radicals, and carboxyl radicals, all of which may be further replaced by a substituent. These substituents may be combined together to form a ring if possible.

Preferred radicals represented by R²¹ are aromatic radicals, aromatic heterocyclic radicals and aryl-substituted methyl radicals, with aryl radicals being most preferred.

R²² is selected from the group consisting of a hydrogen atom, an alkyl, aralkyl, aryl, alkoxy, aryloxy, and amino radical. Preferably, where G is a carbonyl radical, R²² is a hydrogen atom, an alkyl radical (e.g., methyl, trifluoromethyl, 3-hydroxypropyl, and 3-methanesulfonamidopropyl radicals), an aralkyl radical (e.g., o-hydroxybenzyl radical), or an aryl radical (e.g., phenyl, 3,5-dichlorophenyl, o-methanesulfonamidophenyl and 4-methanesulfonylphenyl radicals), with the hydrogen atom being more preferred. Where G is a sulfonyl radical, R²² is preferably an alkyl radical (e.g., methyl radical), an aralkyl radical (e.g., o-hydroxyphenylmethyl radical), an aryl radical (e.g., phenyl radical) or a substituted amino radical (e.g., dimethylamino radical).

The radicals represented by R²² may have a substituent which may be selected from those enumerated for R²¹ as well as acyl, acyloxy, alkyl- or aryloxycarbonyl, alkenyl, alkynyl and nitro radicals. These substituents may be further replaced by such substituents. Also these substituents may be combined together to form a ring if possible.

Preferably R²¹ or R²², especially R²¹ contains a non-diffusion radical such as couplers, known as a ballast radical. The ballast radical used herein is an alkyl radical, phenyl radical, ether radical, amide radical, ureido radical, urethane radical, sulfonamide radical, or thioether radical, all having at least 8 carbon atoms, or a combination thereof.

R²¹ and R²² may have a radical capable of promoting the compound of formula (II) adsorbing to the surface of silver halide grains. The adsorption promoting radical is represented by X²-(L²)_{m''}- wherein X² is as defined for X¹; L² is a divalent linkage as defined for L¹; and m'' is equal to 0 or 1.

Preferably X² is a thioamide radical (excluding thiosemicarbazide and substituted ones thereof), a mercapto radical or a five- or six-membered nitrogenous heterocyclic radical. More preferably X² is selected from cyclic thioamide radicals (that is, mercapto-substituted nitrogenous heterocyclic radicals, for example, 2-mercaptothiadiazole, 3-mercapto-1,2,4-triazole, 5-mercaptotetrazole, 2-mercapto-1,3,4-oxadiazole, and 2-mercaptobenzoxazole radicals) and nitrogenous heterocyclic radicals (for example, benzotriazole, benzimidazole and indazole radicals).

G is selected from the group consisting of a carbonyl radical, sulfonyl radical, sulfoxy radical, phosphoryl radical, and iminomethylene radical: HN=C<, with the carbonyl radical being most preferred.

R²³ and R²⁴ are both hydrogen atoms, or one of R²³ and R²⁴ is a hydrogen atom and the other is an alkylsulfonyl, arylsulfonyl or acyl radical. Most preferably both R²³ and R²⁴ are hydrogen atoms.

Preferred compounds of formula (II) should have a radical capable of adsorbing to silver halide. Preferred adsorbing radicals are mercapto, cyclic thioamide and nitrogenous heterocyclic radicals as previously described in conjunction with formula (I).

Illustrative, non-limiting examples of the compound of formula (II) are given below.

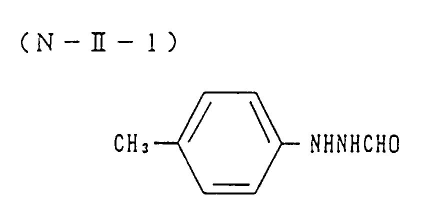

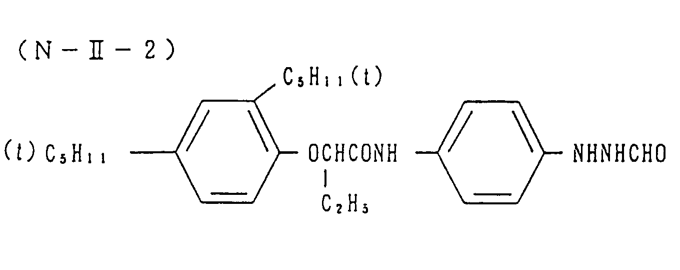

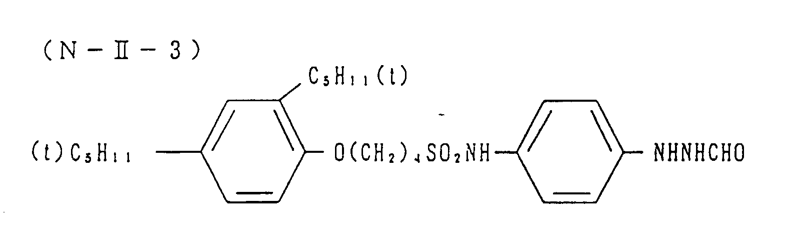

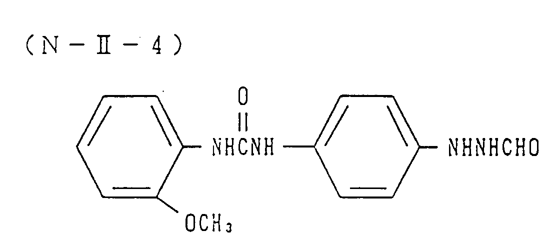

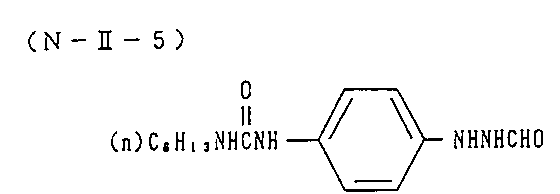

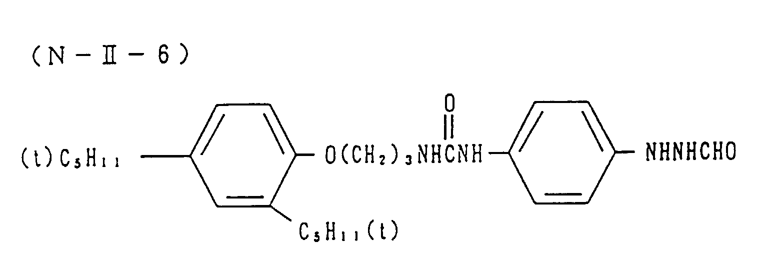

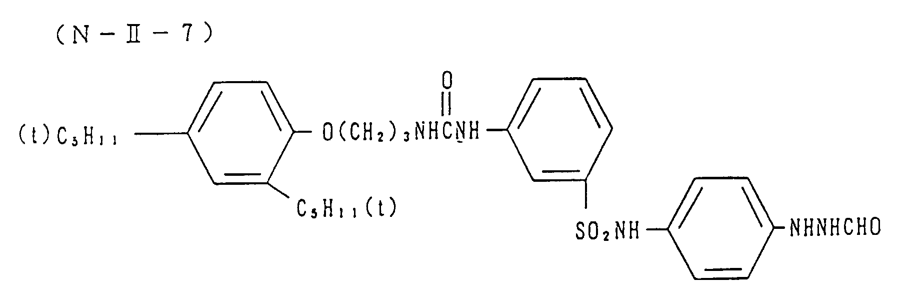

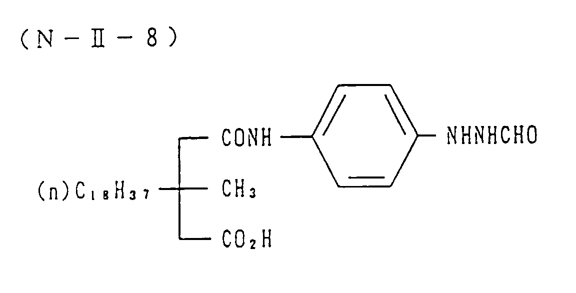

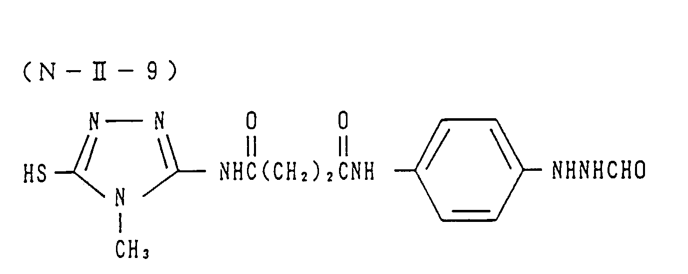

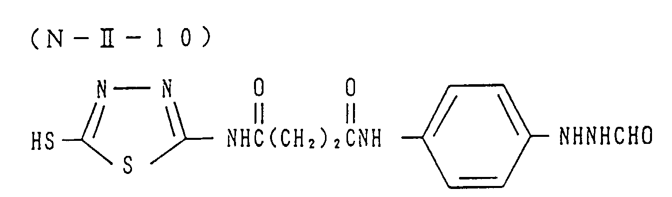

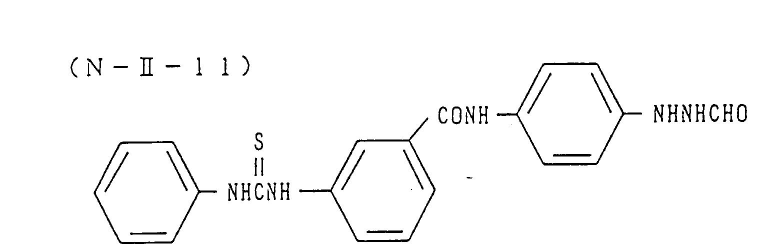

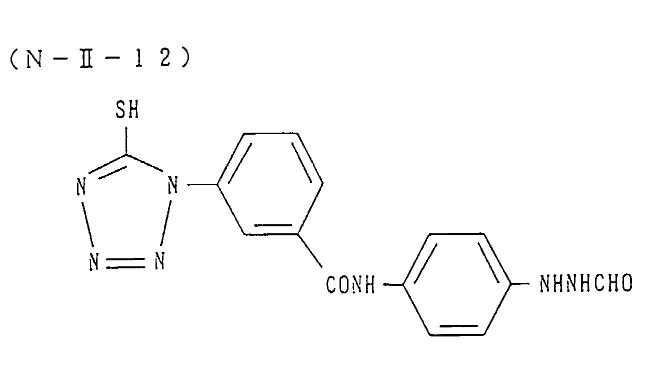

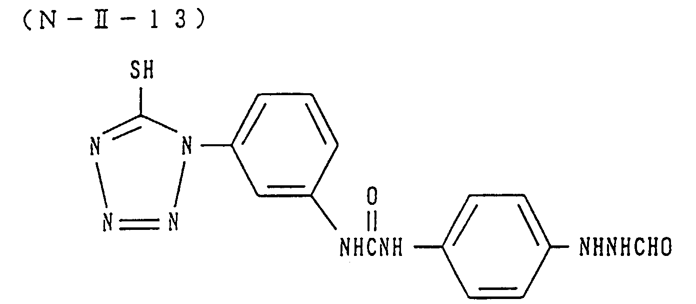

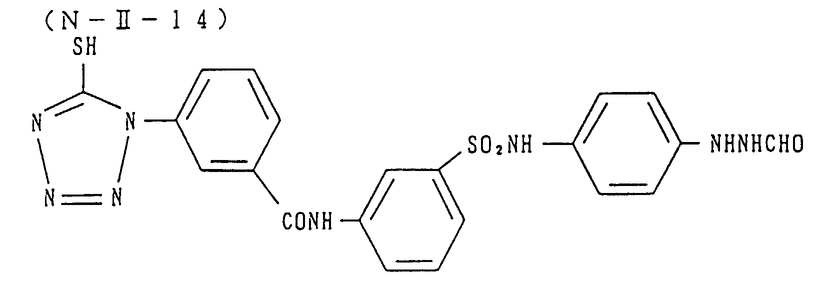

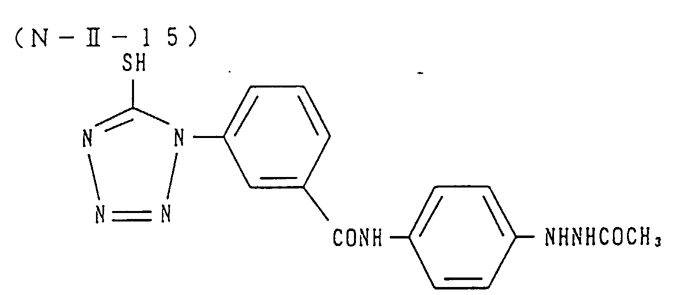

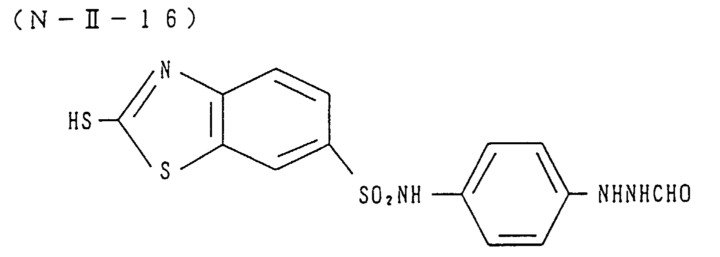

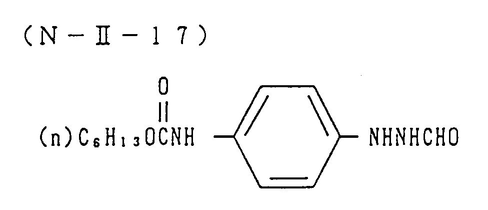

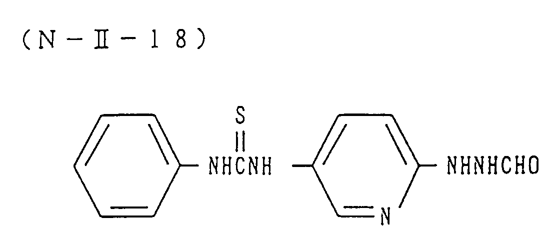

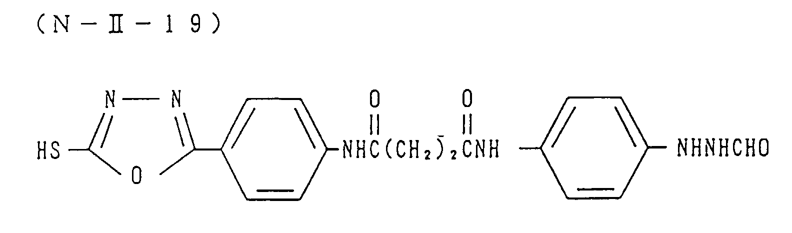

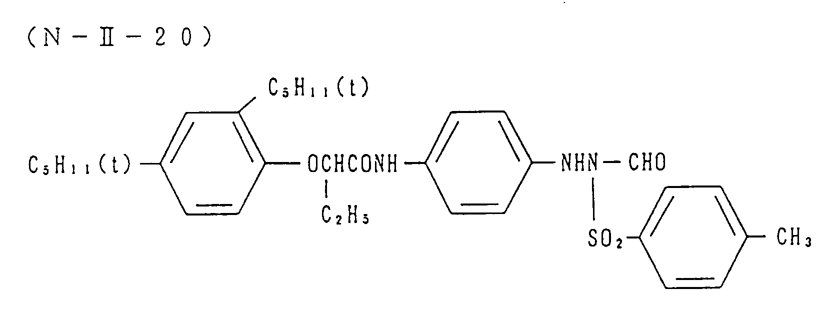

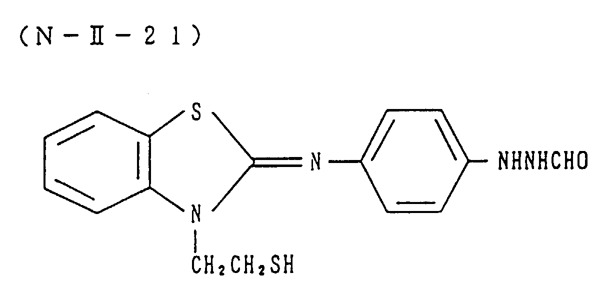

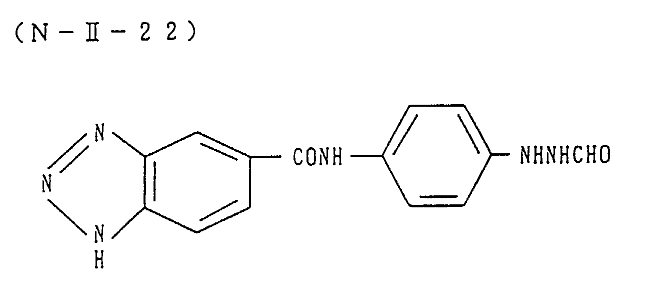

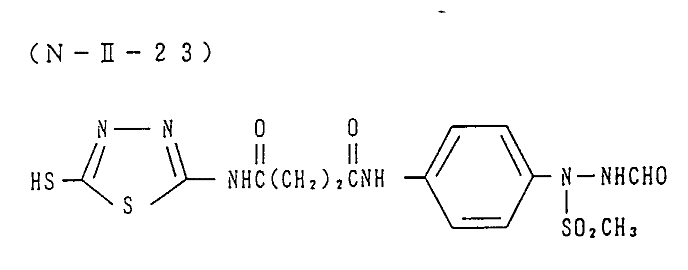

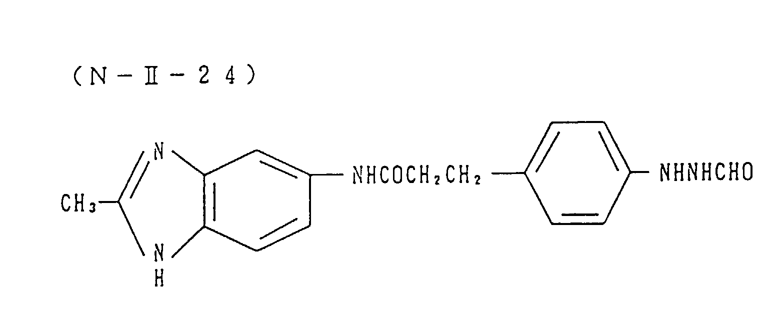

For the synthesis of the aforementioned compounds, reference may be made to, for example, the patents cited in Research Disclosure, No. 15162 (November 1976, pages 76-77), No. 22534 (January 1983, pages 50-54) and No. 23510 (November 1983, pages 346-352) as well as US Patent Nos. 4,080,207, 4,269,924, and 4,276,364.

Any one or more of the compounds of formulae (I) and (II) is contained in any layer of the lithographic printing material, preferably in a silver halide emulsion layer. The amount of the nucleating agent used is not critical although better results are obtained when it is used in an amount of about 1x10⁻⁸ to 1x10⁻² mol, especially about 1x10⁻⁷ to 1x10⁻³ mol per mol of silver in the silver halide emulsion layer. When more than one compound is used, the total amount should preferably fall within this range.

In the practice of the invention, the use of the nucleating agent of formula (I) is preferred. Preferred embodiments are shown below as (I-1) to (I-8), with embodiment (I-8) being most preferred.
(I-1) The compound of formula (I) has a substituent in the form of a radical capable of promoting adsorption to silver halide as represented by X¹.
(I-2) In embodiment (I-1), the adsorption promoting radical represented by X¹ is a thioamide radical, a heterocyclic mercapto radical, or a nitrogenous heterocyclic radical capable of forming imino silver.
(I-3) In embodiment (I-2), the heterocyclic ring completed by Z¹ is a quinolinium, isoquinolinium, naphthopyridinium, or benzothiazolium ring.
(I-4) In embodiment (I-2), the heterocyclic ring completed by Z¹ is a quinolinium ring.
(I-5) In embodiment (I-2), R¹ or Z¹ has a substituent in the form of an alkynyl radical.
(I-6) In embodiment (I-2), R¹ is a propargyl radical.
(I-7) In embodiment (I-2), X¹ is a thiourethane radical as a typical thioamide radical or a mercaptotetrazole radical as a typical heterocyclic mercapto radical.
(I-8) In embodiment (I-6), R¹ is attached to the heterocyclic ring completed by Z¹ to form a ring.

Where the nucleating agent of formula (II) is used, preferred embodiments are shown below as (II-1) to (II-6), with embodiment (II-6) being most preferred.
(II-1) The compound of formula (II) has a substituent in the form of a radical capable-of promoting adsorption to silver halide as represented by X².
(II-2) In embodiment (II-1), the adsorption promoting radical represented by X² is a heterocyclic mercapto radical or a nitrogenous heterocyclic radical capable of forming imino silver.
(II-3) In embodiment (II-2), G-R²² represents a formyl radical.
(II-4) In embodiment (II-3), R²³ and R²⁴ are hydrogen atoms.
(II-5) In embodiment (II-3), R²¹ is an aromatic radical.
(II-6) In embodiment (II-2), the heterocyclic mercapto radical represented by X² is 5-mercaptotetrazole or 5-mercapto-1,2,4-triazole.

In the practice of the invention, a mixture of compounds of formulae (I) and (II) may be used.

The term "nucleating agent" used herein is a compound which acts upon surface development of a previously unfogged internal latent image type silver halide emulsion for forming a direct positive image.

The nucleating agents encompass all the compounds which were developed in the photographic art for the purpose of nucleating internal latent image type silver halide. As previously mentioned, two or more nucleating agents may be used in combination. More particularly, the nucleating agents are described in Research Disclosure No. 22534 (January 1983, pages 50-54) and they are generally classified into three classes of hydrazine compounds, quaternary heterocyclic compounds and other compounds.

It will be understood that the nucleating agents of formula (I) belong to the quaternary heterocyclic compound class and the nucleating agents of formula (II) belong to the hydrazine compound class.

The hydrazine compounds are described, for example, in Research Disclosure No. 15162 (November 1976, pages 76-77) and No. 23510 (November 1983, pages 346-352). More specifically, reference should be made to the following patents. Examples of the hydrazine nucleating agent having a silver halide adsorbing radical are described in US Patent Nos. 4,030,925, 4,080,207, 4,031,127, 3,718,470, 4,269,929, 4,276,364, 4,278,748, 4,385,108, 4,459,347, UK patent No. 2,011,391 B, JP-A 074729/1979, 163533/1980, 074536/1980, and 179734/1985. Other examples of the hydrazine nucleating agent are described in JP-A 086829/1982, and US Patent Nos. 4,560,638, 4,478, 2,563,785, and 2,588,982.

The quaternary heterocyclic compounds are described, for example, in Research Disclosure No. 22534, JP-B 38164/1974, 19452/1977, 47326/1977, JP-A 069613/1977, 003426/1977, 138742/1980, and 011837/1985, US Patent No. 4,306,016, and Research Disclosure No. 23213 (August 1983, pages 267-270).

In the practice of the invention, any of the conventional nucleating agents may be used along with the nucleating agents of formulae (I) and (II). Better results are obtained when the nucleating agents of formulae (I) are used.

In the practice of the invention, it is preferred to use a nucleation accelerating agent along with the nucleating agent. The term "nucleation accelerating agent" used herein is a compound which does not have the function of a nucleating agent in a substantial sense, but assists in the action of a nucleating agent for increasing the maximum density of a direct positive image and/or reducing the development time necessary to provide a direct positive image with a desired density.

Useful nucleation accelerating agents are represented by the general formula:

A-[-(Y¹)ₛ-R]ₜ (III)

In formula (III), A is a radical capable of adsorbing to silver halide; Y¹ is a divalent linkage in the form of an atom selected from a hydrogen, carbon, nitrogen, oxygen and sulfur atom or a group of such atoms; R is an organic radical containing a thioether, amino, ammonium, ether or heterocyclic radical; letter s is equal to 0 or 1; and t is equal to 1 or 2.

The radicals adsorbable to silver halide represented by A include compounds having a mercapto radical attached to a heterocyclic ring, heterocyclic compounds capable of forming imino silver, and hydrocarbon compounds having a mercapto radical.

Examples of the mercapto compound attached to a heterocyclic ring include substituted or unsubstituted mercaptoazoles (e.g., 5-mercaptotetrazoles, 3-mercapto-1,2,4-triazoles, 2-mercaptoimidazoles, 2-mercapto-1,3,4-thiadiazoles, 5-mercapto-1,2,4-thiadiazoles, 2-mercapto-1,3,4-oxadiazoles, 2-mercapto-1,3,4-selenadiazoles, 2-mercaptooxazoles, 2-mercaptothiazoles, 2-mercaptobenzoxazoles, 2-mercaptobenzimidazoles, 2-mercaptobenzothiazoles), and substituted or unsubstituted mercaptopyrimidines (e.g., 2-mercaptopyrimidines).

Examples of the heterocyclic compounds capable of forming imino silver include substituted or unsubstituted indazoles, benzimidazoles, benzotriazoles, benzoxazoles, benzothiazoles, imidazoles, thiazoles, oxazoles, triazoles, tetrazoles, azaindenes, pyrazoles, and indoles.

Examples of the hydrocarbon compounds having a mercapto radical include alkylmercaptans, arylmercaptans, alkenylmercaptans, and aralkylmercaptans.

Y¹ is a divalent linkage which is an atom selected from a hydrogen atom, carbon atom, nitrogen atom, oxygen atom, and sulfur atom or a group of such atoms. Useful divalent linkages are shown below.

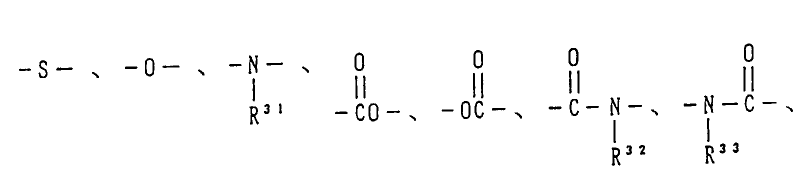

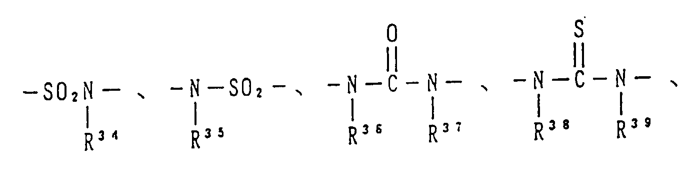

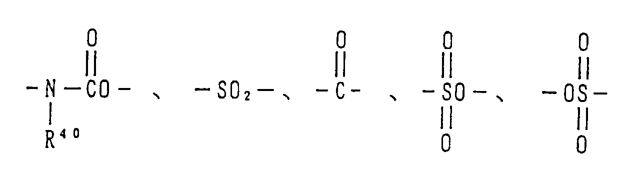

The linkage may be attached to A or a heterocyclic ring to be described later via a linear or branched alkylene radical (e.g., methylene, ethylene, propylene, butylene, hexylene, and 1-methylethylene radicals) or a substituted or unsubstituted arylene radical (e.g., phenylene and naphthylene radicals).

In the linkage formulae, R³¹, R³², R³³, R³⁴, R³⁵, R³⁶, R³⁷, R³⁸, R³⁹, and R⁴⁰ represent hydrogen atoms, substituted or unsubstituted alkyl radicals (e.g., methyl, ethyl, propyl and n-butyl radicals), substituted or unsubstituted aryl radicals (e.g., phenyl and 2-methylphenyl radicals), substituted or unsubstituted alkenyl radicals (e.g., propenyl and 1-methylvinyl radicals), or substituted or unsubstituted alkyl radicals (e.g., benzyl and phenethyl radicals).

R is an organic radical containing at least one member selected from the group consisting of thioether radicals, amino radicals (inclusive of salt form), ammonium radicals, ether radicals and heterocyclic radicals (inclusive of salt form). Typical of the organic radical is a radical selected from substituted or unsubstituted alkyl, alkenyl, aralkyl, and aryl radicals, having incorporated or combined therewith a member selected from the above-mentioned group. Examples include hydrochloride salts of dimethylaminoethyl, aminoethyl, diethylaminoethyl, dibutylaminoethyl, and dimethylaminopropyl radicals; dimethylaminoethylthioethyl, 4-dimethylaminophenyl, 4-dimethylaminobenzyl, methylthioethyl, ethylthiopropyl, 4-methylthio-3-cyanophenyl, methylthiomethyl, trimethylammonioethyl, methoxyethyl, methoxyethoxyethoxyethyl, methoxyethylthioethyl, 3,4-dimethoxyphenyl, 3-chloro-4-methoxyphenyl, morpholinoethyl, 1-imidazolylethyl, morpholinoethylthioethyl, pyrrolidinoethyl, piperidinopropyl, 2-pyridylmethyl, 2-(1-imidazolyl)ethylthioethyl, pyrazolylethyl, triazolylethyl, and methoxyethoxyethoxyethoxycarbonylaminoethyl radicals.

Preferred examples of the compound of formula (III) are given below.

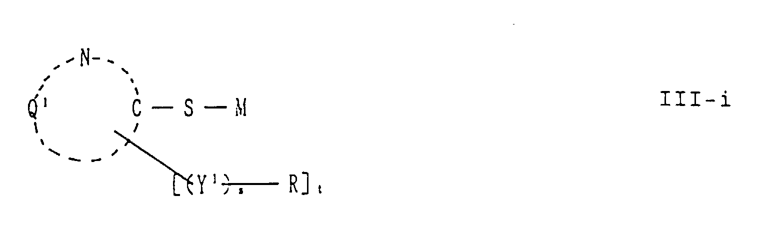

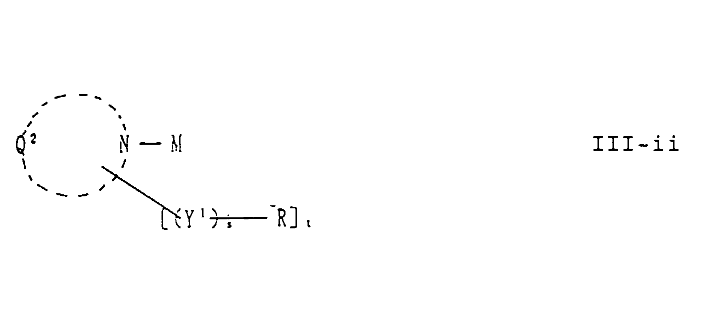

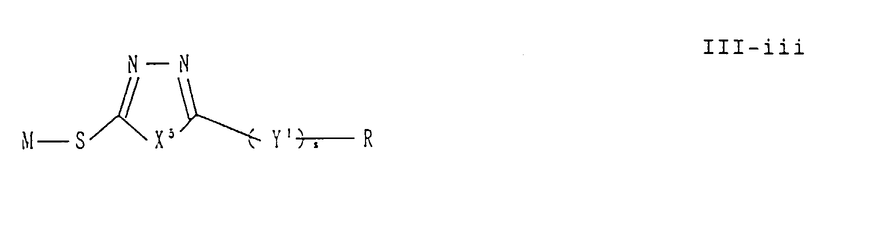

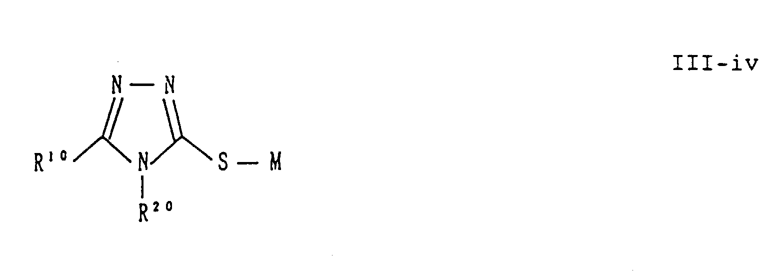

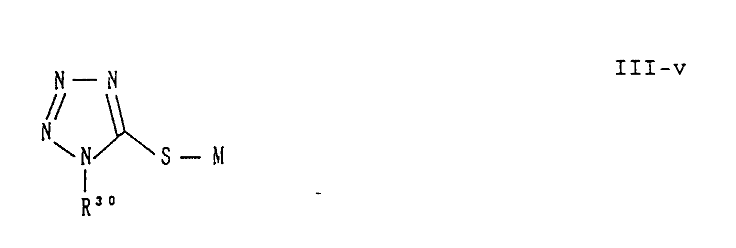

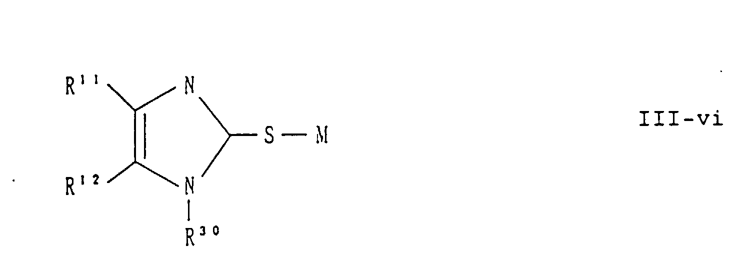

In formula (III-i), Q¹ is a group of atoms necessary to form a five- or six-membered heterocyclic ring containing at least one atom selected from carbon, nitrogen, oxygen, sulfur and selenium atoms. The heterocyclic ring may have an aromatic carbocyclic ring or heterocyclic aromatic ring fused thereto. Examples of the heterocyclic ring include tetrazoles, triazoles, imidazoles, thiadiazoles, oxadiazoles, selenadiazoles, oxazoles, thiazoles, benzoxazoles, benzothiazoles, benzimidazoles, and pyrimidines.

These heterocyclic rings may have substituents, for example, nitro radicals, halogen atoms (e.g., chlorine and bromine atoms), mercapto radicals, cyano radicals, substituted or unsubstituted alkyl radicals (e.g., methyl, ethyl, propyl, t-butyl, and cyanoethyl radicals), aryl radicals (e.g., phenyl, 4-methanesulfonamidophenyl, 4-methylphenyl, 3,4-dichlorophenyl, and naphthyl radicals), alkenyl radicals (e.g., allyl radical), aralkyl radical (e.g., benzyl, 4-methylbenzyl, and phenethyl radicals), sulfonyl radicals (e.g., methanesulfonyl, ethanesulfonyl and p-toluenesulfonyl radicals), carbamoyl radicals (e.g., unsubstituted carbamoyl, methylcarbamoyl, and phenylcarbamoyl radicals), sulfamoyl radicals (e.g., unsubstituted sulfamoyl, methylsulfamoyl, and phenylsulfamoyl radicals), carbonamide radicals (e.g., acetamide and benzamide radicals), sulfonamide radicals (e.g., methanesulfonamide, benzenesulfonamide, and p-toluenesulfonamide radicals), acyloxy radicals (e.g., acetyloxy and benzoyloxy radicals), sulfonyloxy radical (e.g., methanesulfonyloxy radical), ureido radicals (e.g., unsubstituted ureido, methylureido, ethylureido, and phenylureido radicals), thioureido radicals (e.g., unsubstituted thioureido and methylthioureido radicals), acyl radicals (e.g., acetyl and benzoyl radicals), oxycarbonyl radicals (e.g., methoxycarbonyl and phenoxycarbonyl radicals), oxycarbonylamino radicals (e.g., methoxycarbonylamino, phenoxycarbonylamino, and 2-ethylhexyloxycarbonylamino radicals), carboxylic acids or salts thereof, sulfonic acids or salts thereof, and hydroxyl radical. It is preferred for nucleation accelerating effect that the heterocyclic ring be not replaced with a carboxylic acid or salt thereof, a sulfonic acid or salt thereof, and a hydroxyl radical.

Preferred examples of the heterocyclic ring represented by Q¹ include tetrazoles, triazoles, imidazoles, thiadiazoles, and oxadiazoles.

M is a hydrogen atom, an alkali metal atom (e.g., sodium and potassium atoms), an ammonium radical (e.g., trimethylammonium and dimethylbenzylammonium radicals), or a radical capable of converting into M = H or an alkali metal atom under alkaline conditions (e.g., acetyl, cyanoethyl, and methanesulfonylethyl radicals).

Y¹, R, t and s are as defined for formula (III).

In formula (III-ii), Y¹, R, t, s and M are as defined for formulae (III) and (III-i). Q² is a group of atoms necessary to form a five- or six-membered heterocyclic ring capable of forming imino silver, preferably a group of atoms necessary to form a five- or six-membered heterocyclic ring containing an atom selected from carbon, nitrogen, oxygen, sulfur and selenium atoms. The heterocyclic ring may have a carbon aromatic ring or heterocyclic aromatic ring fused thereto. Preferred examples of the heterocyclic ring represented by Q² include indazoles, benzimidazoles, benzotriazoles, benzoxazoles, benzothiazoles, imidazoles, thiazoles, oxazoles, triazoles, tetrazoles, tetraazaindenes, triazaindenes, diazaindenes, pyrazoles, and indoles.

In formula (III-iii), Y¹, R, s and M are as defined for formula (III-i). X⁵ is an oxygen atom, sulfur atom or selenium atom, with the sulfur atom being preferred.

In formula (III-iv), R¹⁰ is a hydrogen atom, halogen atom (e.g., chlorine and bromine atoms), nitro radical, mercapto radical, unsubstituted amino radical, substituted or unsubstituted alkyl radical (e.g., methyl and ethyl radicals), alkenyl radical (e.g., propenyl and 1-methylvinyl radicals), aralkyl radicals (e.g., benzyl and phenethyl radicals), aryl radical (e.g., phenyl and 2-methylphenyl radicals) or -(Y¹)ₛ-R. R²⁰ is a hydrogen atom, unsubstituted amino radical, or -(Y¹)ₛ-R. It is essential that at least one of R¹⁰ and R²⁰ represents -(Y¹)ₛ-R. Where both R¹⁰ and R²⁰ represent -(Y¹)ₛ-R, they may be either identical or different. It is understood that M, Y¹, R, and s are as defined for formula (III-i).

In formula (III-v), R³⁰ is -(Y¹)ₛ-R. It is understood that M, Y¹, R, and s are as defined for formula (III-i).

In formula (III-vi), each of R¹¹ and R¹² is a hydrogen atom, halogen atom (e.g., chlorine and bromine atoms), substituted or unsubstituted amino radical (e.g., unsubstituted amino and methylamino radicals), nitro radical, substituted or unsubstituted alkyl radical (e.g., methyl and ethyl radicals), alkenyl radical (e.g., propenyl and 1-methylvinyl radicals), aralkyl radicals (e.g., benzyl and phenethyl radicals), or aryl radical (e.g., phenyl and 2-methylphenyl radicals). It is understood that M and R³⁰ are as defined for formula (III-v).

Illustrative, non-limiting examples of the compound of formula (III) are given below.

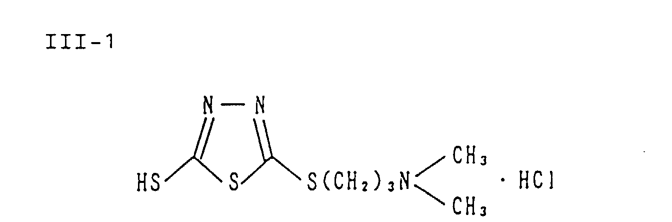

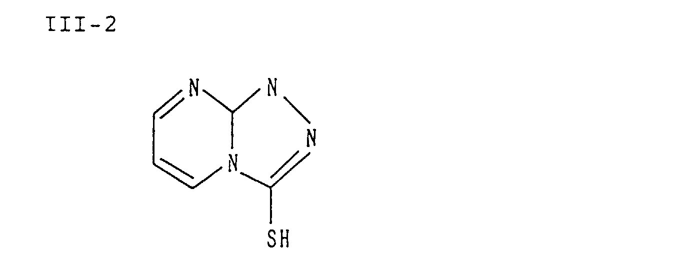

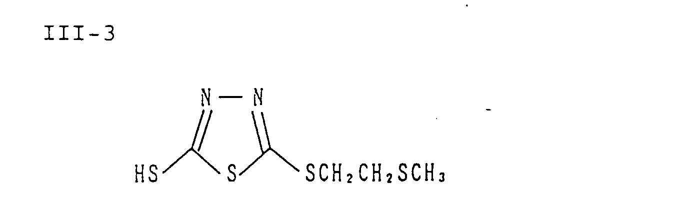

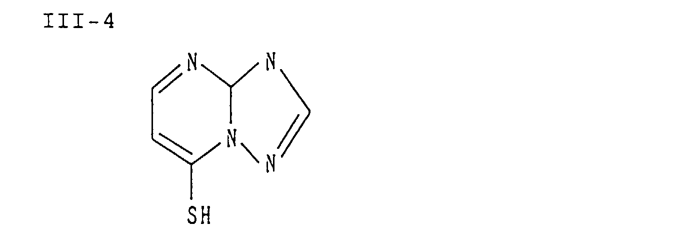

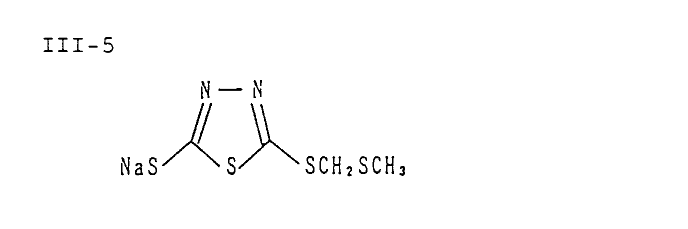

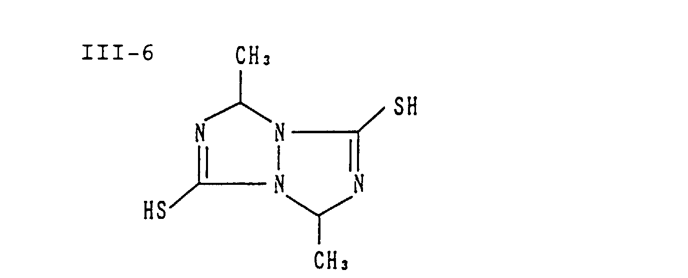

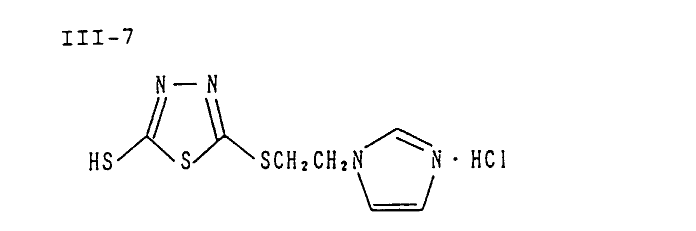

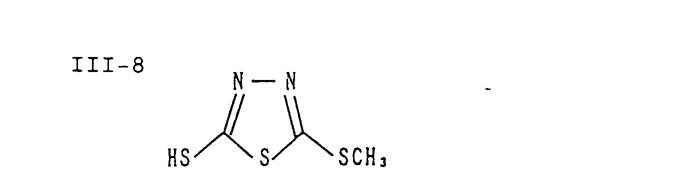

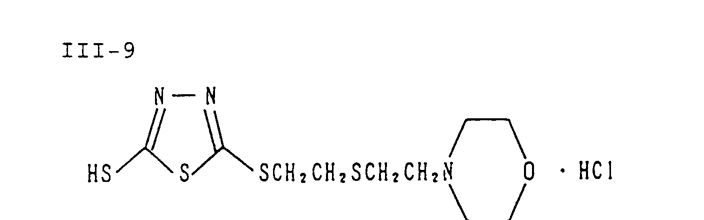

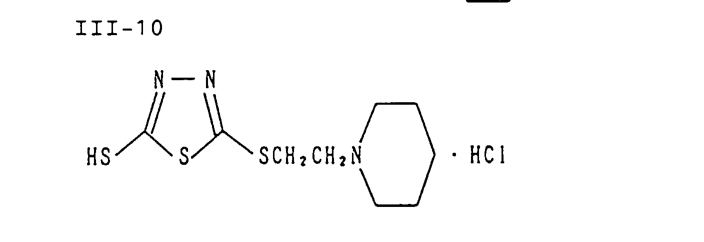

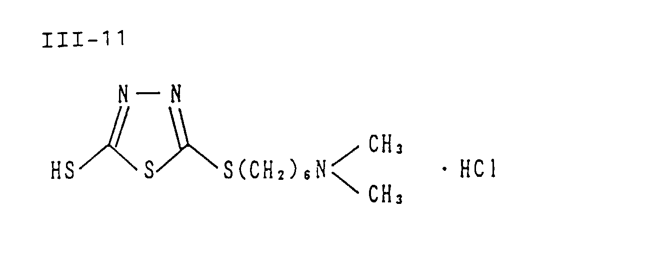

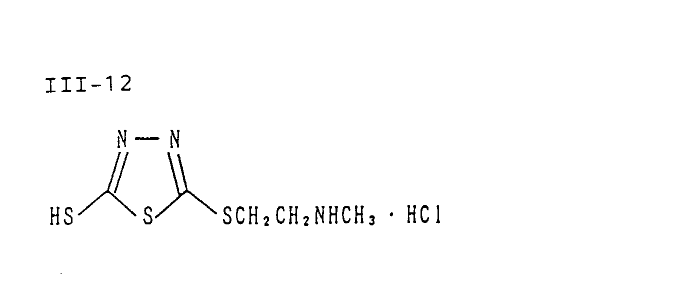

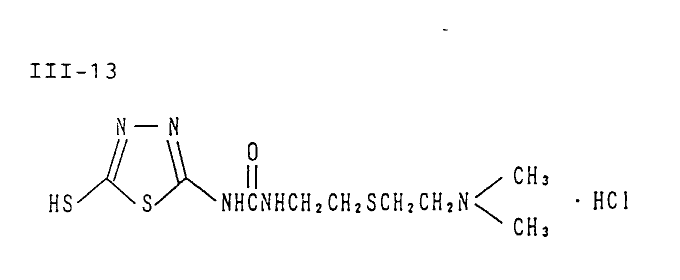

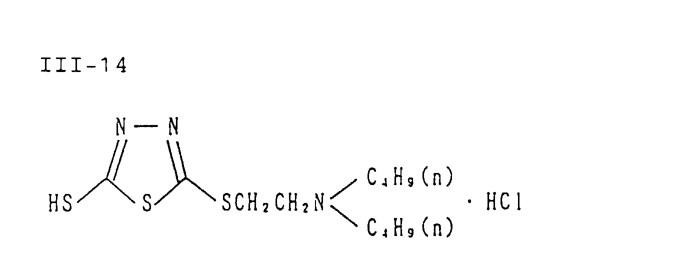

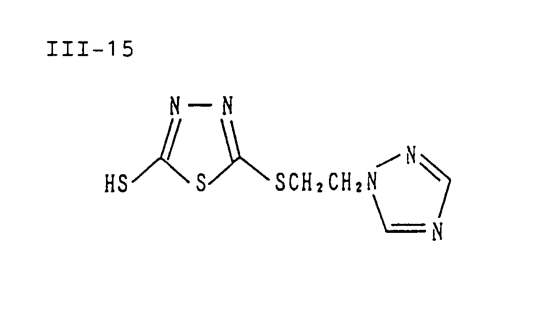

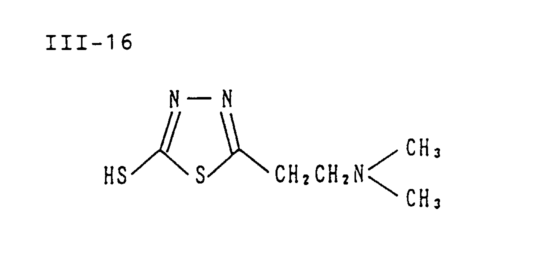

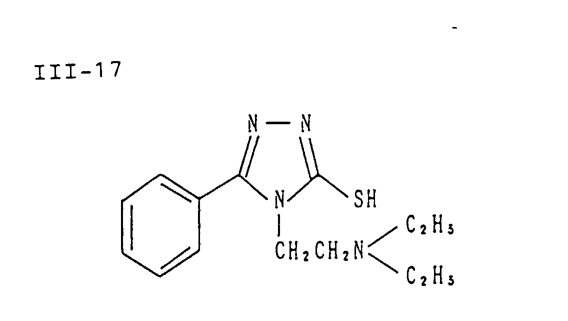

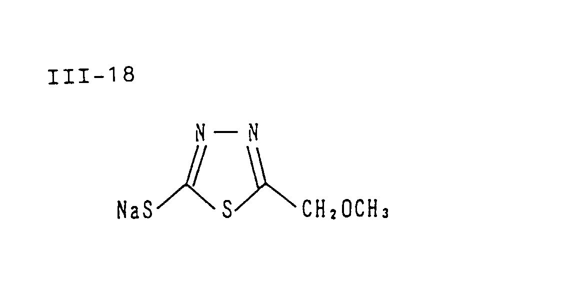

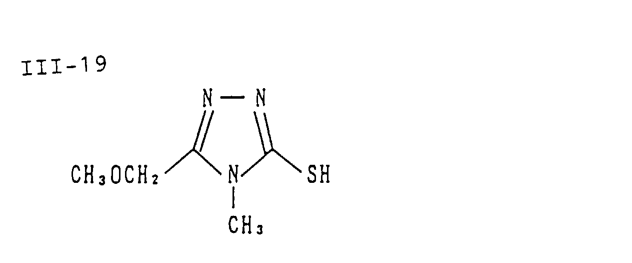

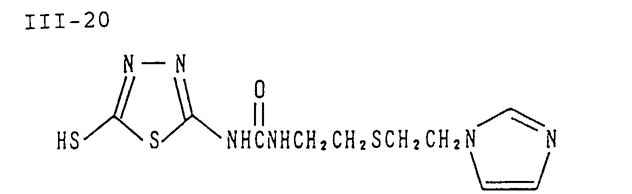

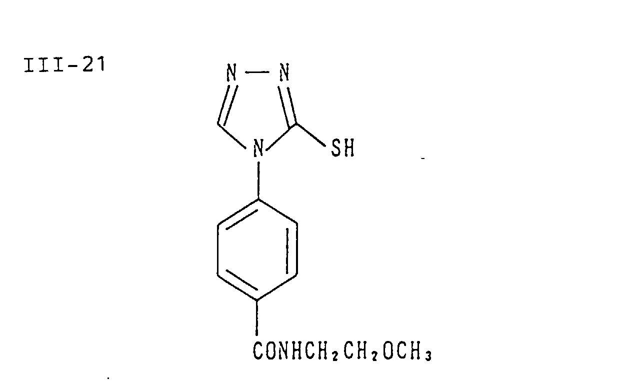

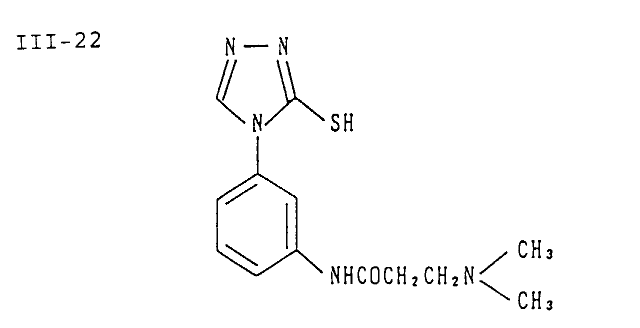

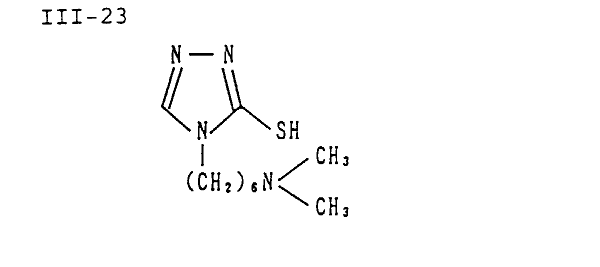

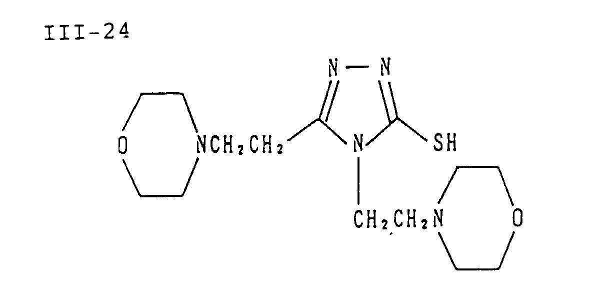

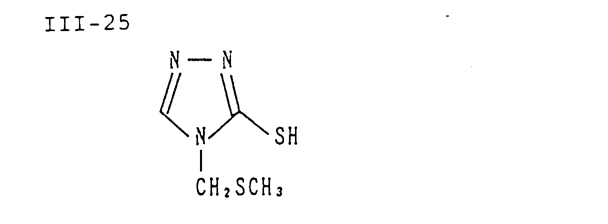

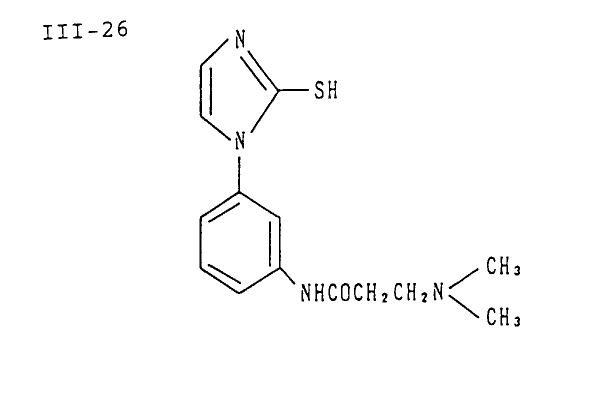

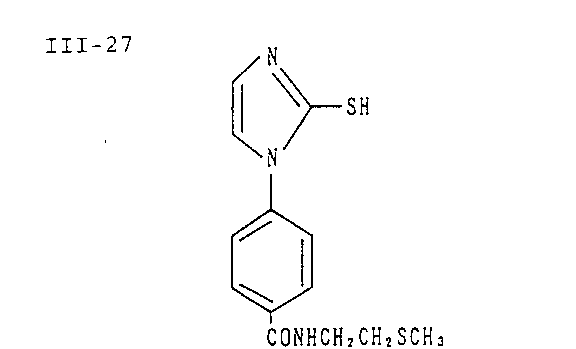

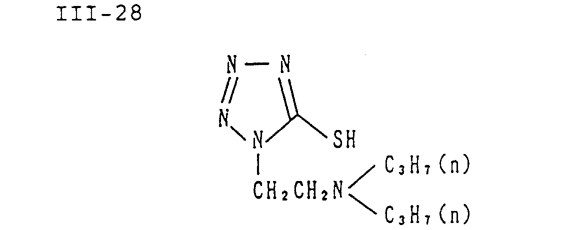

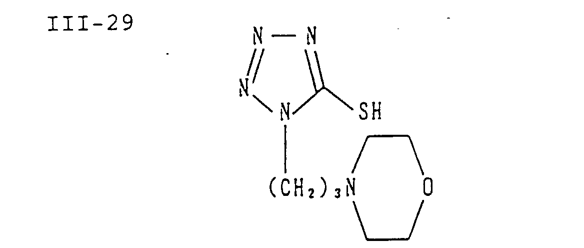

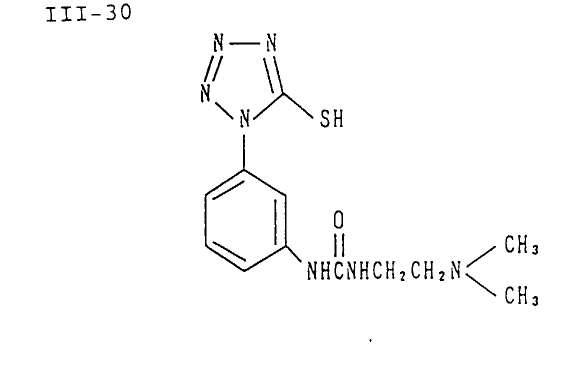

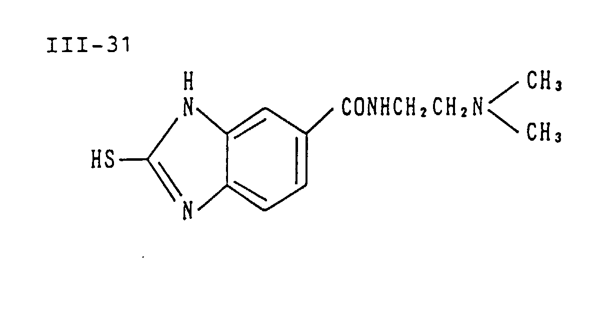

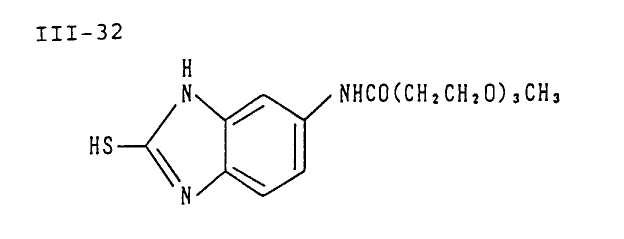

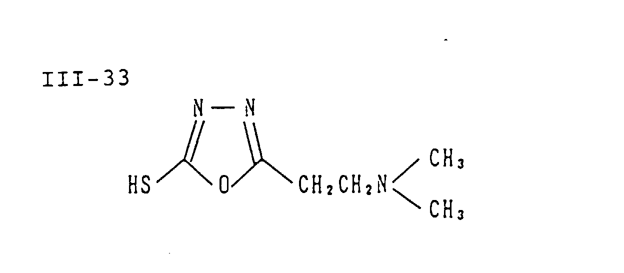

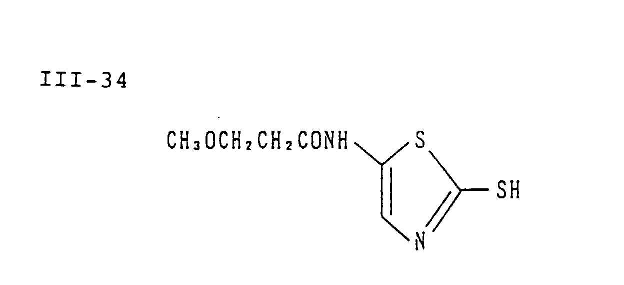

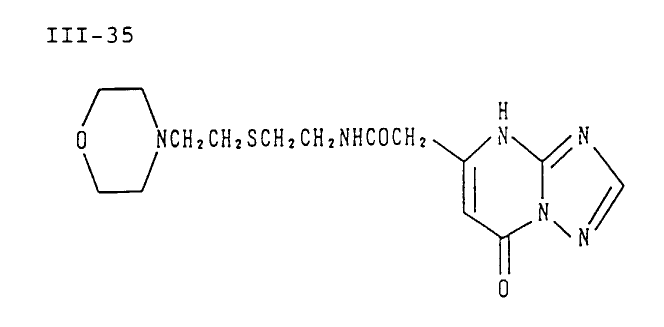

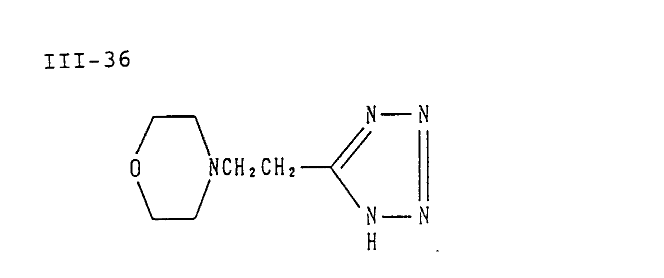

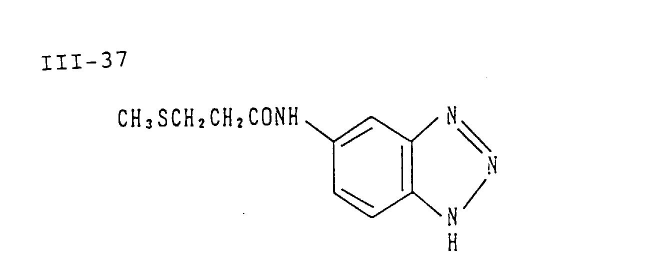

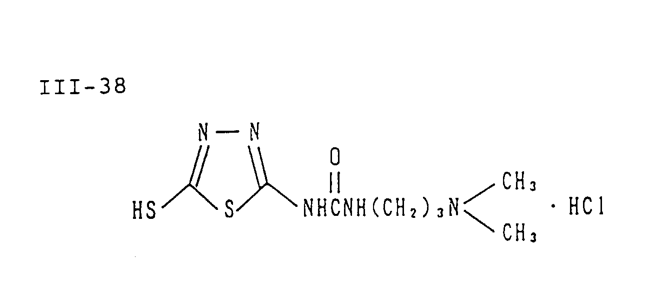

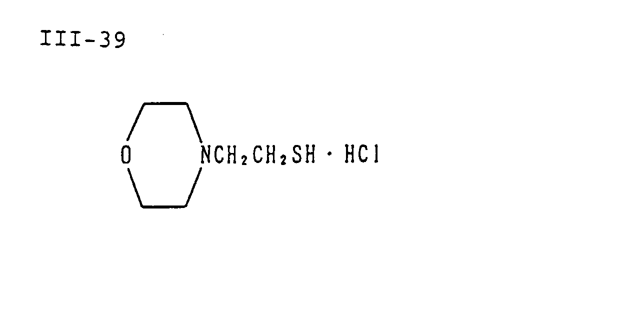

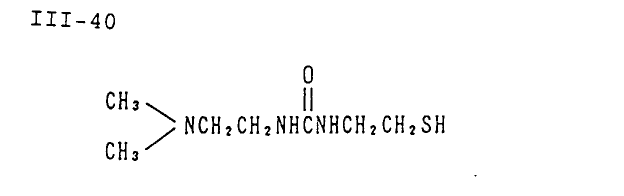

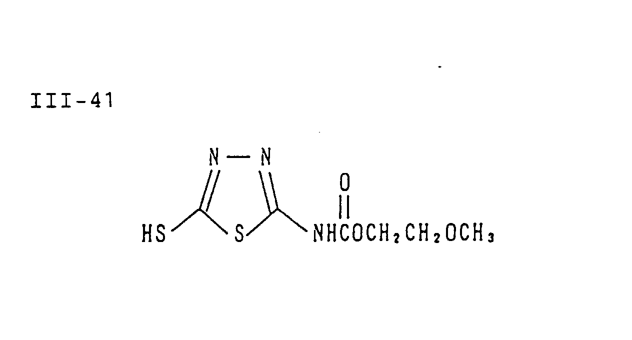

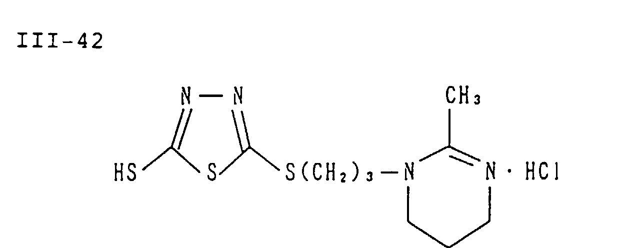

The nucleation accelerating agent used herein can be synthesized by the methods described in the following literature and patents.

Berichte der Deutschen Chemischen Gesellschaft, 28, 77 (1895), ibid., 22, 568 (1889), ibid., 29, 2483 (1896),
J. Chem. Soc., 1932, 1806,
J. Am. Chem. Soc., 71, 4000 (1949), ibid., 45, 2390 (1923),
Advances in Heterocyclic Chemistry, 9, 165 (1968),
Chemische Berichte, 9, 465 (1876),
Organic Synthesis, IV, 569 (1963),

| | | |
|---|---|---|
| USP 2,271,229, | 2,444,605, | 2,444,606, |
| 2,444,607, | 2,541,924, | 2,585,388, |
| 2,935,404, | 3,060,028, | 3,071,465, |
| 3,106,467, | 3,137,578, | 3,148,066, |
| 3,251,691, | 3,271,154, | 3,295,976, |
| 3,376,310, | 3,420,664, | 3,420,670, |
| 3,511,663, | 3,598,599, | 3,615,616, |

JP-B 28496/1965, 04135/1968,
JP-A 037436/1975, 089034/1975, 003231/1976,
Japanese Patent Application No. 145932/1987.

The nucleation accelerating agent may be contained in a lithographic printing material or a processing solution, preferably in a lithographic printing material, more preferably in an internal latent image type silver halide emulsion layer or other hydrophilic colloid layers (including intermediate and protective layers). Most preferably, the agent is contained in a silver halide emulsion layer or a layer adjacent thereto.

Preferably the nucleation accelerating agent is added in an amount of 10⁻⁶ to 10⁻² mol, more preferably 10⁻⁵ to 10⁻² mol per mol of silver halide. Where it is added to a processing solution, namely a developer or a preceding bath, its amount is preferably 10⁻⁸ to 10⁻³ mol, more preferably 10⁻⁷ to 10⁻⁴ mol per liter of the solution.

To enhance the action of the nucleation accelerating agent, any of the following compounds is preferably used in combination.

Included are hydroquinones (as described in USP 3,227,552 and 4,279,987), chromans (as described in USP 4,268,621, JP-A 103031/1979, and RD 18264 (1979)), quinones as described in RD 21206 (1981), amines as described in USP 4,150,993 and JP-A 174757/1983, oxidizing agents as described in RD 16936 (1978), catechols as described in JP-A 021013/1980 and 065944/1980, compounds capable of releasing nucleating agents upon development as described in JP-A 107029/1985, thioureas as described in JP-A 095533/1985, and spirobisindanes as described in JP-A 065944/1980.

The previously unfogged internal latent image type silver halide emulsion used herein is an emulsion in which silver halide grains are not previously fogged on their surface and a latent image is formed mainly in the grain interior. More particularly, provided that a silver halide emulsion is coated on a transparent support to a predetermined coverage, exposed for a fixed time of 0.01 to 10 seconds, and developed in a developer before the maximum density is measured by conventional photographic densitometry, the emulsion should preferably be such that the maximum density obtained upon development in developer A (internal developer, as defined below) at 20°C for 6 minutes is at least 5 times, preferably at least 10 times higher than the maximum density obtained upon development in developer B (surfacial developer, as defined below) at 18°C for 5 minutes.

| Internal developer A | |
|---|---|
| Metol | 2 g |
| Sodium sulfite (anhydrous) | 90 g |
| Hydroquinone | 8 g |
| Sodium carbonate monohydrate | 52.5 g |
| KBr | 5 g |
| KI | 0.5 g |
| Water totaling to | 1 liter |

| Surfacial developer B | |
|---|---|
| Metol | 2.5 g |
| L-ascorbic acid | 10 g |
| NaBO₂·4H₂O | 35 g |
| KBr | 1 g |
| Water totaling to | 1 liter |

Illustrative examples of the internal latent image type emulsion include conversion type silver halide emulsions and core/shell type silver halide emulsions as described in UK Patent No. 1,011,062 and US Patent Nos. 2,592,250 and 2,456,943. The core/shell type silver halide emulsions are described in JP-A 032813/1972, 032814/1972, 134721/1977, 156614/1977, 060222/1978, 066218/1978, 066727/1978, 127549/1980, 136641/1982, 070221/1983, 208540/1984, 216136/1984, 107641/1985, 247237/1985, 002148/1986, and 003137/1986, JP-B 18939/1981, 01412/1983, 01415/1983, 06935/1983, and 108528/1983, Japanese Patent Application No. 36424/1986, US Patent Nos. 3,206,313, 3,317,322, 3,761,266, 3,761,276, 3,850,637, 3,923,513, 4,035,185, 4,395,478, and 4,504,570, EP 0017148, and Research Disclosure, RD 16345 (November 1977).

Typical compositions of the silver halide are silver chloride, silver bromide, and mixed silver halide such as silver chlorobromide, silver chloroiodobromide, and silver iodobromide. The silver halide used herein are silver chloro(iodo)bromide, silver (iodo)chloride and silver (iodo)bromide which are devoid of silver iodide or contain less than 3 mol% of silver iodide, and silver chlorobromide containing less than 20 mol% of bromine.

The silver halide grains preferably have a mean grain size of 0.1 to 2 µm, more preferably from 0.15 to 1 µm. For spherical or nearly spherical grains, the mean grain size is an average of the diameters of grains and for cubic grains, it is an average based on the projected areas of grains with the side length being the grain size. The grain size distribution may be either narrow or wide although a commonly known "monodispersed" silver halide emulsion having a narrow grain size distribution that more than 90%, especially more than 95% based on grain number or weight of the entire grains fall within ±40%, more preferably within ±30%, most preferably within ±20% of the mean grain size is preferred for improving graininess and sharpness. To satisfy the designed-for gradation of the lithographic printing material, in emulsion layers having substantially the same color sensitivity, two or more monodispersed silver halide emulsions having different grain sizes or two or more silver halide emulsions containing grains of the same size, but of different sensitivities may be mixed in a single layer or coated as separate layers in an overlapping manner. Alternatively, two or more poly-dispersed silver halide emulsions or a mono-dispersed emulsion and a poly-dispersed emulsion may be mixed or overlapped.

The silver halide grains may have a regular crystal form such as cube, octahedron, dodecahedron (12-sided) and tetradecahedron (14 sided), an irregular crystal form such as spherical form or a composite form of these crystal forms. Also plate grains are acceptable, and especially useful are emulsions wherein plate grains having an aspect (length/breadth) ratio of at least 5, especially at least 8 occupy at least 50% of the overall projected areas of grains. Emulsions containing a mixture of different crystal form grains are also useful.

As used herein, the silver halide emulsion may be prepared in the presence of a silver halide solvent. Examples of the silver halide solvent include organic thioethers as described in USP 3,271,157, 3,531,289, and 3,574,628 and JP-A 001019/1979 and 158917/1979, and thiourea derivatives as described in JP-A 082408/1978, 077737/1980 and 002982/1980. In the preparation of such emulsions, grains may be doped with metals such as Ir, Rh, Ru, Pd, Pt, Pb and Fe during grain formation. The silver halide emulsion used herein may be chemically sensitized by effecting selenium sensitization, reducing sensitization or noble metal sensitization alone or in combination within or on silver halide grains.

To the lithographic printing material of the invention there are added sensitizing dyes represented by formulae (IV) and/or (V) for the purpose of increasing sensitivity. In addition, the lithographic printing material may contain further sensitizing dyes.

The sensitizing dyes may be used alone or in combination of two or more. A combination of sensitizing dyes is frequently used for supersensitization. Along with the sensitizing dye, a dye which itself is free of spectral sensitizing ability or a substance which does not substantially absorb visible light, but contributes to supersensitization may be contained in the emulsion.

Useful sensitizing dyes, dye combinations providing supersensitization and substances contributing to supersensitization are described in the foregoing patents as well as Research Disclosure, Vol. 176, 17643 (December 1978), page 23, items IV-A to J.

It will be understood that the sensitizing dyes or the like may be added at any step of the emulsion preparation process and at any stage after the end of preparation until coating. For example, they may be added at the step of grain formation, physical ripening or chemical ripening.

The sensitizing dye used herein may be selected from orthochromatic sensitizing dyes, panchromatic sensitizing dyes, and infrared sensitizing dyes in accordance with a high illuminance light source selected from conventional tungsten halide lamps and Ar, He-Ne and semiconductor lasers.

Sensitizing dyes represented by formulae (IV) and (V) are further specified below.

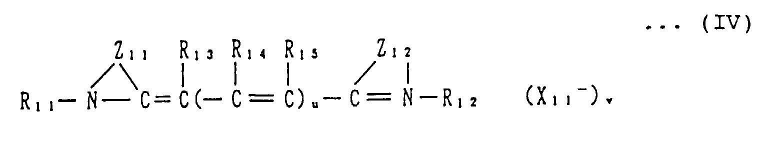

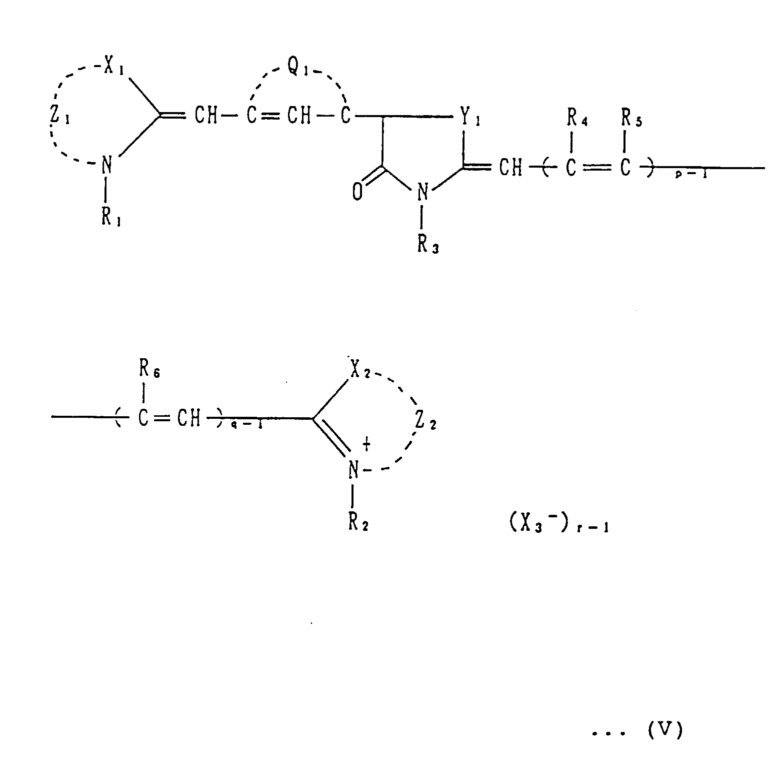

In formula (IV), Z₁₁ and Z₁₂, which may be identical or different, each represent a group of atoms forming a five or six-membered nitrogeneous heterocyclic ring with the nitrogen and carbon atoms, and letter u is equal to 0 or 1. R₁₁ and R₁₂, which may be identical or different, each represent a substituted or unsubstituted alkyl or alkenyl radical having up to 10 carbon atoms in total. R₁₃ and R₁₅ represent hydrogen atoms, or R₁₃ and R₁₁ taken together and R₁₅ and R₁₂ taken together may form a five or six-membered ring. R₁₄ is a hydrogen atom or a lower alkyl radical which may have a substituent. X₁₁ is an acid anion residue. Letter v is equal to 0 or 1. In the case of an internal salt, v is 0.

Preferred heterocyclic rings formed by Z₁₁ or Z₁₂ are shown below. Where u is equal to 0, Z₁₁ and Z₁₂ may be identical or different and form heterocyclic rings including thiazole, benzothiazole, naphthothiazole, dihydronaphthothiazole, selenazole, benzoselenazole, naphthoselenazole, dihydronaphthoselenazole, oxazole, benzoxazole, naphthoxazole, benzimidazole, naphthoimidazole, pyridine, quinoline, imidazo-[4,5-b]quinoxaline, and 3,3-dialkylindolenine rings. Where u is equal to 1, the preferred heterocyclic rings formed by Z₁₁ include thiazoline, thiazole, benzothiazole, selenazoline, selenazole, benzoselenazole, oxazole, benzoxazole, naphthoxazole, imidazole, benzimidazole, naphthoimidazole, and pyrroline rings and the preferred heterocyclic rings formed by Z₁₂ include oxazoline, oxazole, benzoxazole, naphthoxazole, thiazoline, selenazoline, pyrroline, benzimidazole, and naphthoimidazole rings.

The nitrogeneous heterocyclic rings formed by Z₁₁ or Z₁₂ may have one or more substituents. Preferred substituents include lower alkyl radicals which may be branched or which may, in turn, have a substituent (e.g., hydroxy radical, halogen atom, aryl, aryloxy, arylthio, carboxy, alkoxy, alkylthio, and alkoxycarbonyl radical), more preferably alkyl radicals having up to 10 carbon atoms in total, for example, methyl, ethyl, butyl, chloroethyl, 2,2,3,3-tetrafluoropropyl, hydroxyethyl, benzyl, tolylethyl, phenoxyethyl, phenylthioethyl, carboxypropyl, methoxyethyl, ethylthioethyl, and ethoxycarbonylethyl radicals; lower alkoxy radicals which may, in turn, have a substituent (which is the same as the exemplary substituents on the alkyl radicals), more preferably alkoxy radicals having up to 8 carbon atoms in total, for example, methoxy, ethoxy, pentyloxy, ethoxymethoxy, methylthioethoxy, phenoxyethoxy, hydroxyethoxy, and chloropropoxy radicals; a hydroxy radical; halogen atoms; a cyano radical; aryl radicals, for example, phenyl, tolyl, anisil, chlorophenyl and carboxyphenyl radicals; aryloxy radicals, for example, tolyloxy, anisiloxy, phenoxy and chlorophenoxy radicals; arylthio radicals, for example, tolylthio, chlorophenylthio and phenylthio radicals; lower alkylthio radicals which may, in turn, have a substituent (which is the same as the exemplary substituents on the alkyl radicals), more preferably alkylthio radicals having up to 8 carbon atoms in total, for example, methylthio, ethylthio, hydroxyethylthio, carboxyethylthio, chloroethylthio and benzylthio radicals; acylamino and sulfonylamino radicals, more preferably acylamino radicals having up to 8 carbon atoms in total, for example, acetylamino, benzoylamino, methanesulfonylamino and benzenesulfonylamino radicals; a carboxy radical; lower alkoxycarbonyl radicals, more preferably alkoxycarbonyl radicals having up to 6 carbon atoms in total, for example, ethoxycarbonyl and butoxycarbonyl radicals; perfluoroalkyl radicals, more preferably perfluoroalkyl radicals having up to 5 carbon atoms in total, for example, trifluoromethyl and difluoromethyl radicals; and acyl radicals, more preferably acyl radicals having up to 8 carbon atoms in total, for example, acetyl, propionyl, benzoyl and benzenesulfonyl radicals.

Examples of the nitrogeneous heterocyclic ring formed by Z₁₁ or Z₁₂ include thiazoline, 4-methylthiazoline, thiazole, 4-methylthiazole, 4,5-dimethylthiazole, 4-phenylthiazole, benzothiazole, 5-methylbenzothiazole, 6-methylbenzothiazole, 5-ethylbenzothiazole, 5,6-dimethylbenzothiazole, 5-methoxybenzothiazole, 6-methoxybenzothiazole, 5-butoxybenzothiazole, 5,6-dimethoxybenzothiazole, 5-methoxy-6-methylbenzothiazole, 5-chlorobenzothiazole, 5-chloro-6-methylbenzothiazole, 5-phenylbenzothiazole, 5-acetylaminobenzothiazole, 6-propionylaminobenzothiazole, 5-hydroxybenzothiazole, 5-hydroxy-6-methylbenzothiazole, 5-ethoxycarbonylbenzothiazole, 5-carboxybenzothiazole, naphtho[1,2-d]thiazole, naphtho[2,1-d]thiazole, 5-methylnaphtho[l,2-d]thiazole, 8-methoxynaphtho[1,2-d]thiazole, 8,9-dihydronaphthothiazole, 3,3-diethylindolenine, 3,3-dipropylindolenine, 3,3-dimethylindolenine, 3,3,5-trimethylindolenine, selenazoline, selenazole, benzoselenazole, 5-methylbenzoselenazole, 6-methylbenzoselenazole, 5-methoxybenzoselenazole, 6-methoxybenzoselenazole, 5-chlorobenzoselenazole, 5,6-dimethylbenzoselenazole, 5-hydroxybenzoselenazole, 5-hydroxy-6-methylbenzoselenazole, 5,6-dimethoxybenzoselenazole, 5-ethoxycarbonylbenzoselenazole, naphtho[1,2-d]selenazole, naphtho[1,2-d]selenazole, oxazole, 4-methyloxazole, 4,5-dimethyloxazole, 4-phenyloxazole, benzoxazole, 5-hydroxybenzoxazole, 5-methoxybenzoxazole, 5-phenylbenzoxazole, 5-phenethylbenzoxazole, 5-phenoxybenzoxazole, 5-chlorobenzoxazole, 5-chloro-6-methylbenzoxazole, 5-phenylthiobenzoxazole, 6-ethoxy-5-hydroxybenzoxazole, 6-methoxybenzoxazole, naphtho[1,2-d]oxazole, naphtho[2,1-d]oxazole, naphtho[2,3-d]oxazole, 1-ethyl-5-cyanobenzimidazole, 1-ethyl-5-chlorobenzimidazole, 1-ethyl-5,6-dichlorobenzimidazole, 1-ethyl-6-chloro-5-cyanobenzimidazole, 1-ethyl-6-chloro-5-trifluoromethylbenzimidazole, 1-propyl-5-butoxycarbonylbenzimidazole, l-benzyl-5-methylsulfonylbenzimidazole, 1-allyl-5-chloro-6-acetylbenzimidazole, 1-ethylnaphtho[l,2-d]imidazole, 1-ethyl-6-chloronaphtho[2,3-d]imidazole, 2-quinoline, 4-quinoline, 8-fluoro-4-quinoline, 6-methyl-2-quinoline, 6-hydroxy-2-quinoline, and 6-methoxy-2-quinoline.

R₁₁ and R₁₂, which may be identical or different, each represent a substituted or unsubstituted alkyl or alkenyl radical having up to 10 carbon atoms in total. Preferred substituents on the alkyl and alkenyl radicals include sulfo, carboxy, halogen atom, hydroxy, alkoxy radicals having up to 6 carbon atoms, substituted or unsubstituted aryl radicals having up to 8 carbon atoms (e.g., phenyl, tolyl, sulfophenyl and carboxyphenyl radicals), heterocyclic radicals (e.g., furyl and thienyl radicals), substituted or unsubstituted aryloxy radicals having up to 8 carbon atoms (e.g., chlorophenoxy, phenoxy, sulfophenoxy and hydroxyphenoxy radicals), acyl radicals having up to 8 carbon atoms (e.g., benzenesulfonyl, methanesulfonyl, acetyl and propionyl radicals), alkoxycarbonyl radicals having up to 6 carbon atoms (e.g., ethoxycarbonyl and butoxycarbonyl radicals), cyano radicals, substituted or unsubstituted alkylthio radicals having up to 6 carbon atoms (e.g., methylthio and ethylthio radicals), substituted or unsubstituted arylthio radicals having up to 8 carbon atoms (e.g., phenylthio and tolylthio radicals), substituted or unsubstituted carbamoyl radicals having up to 8 carbon atoms (e.g., carbamoyl and N-ethylcarbamoyl radicals), and acylamino radicals having up to 8 carbon atoms (e.g., acetylamino and methanesulfonylamino radicals). When substituted, these radicals may have one or more substituents.

Examples of the radical represented by R₁₁ and R₁₂ include methyl, ethyl, propyl, allyl, pentyl, hexyl, methoxyethyl, ethoxyethyl, phenethyl, tolylethyl, sulfophenethyl, 2,2,2-trifluoroethyl, 2,2,3,3-tetrafluoropropyl, carbamoylethyl, hydroxyethyl, 2-(2-hydroxyethoxy)ethyl, carboxymethyl, carboxyethyl, ethoxycarbonylmethyl, sulfoethyl, 2-chloro-3-sulfopropyl, 3-sulfopropyl, 2-hydroxy-3-sulfopropyl, 3-sulfobutyl, 4-sulfobutyl, 2-(2,3-dihydroxypropyloxy)ethyl, and 2-[2-(3-sulfopropyloxy)ethoxy]ethyl radicals.

Each of R₁₃ and R₁₅ represents a hydrogen atom, or R₁₃ and R₁₁ taken together and R₁₅ and R₁₂ taken together may form a five or six-membered ring.

R₁₄ is a hydrogen atom or a lower alkyl radical which may have a substituent, for example, methyl, ethyl, propyl, methoxyethyl, and phenethyl radicals, with alkyl radicals having up to 5 carbon atoms being preferred.

X₁₁ is an acid anion residue, for example, a chloride ion, bromide ion, iodide ion, perchlorate ion, rhodanate ion and p-toluenesulfonate ion.

Letter v is equal to 0 or 1, and v = 0 in the case of an internal salt.

Preferred among the sensitizing dyes of formula (IV) are those dyes of the formula wherein u is 1, Z₁₁ is a group of atoms forming a heterocyclic ring such as oxazole, benzoxazole, and naphthoxazole, Z₁₂ is a group of atoms forming a heterocyclic ring such as benzimidazole and naphthoimidazole, at least one of R₁₁ and R₁₂ is a radical having a sulfo, carboxy or hydroxy radical, and R₁₄ is a hydrogen atom. As previously described, the heterocyclic nucleus represented by each of Z₁₁ and Z₁₂ may have one or more substituents thereon which are preferably electron attracting substituents when Z₁₂ forms a benzimidazole or naphthoimidazole nucleus.

More preferred among the sensitizing dyes of formula (IV) are those dyes of the formula wherein u is 1, Z₁₁ is a group of atoms forming a benzoxazole nucleus, Z₁₂ is a group of atoms forming a benzimidazole nucleus, at least one of R₁₁ and R₁₂ is a radical having a sulfo or carboxy radical, and R₁₄ is a hydrogen atom. As previously described, the heterocyclic nucleus represented by each of Z₁₁ and Z₁₂ may have one or more substituents thereon. For the benzimidazole nucleus, such substituents are preferably selected from a chlorine atom, fluorine atom, cyano radical, alkoxycarbonyl radicals having up to 5 carbon atoms in total, acyl radicals having up to 7 carbon atoms in total, and perfluoroaclkyl radicals having up to 4 carbon atoms (e.g., trifluoromethyl radical). For the other heterocyclic nuclei, such substituents are preferably selected from substituted or unsubstituted phenyl radicals having up to 8 carbon atoms, alkyl radicals having up to 5 carbon atoms, alkoxy radicals having up to 5 carbon atoms, acylamino radicals having up to 5 carbon atoms in total, carboxy radicals, alkoxycarbonyl radicals having up to 5 carbon atoms in total, benzyl radical, phenethyl radical, and chlorine atom.

Illustrative, non-limiting examples of the compound of formula (IV) are given below.

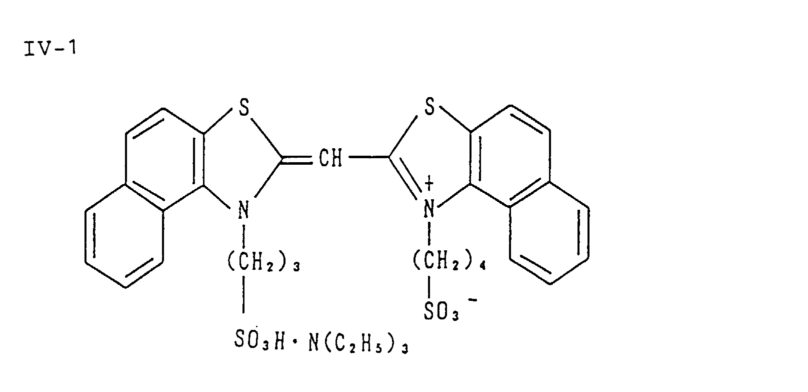

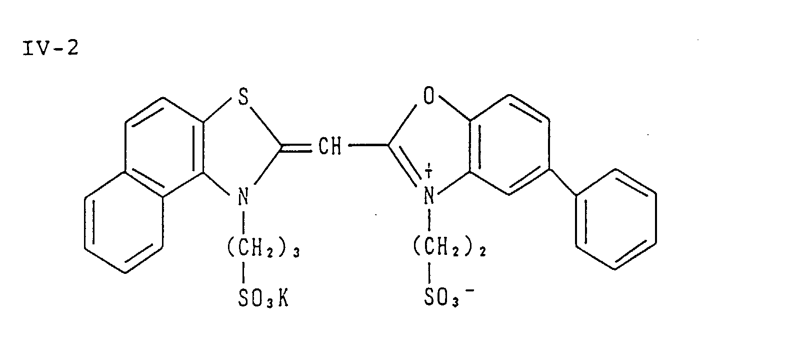

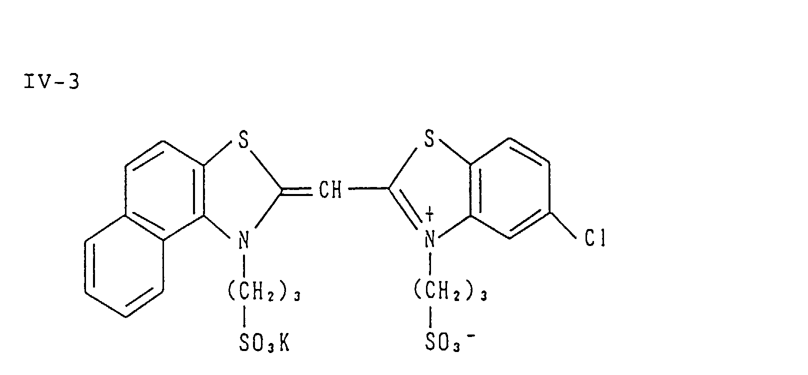

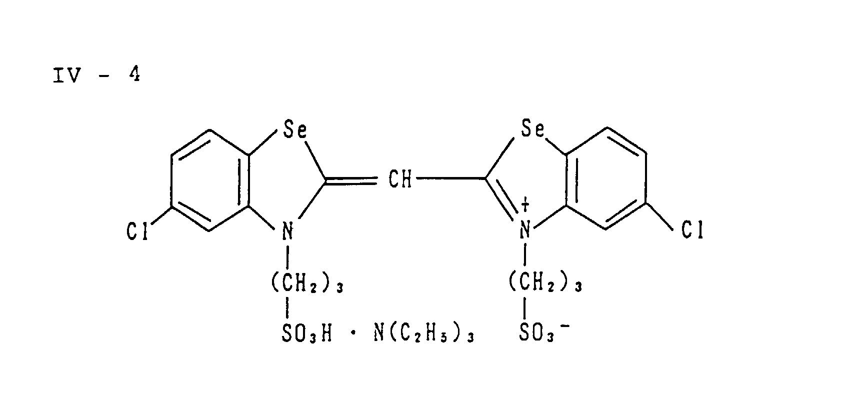

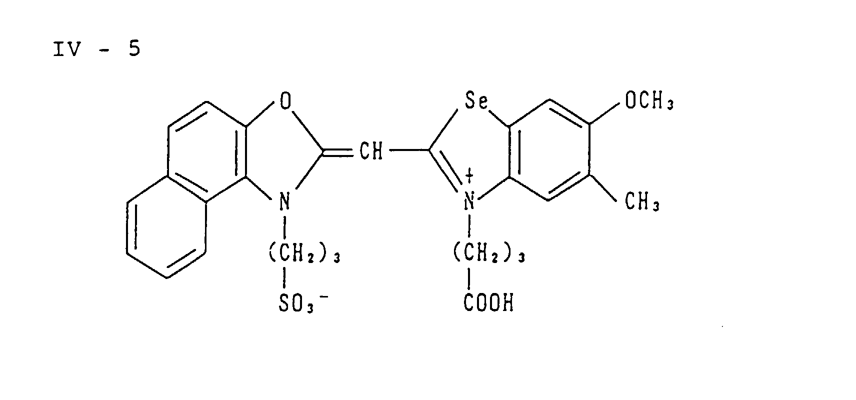

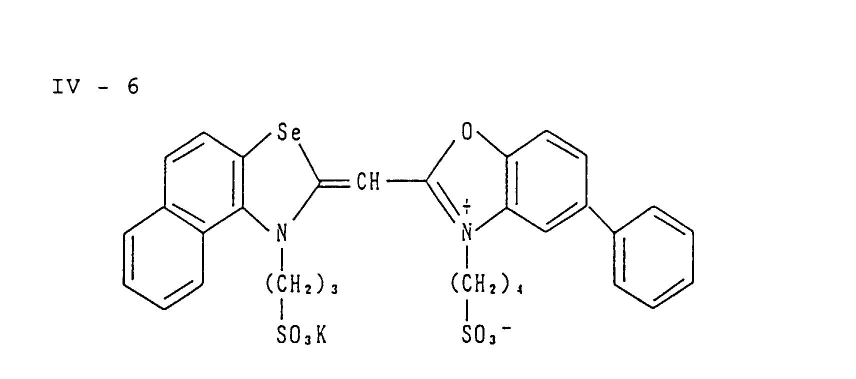

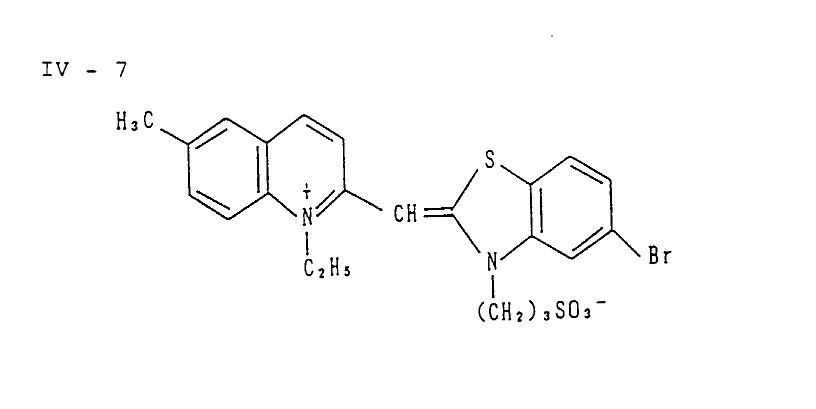

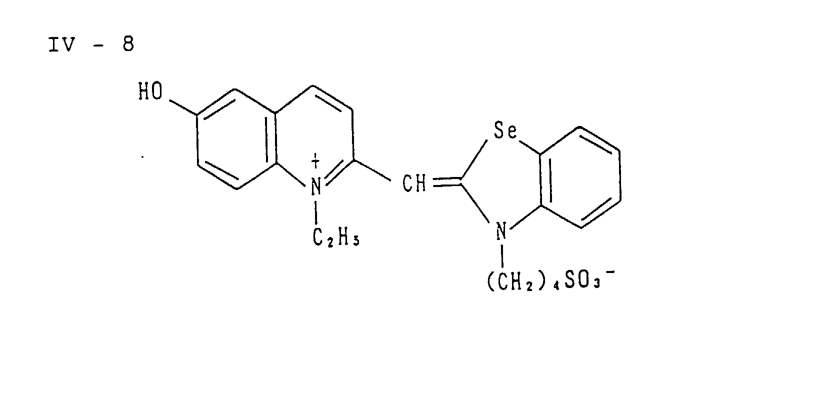

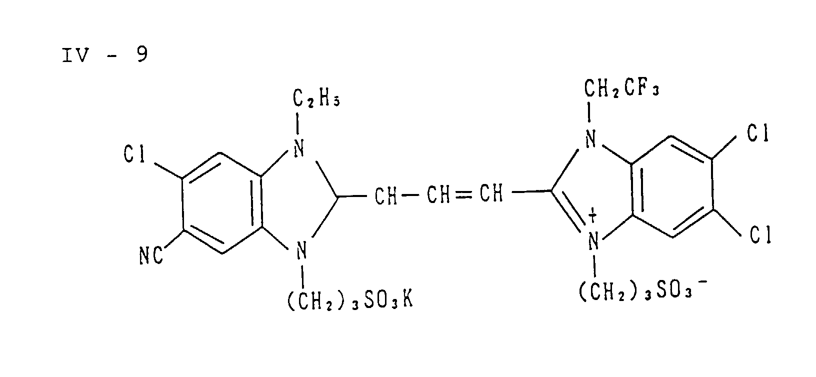

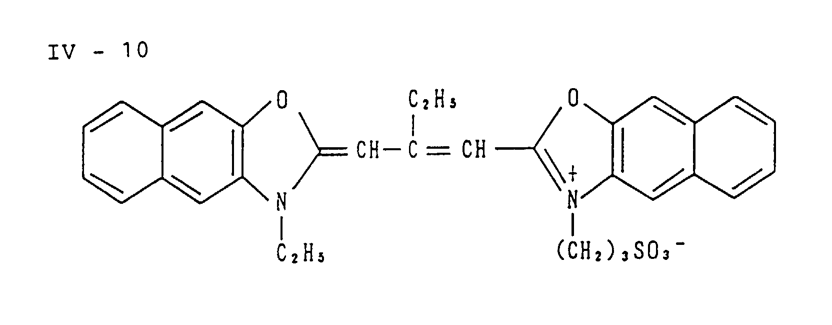

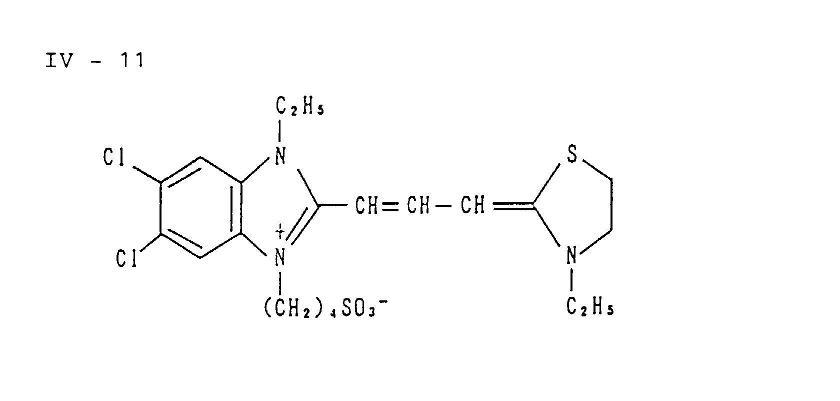

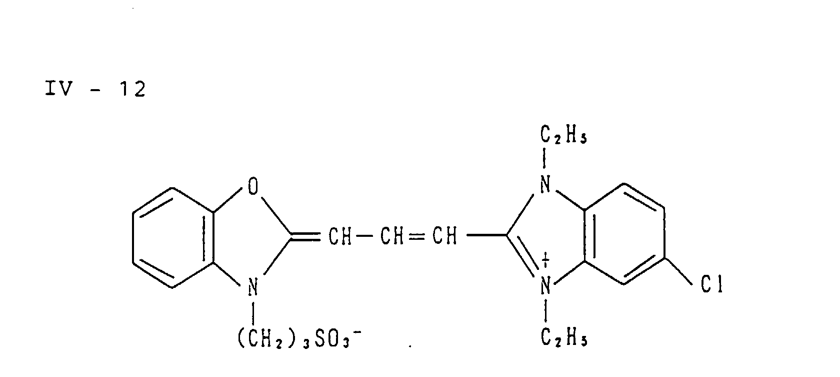

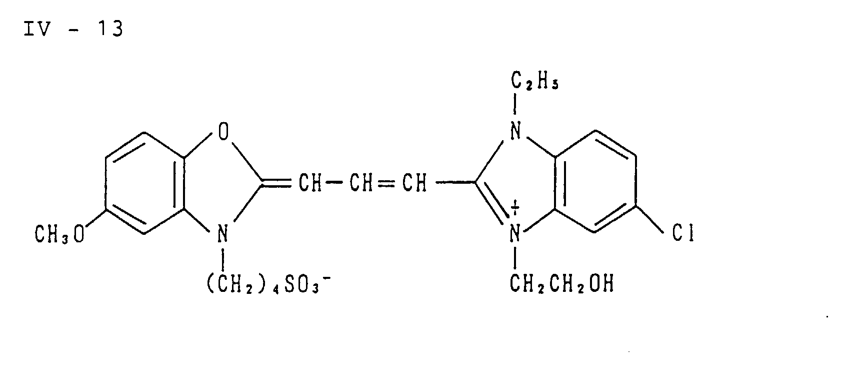

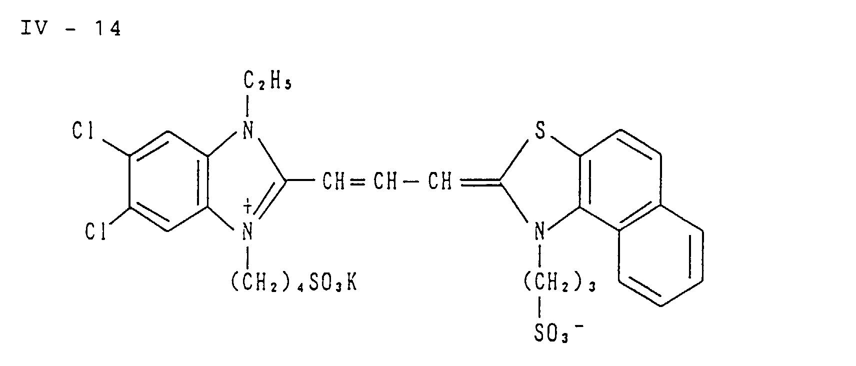

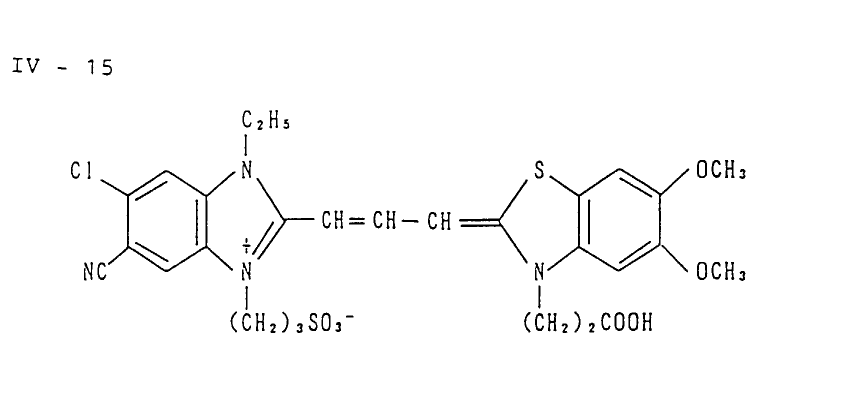

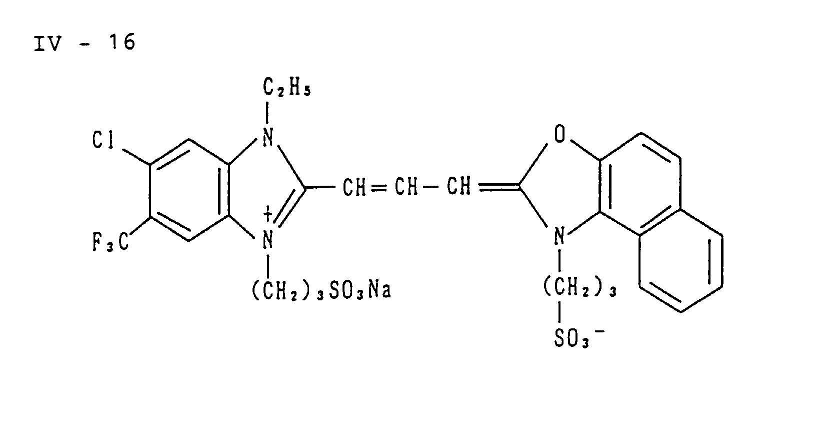

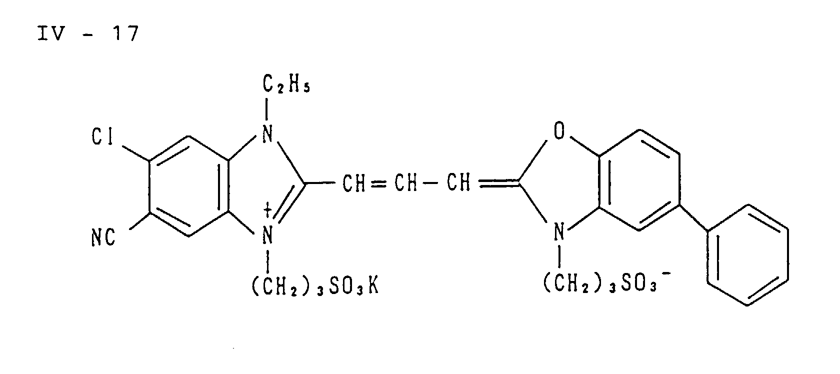

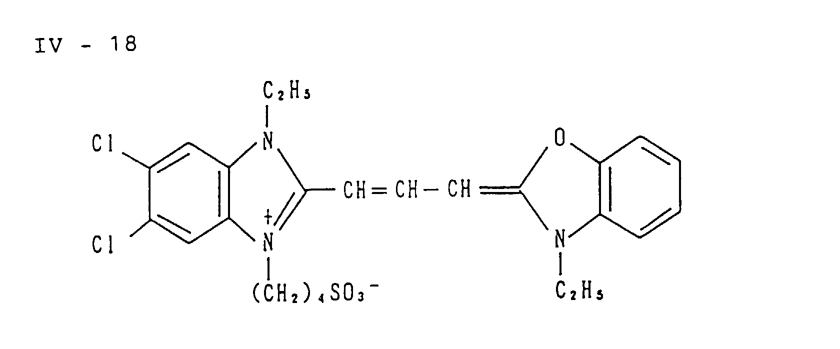

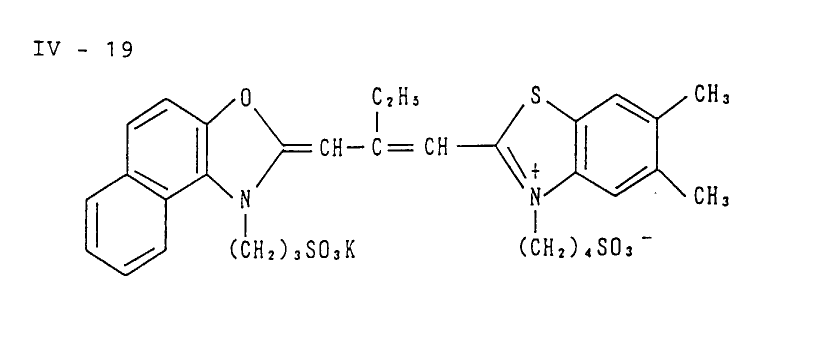

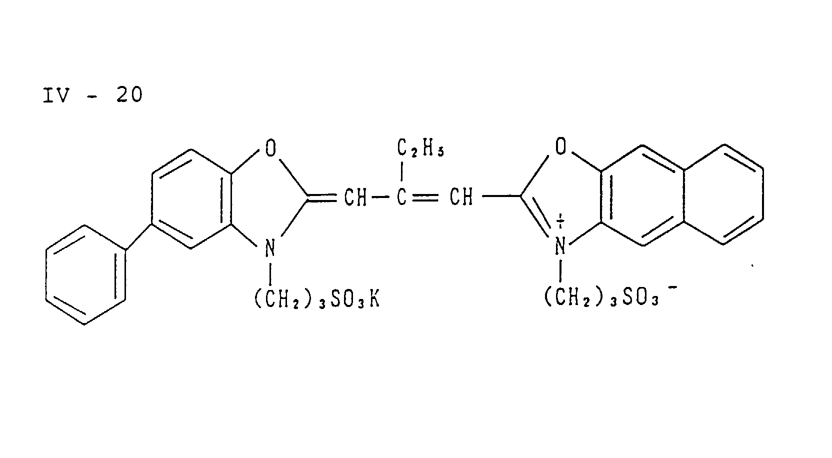

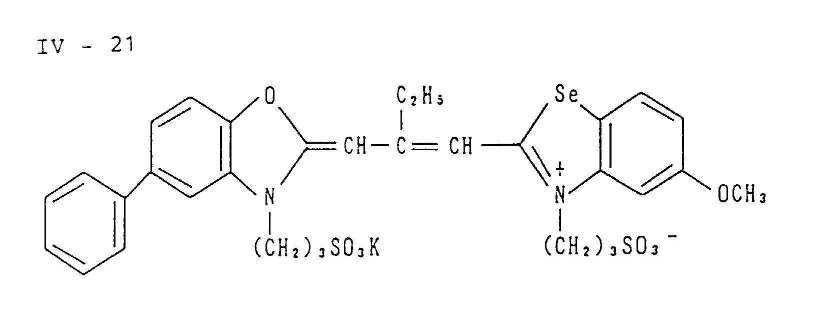

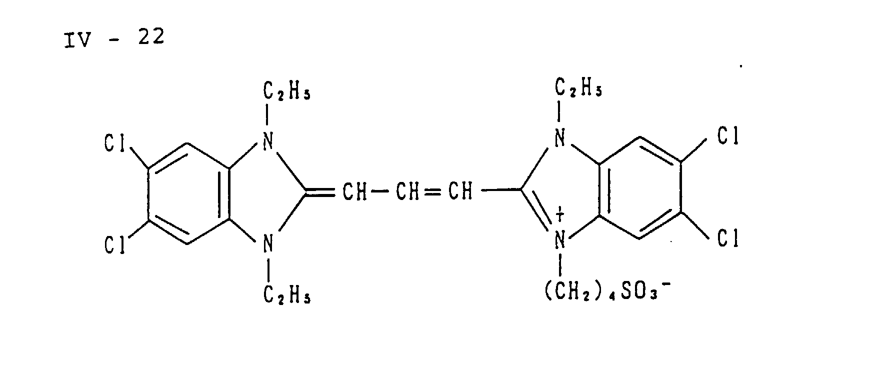

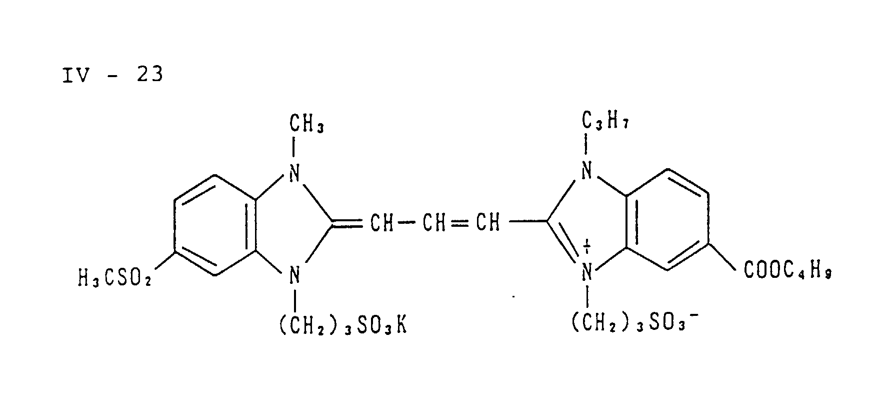

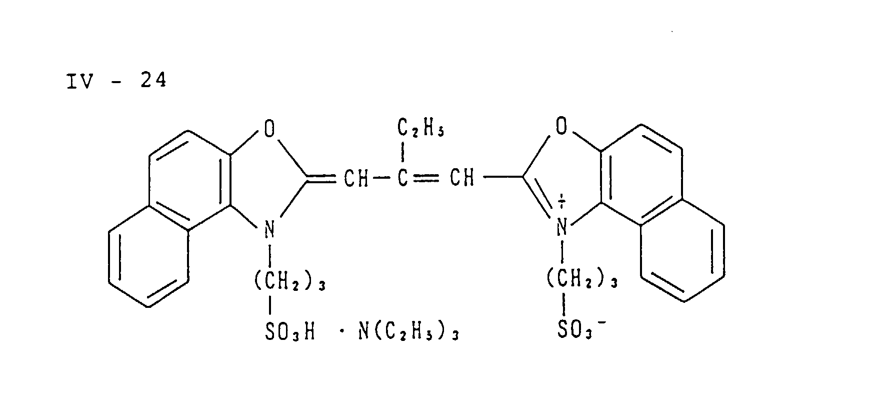

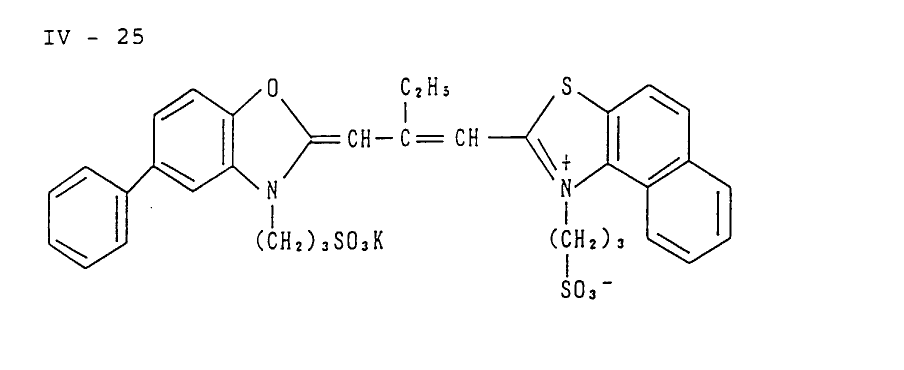

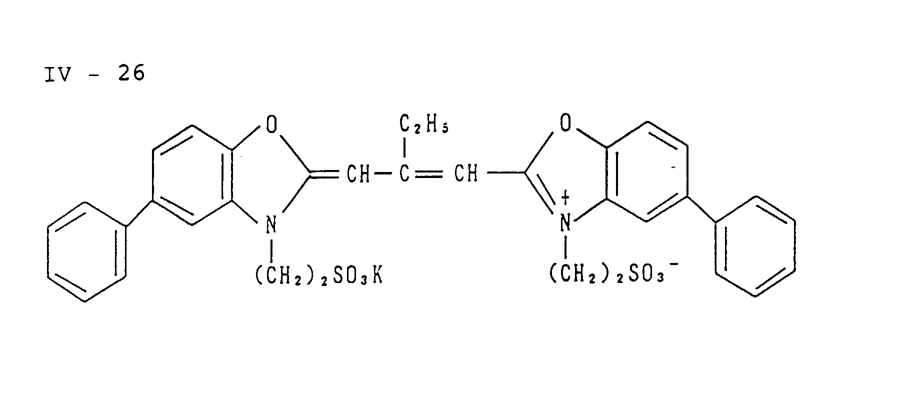

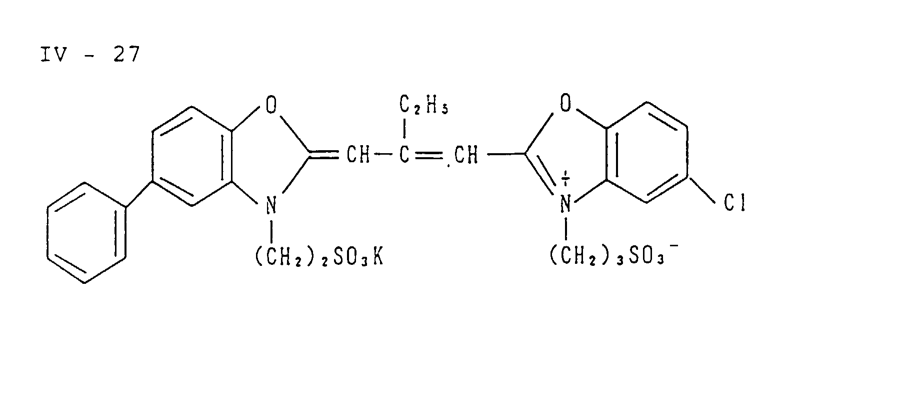

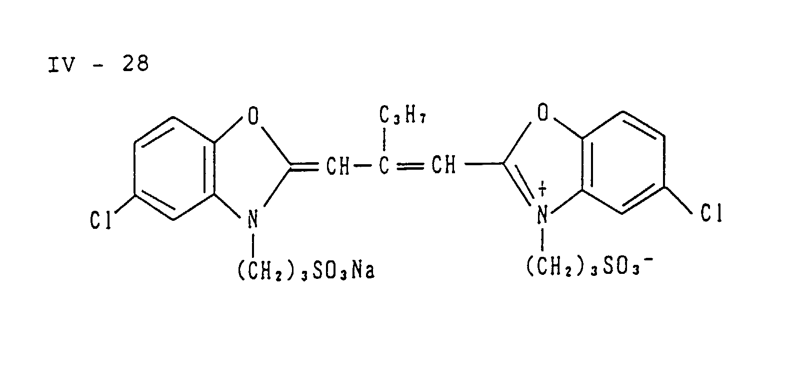

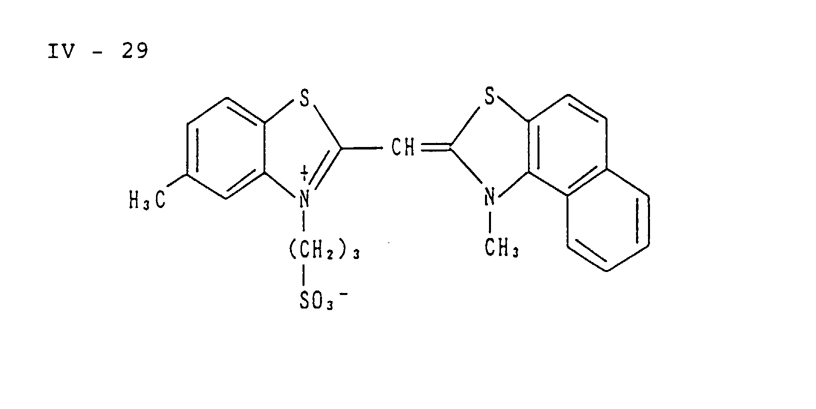

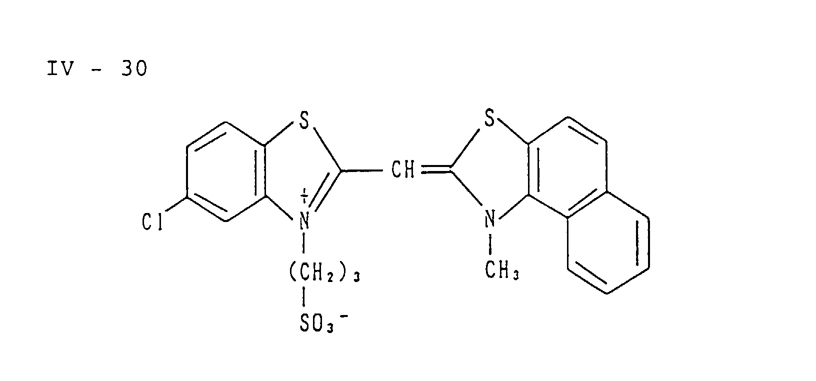

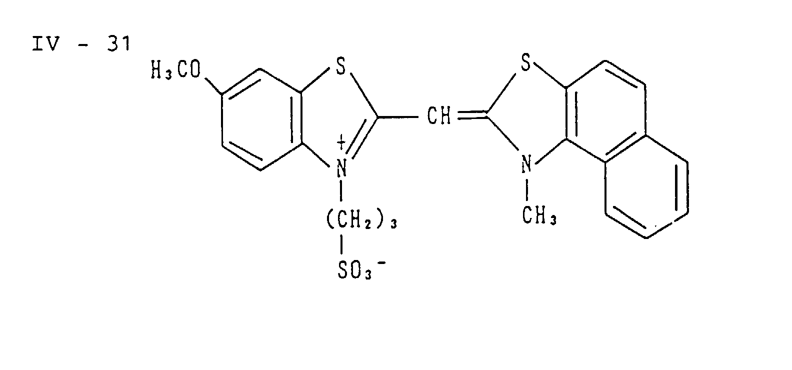

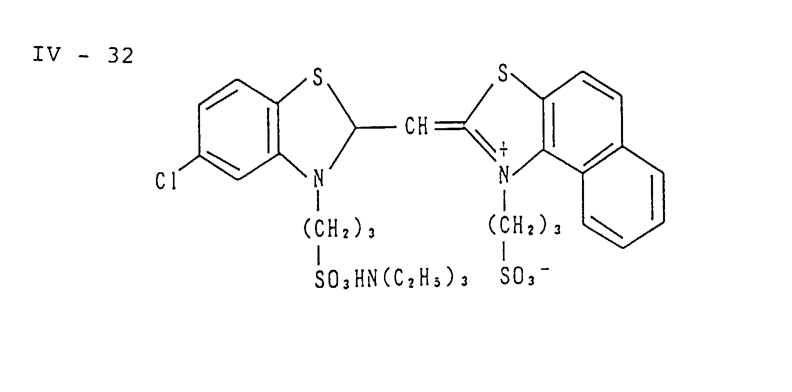

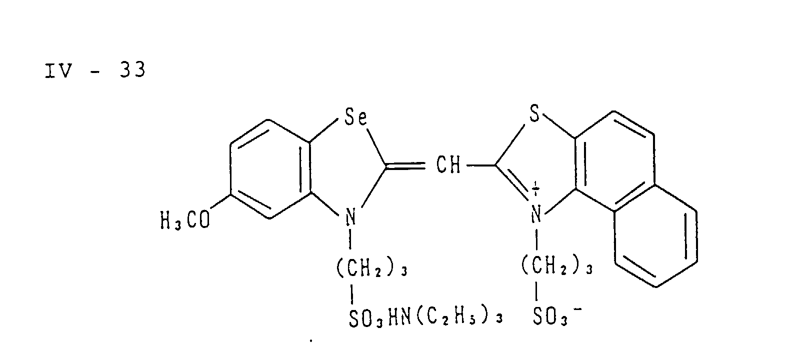

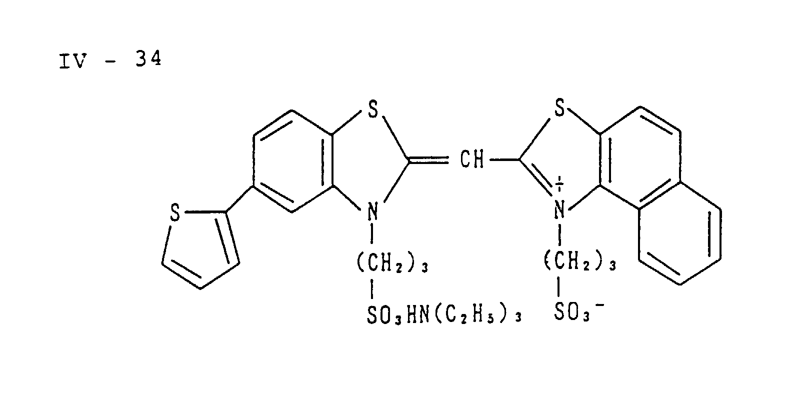

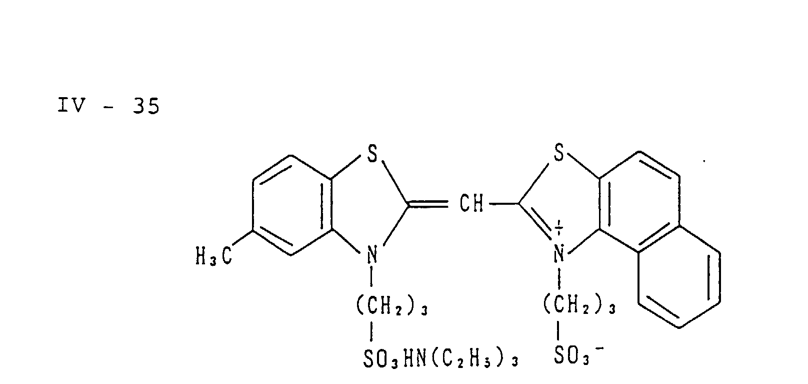

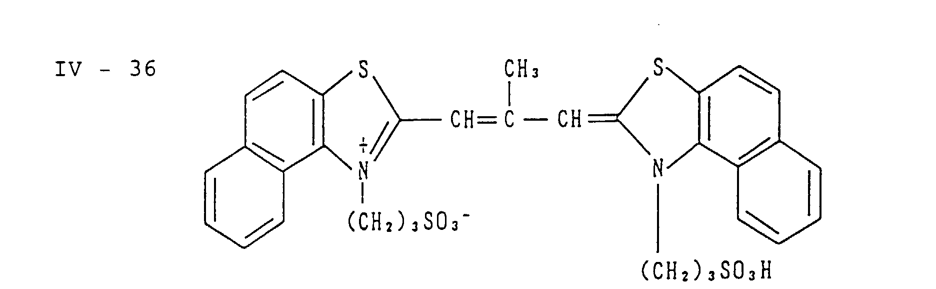

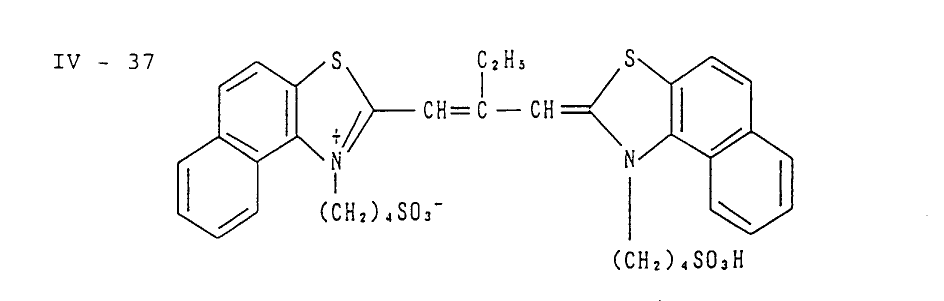

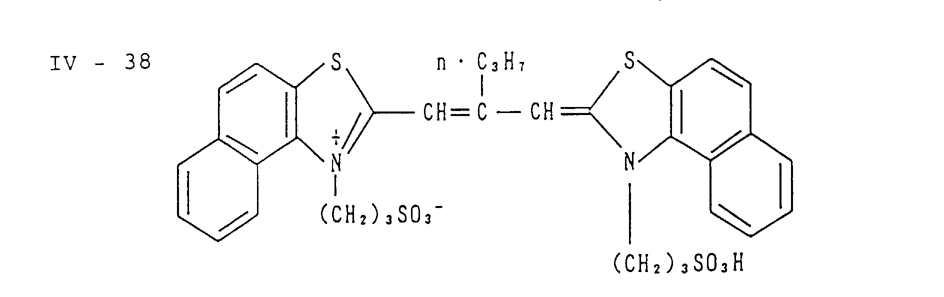

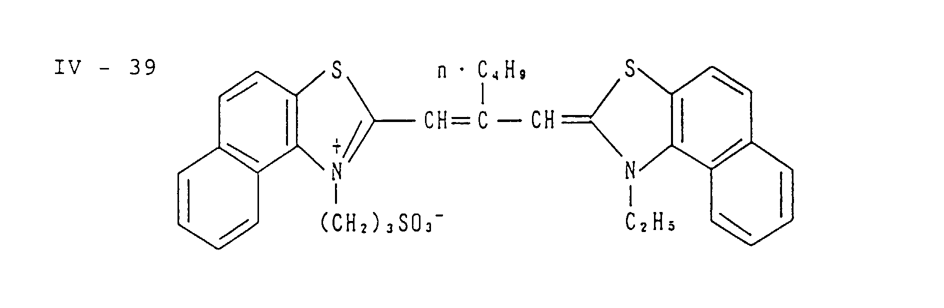

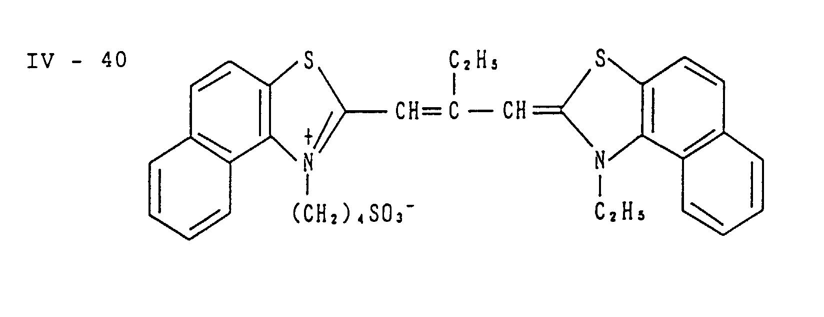

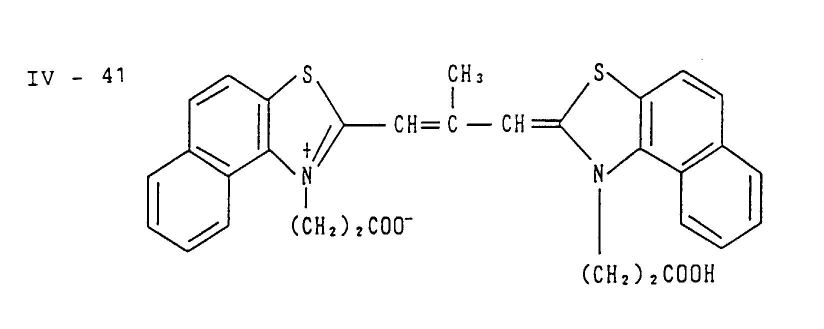

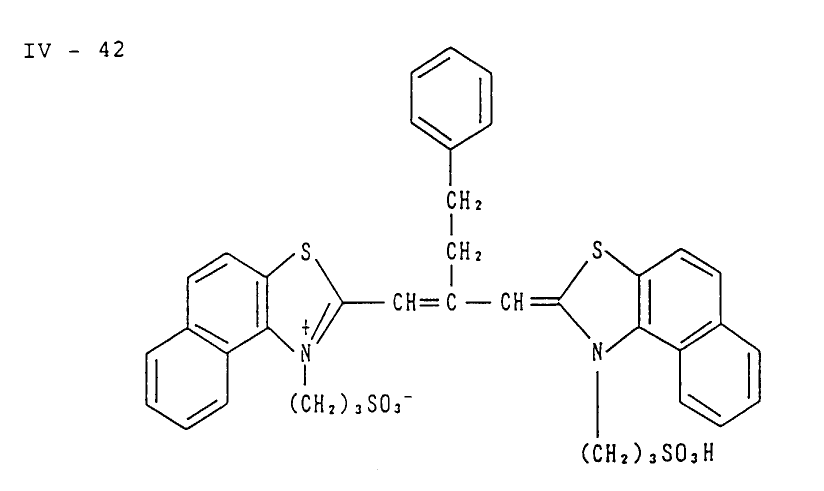

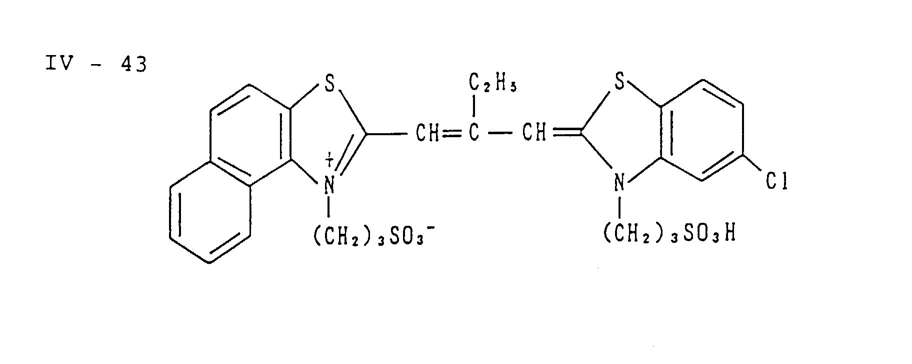

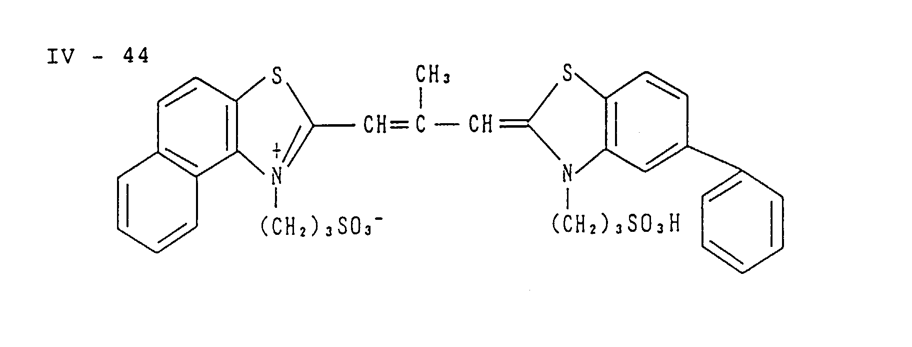

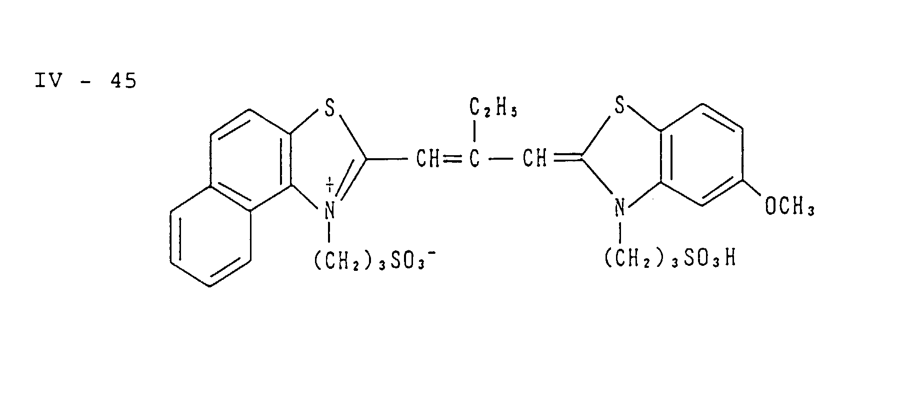

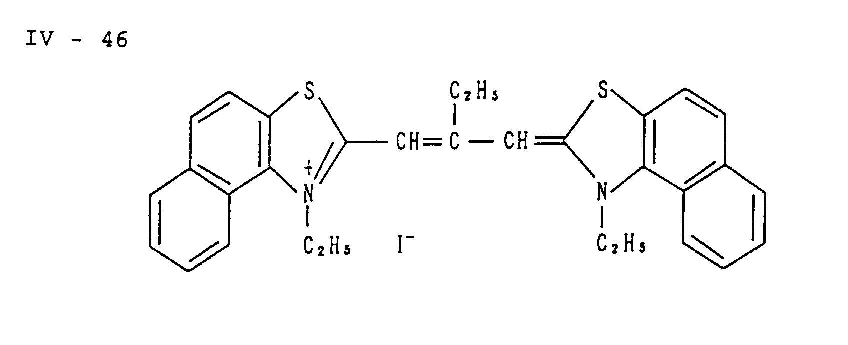

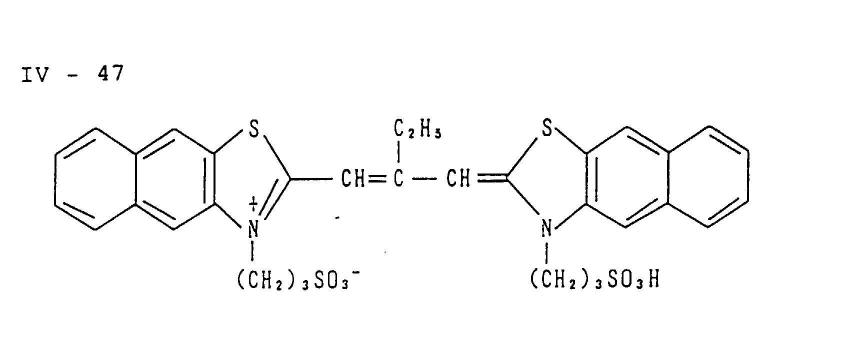

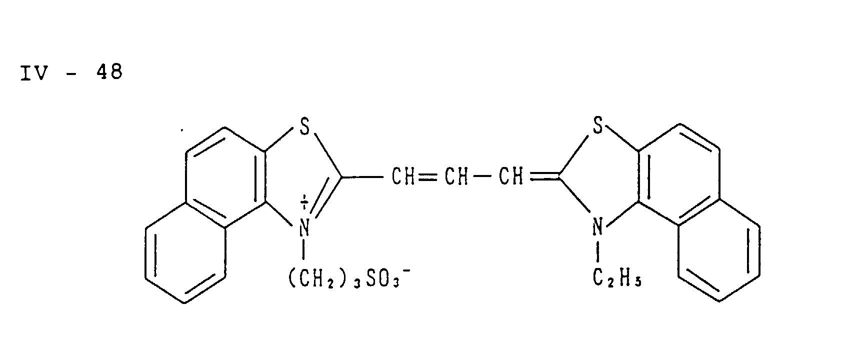

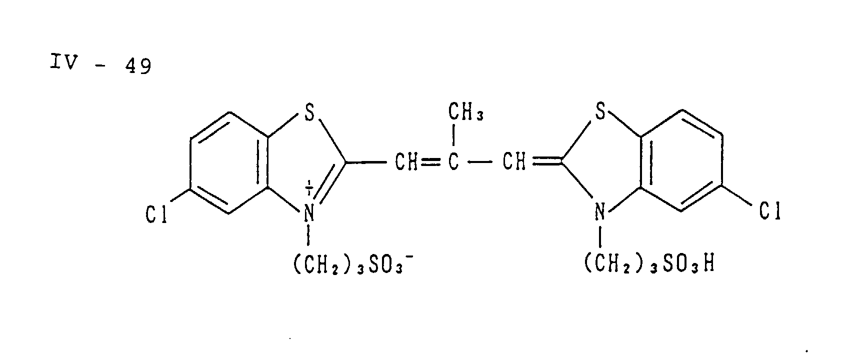

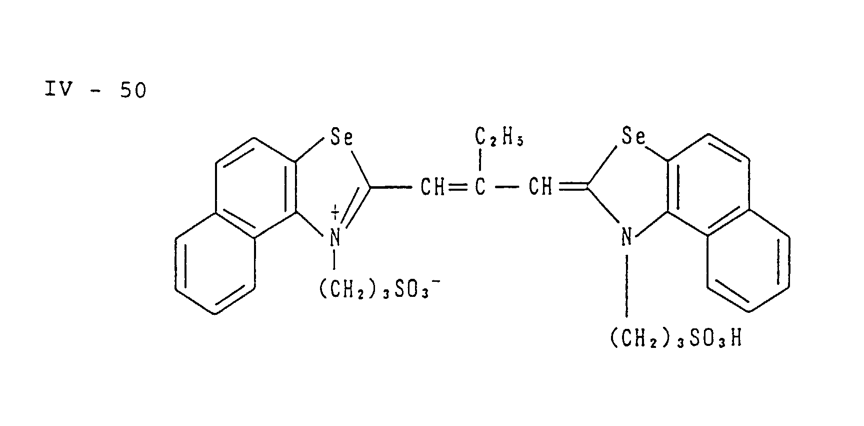

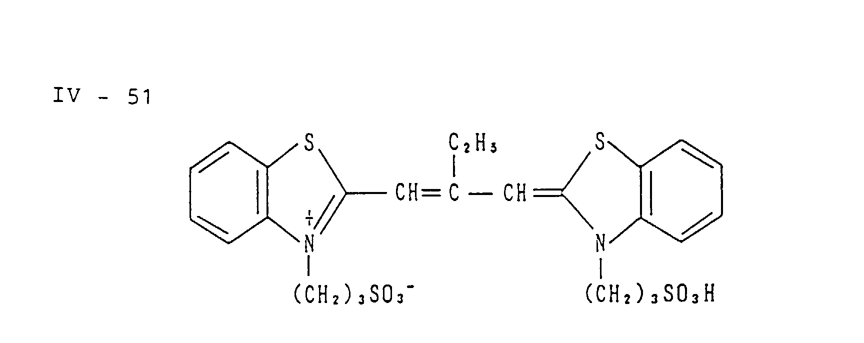

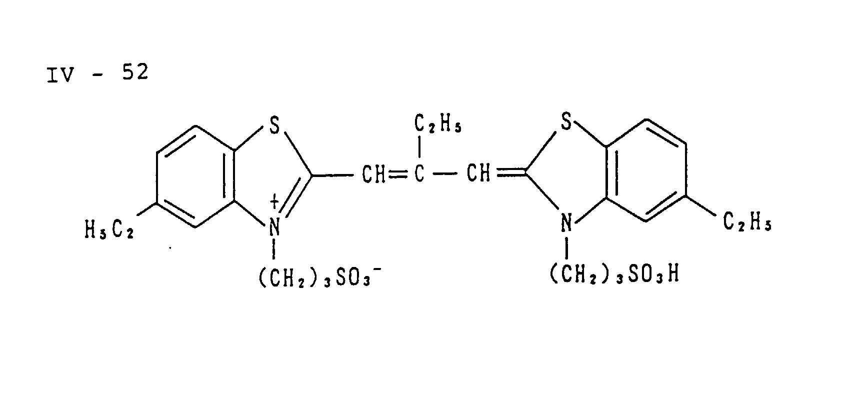

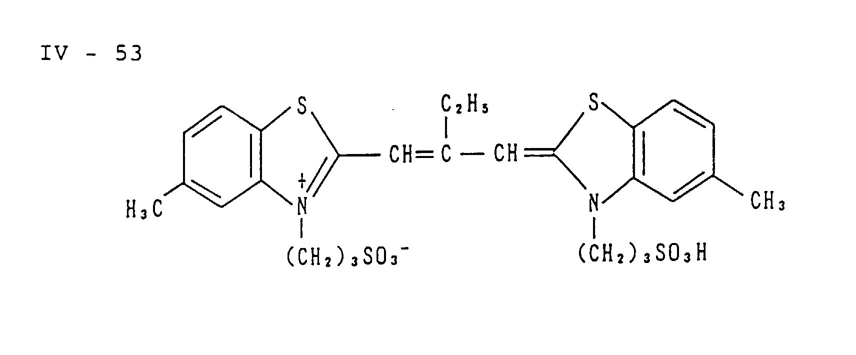

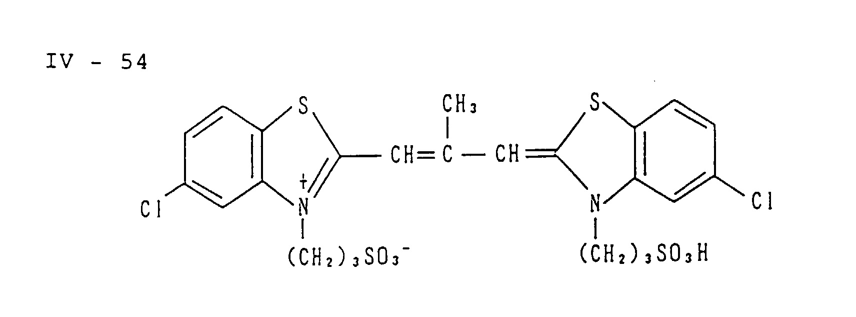

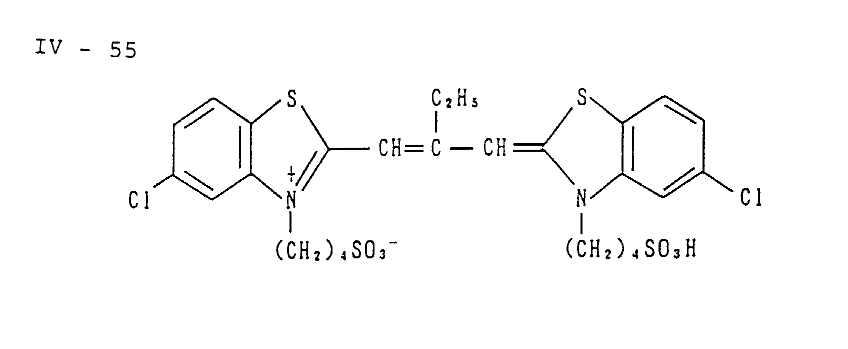

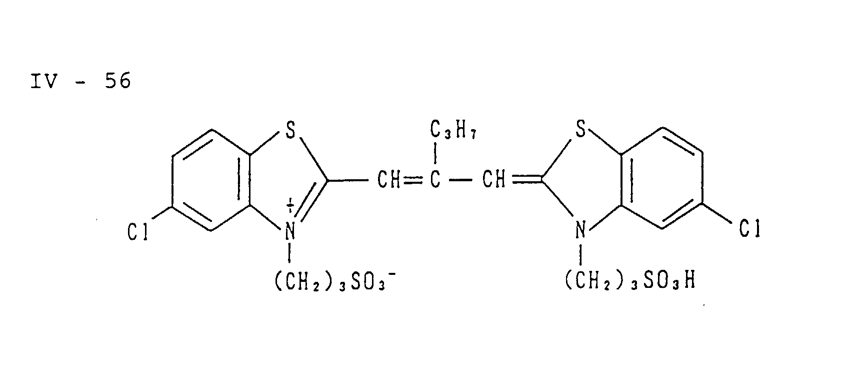

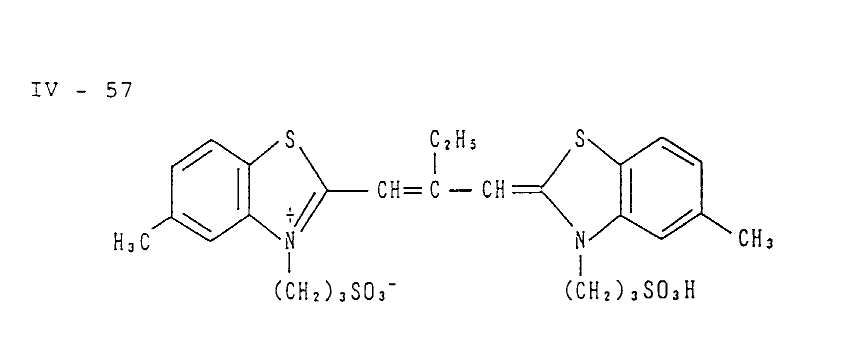

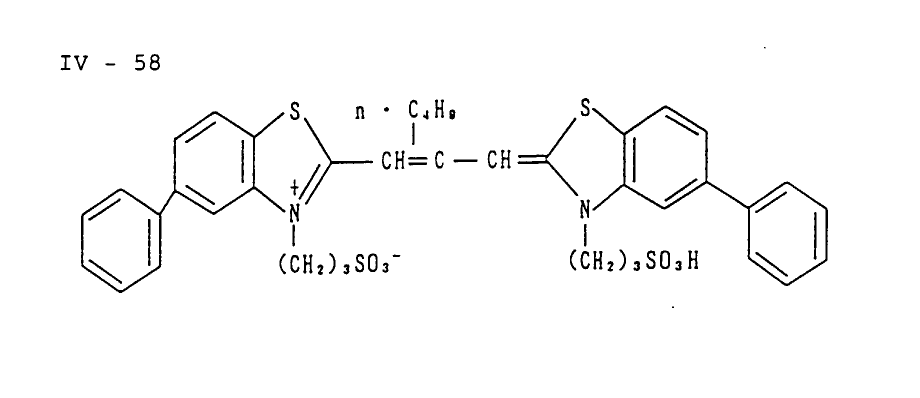

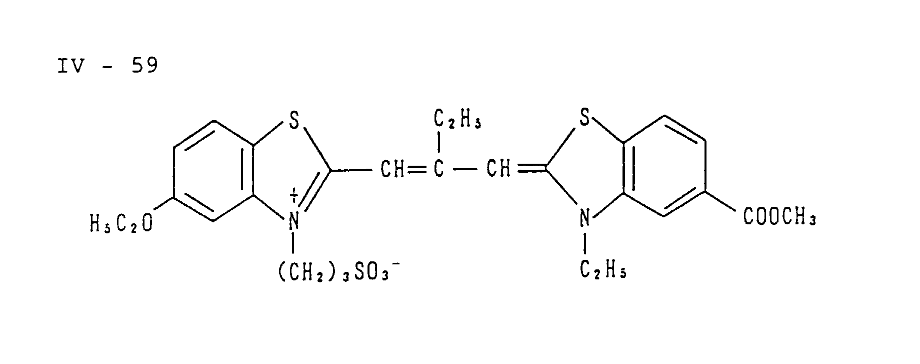

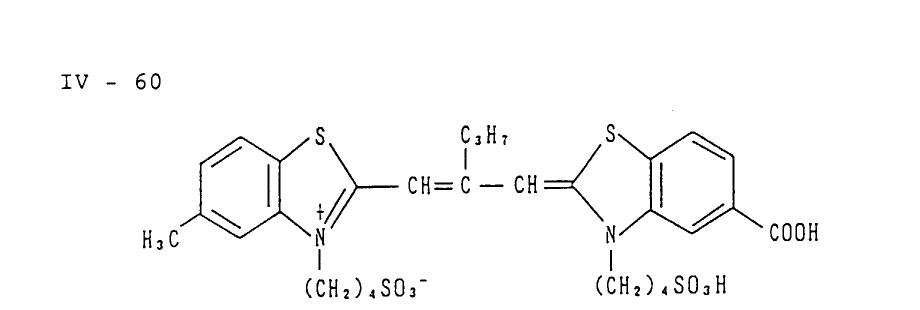

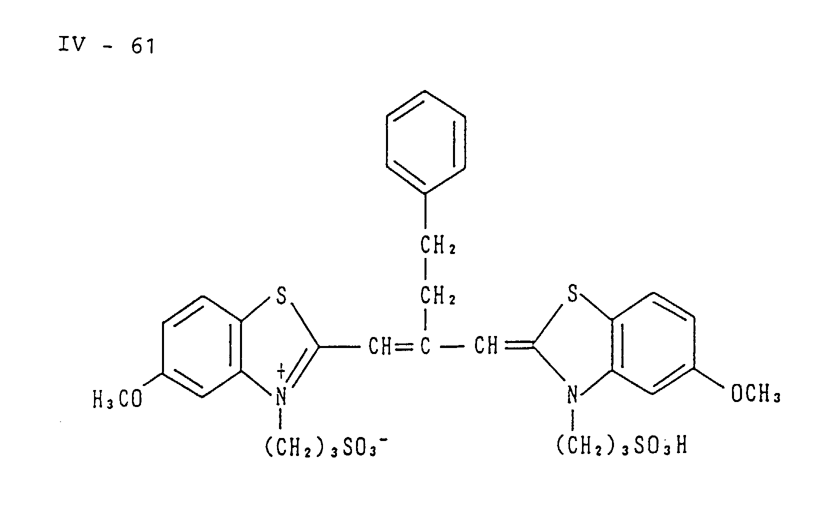

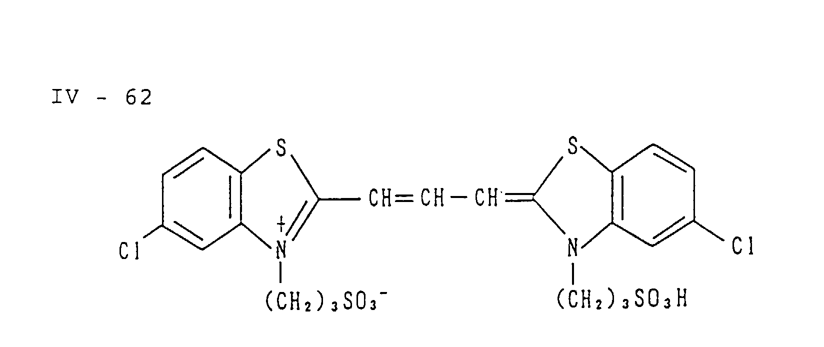

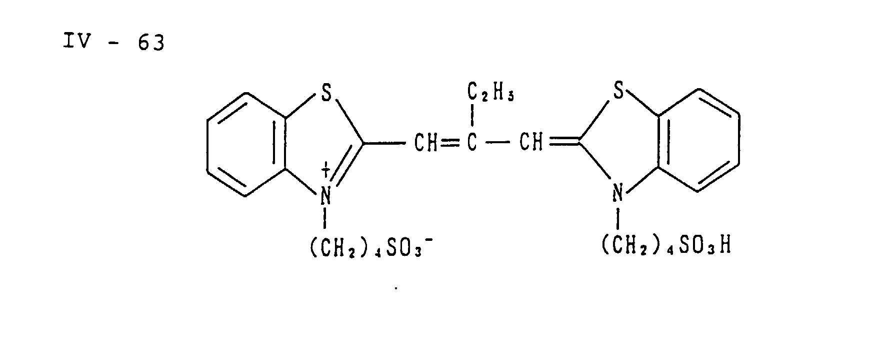

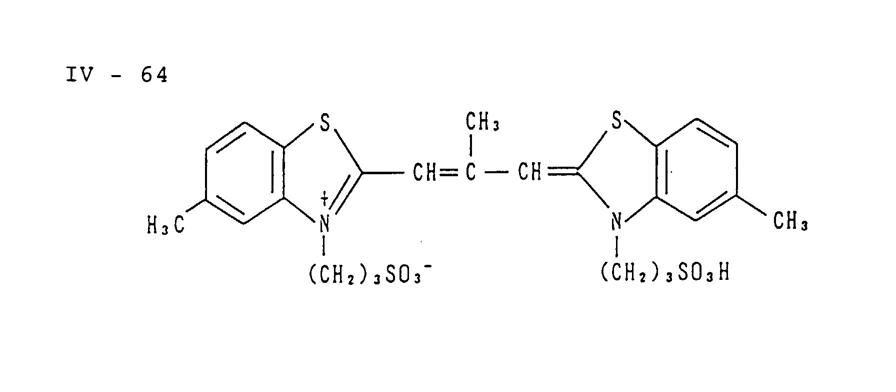

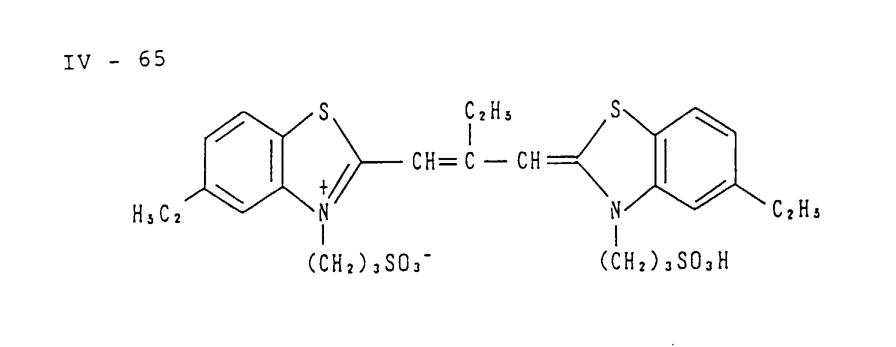

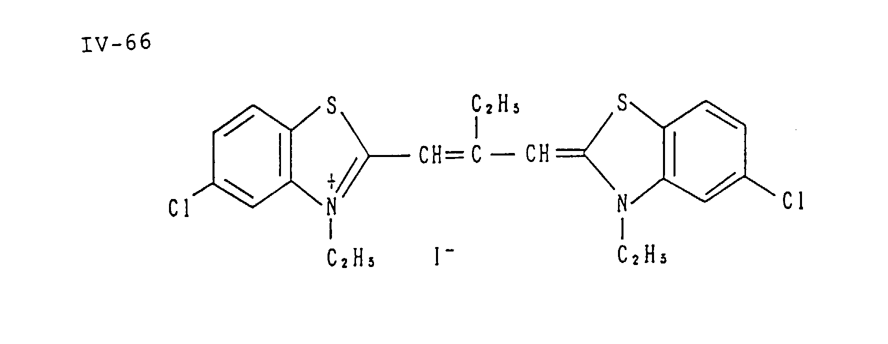

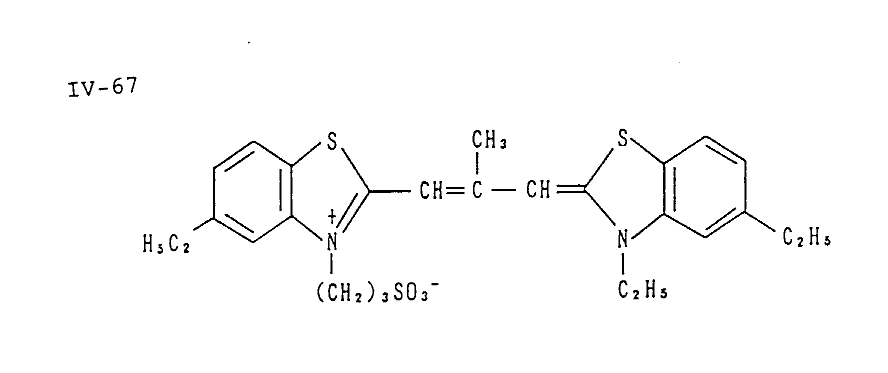

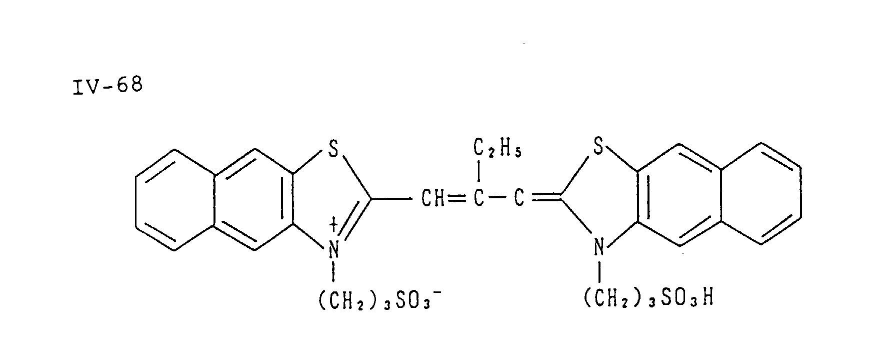

In formula (V), X₁ and X₂, which may be identical or different, each represent an oxygen atom, sulfur atom, selenium atom, a radical of the formula: >N-R₇ wherein R₇ is an alkyl radical or a radical of the formula: 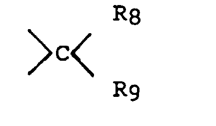 wherein R₈ and R₉ are alkyl radicals. Z₁ and Z₂, which may be identical or different, each represent a group of atoms necessary to form a five-membered nitrogenous heterocyclic ring. R₁ and R₂, which may be identical or different, each represent an alkyl or alkenyl radical. R₃ is an alkyl, alkenyl or aryl radical. R₄, R₅ and R₆, which may be identical or different, each represent a hydrogen atom, halogen atom, alkyl radical or aryl radical. Y₁ represents a sulfur atom, an oxygen atom or a radical of the formula: >N-R₁₀ wherein R₁₀ is an alkyl radical. Q₁ is a group of atoms necessary to form a five or six-membered ring by connecting to the carbon atoms of the methylene linkage. X₃ is an acid anion. Letters p, q and r each are equal to 1 or 2.

Examples of the nitrogenous heterocyclic ring formed by Z₁ or Z₂ include thiazole, benzothiazole, naphtho[1,2-d]thiazole, naphtho[2,1-d]thiazole, naphtho[2,3-d]thiazole, selenazole, benzoselenazole, naphtho[2,1-d]selenazole, naphtho[1,2-d]selenazole, oxazole, benzoxazole, naphtho[1,2-d]oxazole, [2,1-d]oxazole, naphtho[2,3-d]oxazole, 3,3-dialkylindolenine, imidazole, benzimidazole, and naphtho[1,2-d]imidazole. These heterocyclic rings may have one or more substituents, for example, alkyl radicals (e.g., methyl, ethyl, butyl and trifluoromethyl radicals), aryl radicals (e.g., phenyl and tolyl radicals), hydroxy radicals, alkoxy radicals (e.g., methoxy, ethoxy, and butoxy radicals), carboxy radicals, alkoxycarbonyl radicals (e.g., methoxycarbonyl and ethoxycarbonyl radicals), halogen atoms (e.g., fluorine, chlorine, bromine and iodine), aralkyl radicals (e.g., benzyl and phenethyl radicals), cyano radical, and alkenyl radicals (e.g., allyl radicals).

Examples of the alkyl radical represented by R₁ and R₂ include lower alkyl radicals such as methyl, ethyl, propyl and butyl; hydroxyalkyl radicals such as β-hydroxyethyl and γ-hydroxypropyl; alkoxyalkyl radicals such as β-methoxyethyl and γ-methoxypropyl; acyloxyalkyl radicals such as β-acetoxyethyl, γ-acetoxypropyl and β-benzoyloxyethyl; carboxyalkyl radicals such as carboxymethyl and β-carboxyethyl; alkoxycarbonylalkyl radicals such as methoxycarbonylmethyl, ethoxycarbonylethyl and β-ethoxycarbonylethyl; sulfoalkyl radicals such as β-sulfoethyl, γ-sulfopropyl and δ-sulfobutyl; and aralkyl radicals such as benzyl, phenethyl and sulfobenzyl. An exemplary alkenyl radical is an allyl radical.

Exemplary radicals represented by R₃ are alkyl and alkenyl radicals as described just above for R₁ and R₂ as well as aryl radicals such as phenyl, tolyl, methoxyphenyl, chlorophenyl and naphthyl radicals.

R₄ to R₆ represent hydrogen atoms, alkyl and aryl radicals as described just above, and halogen atoms such as fluorine, chlorine, bromine and iodine. The alkyl radicals represented by R₇ to R₁₀ are preferably lower alkyl radicals such as methyl and ethyl. The ring represented by Q₁ may have a lower alkyl substituent such as methyl.

X₃ is an acid anion, for example, an alkyl sulfate ion (e.g., methyl sulfate and ethyl sulfate), thiocyanate ion, toluenesulfonate ion, a halogen ion (e.g., a chloride, bromide, and iodide ion), and a perchlorate ion, but is absent where the dye has a betain analogous structure.

Illustrative, non-limiting examples of the sensitizing dye of formula (V) are given below.

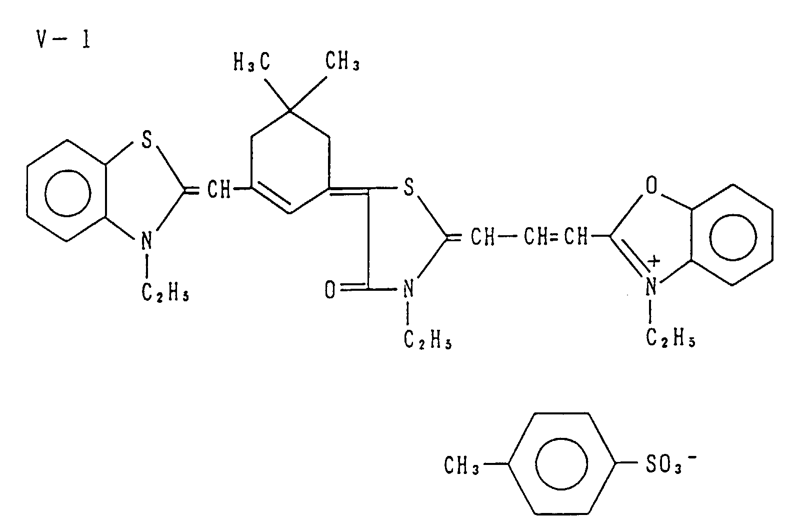

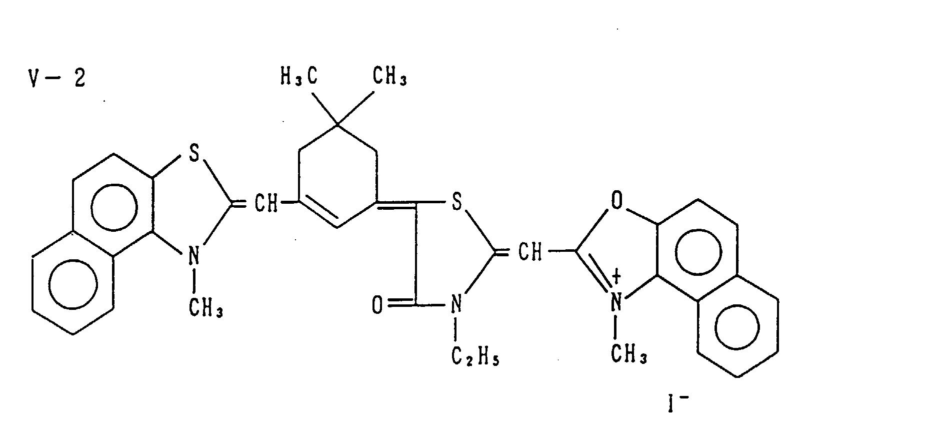

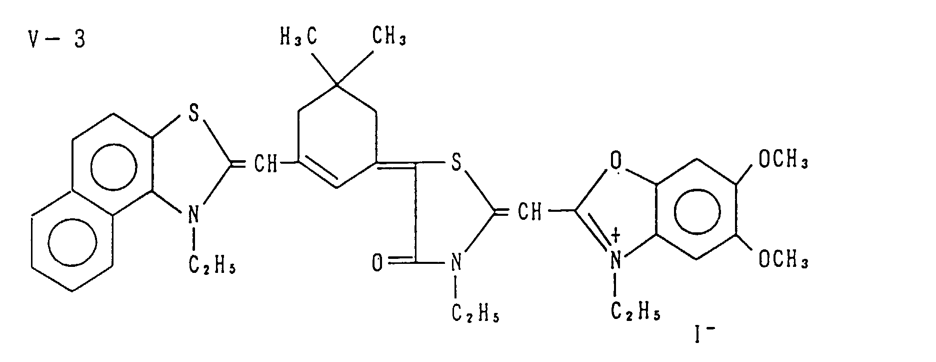

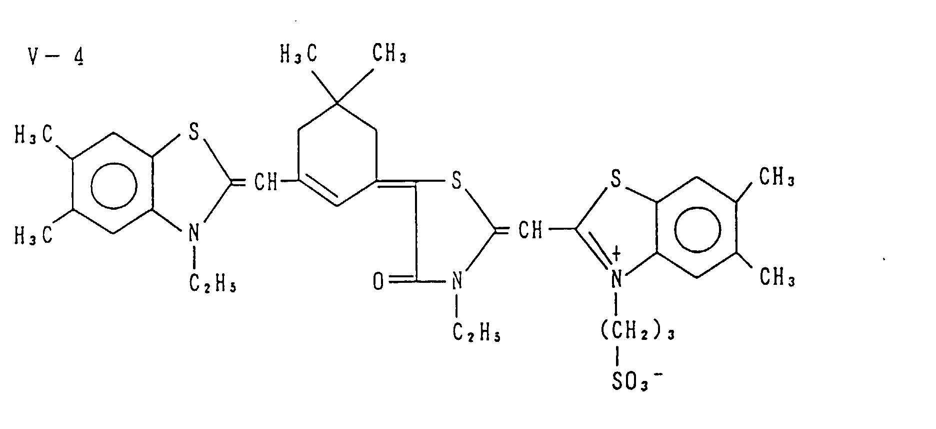

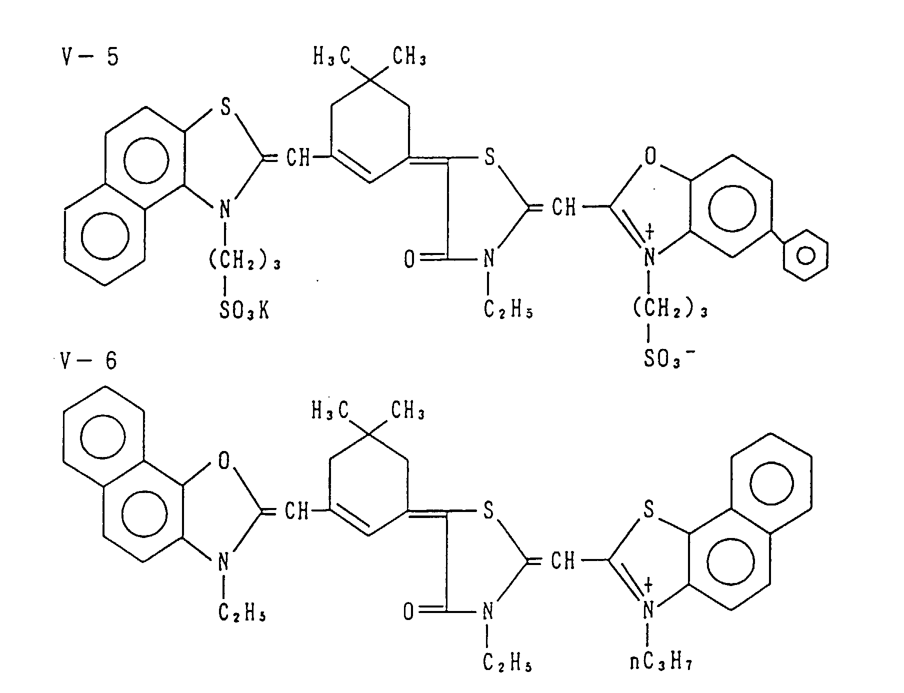

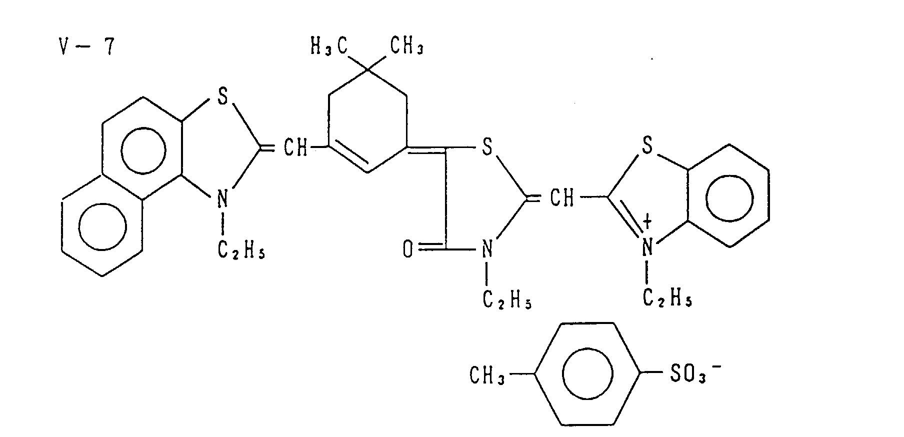

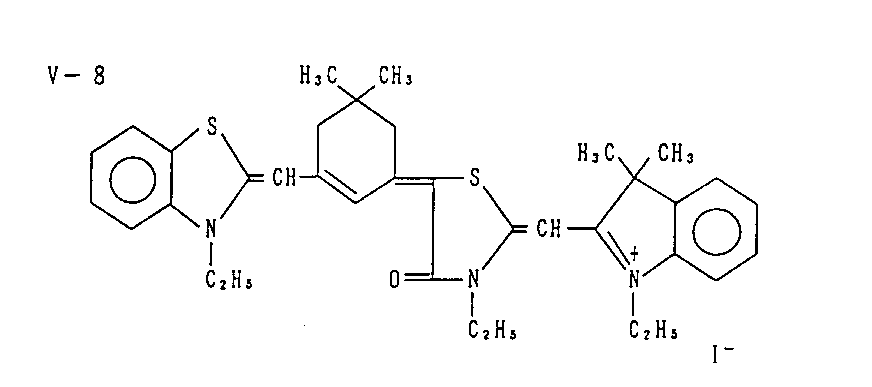

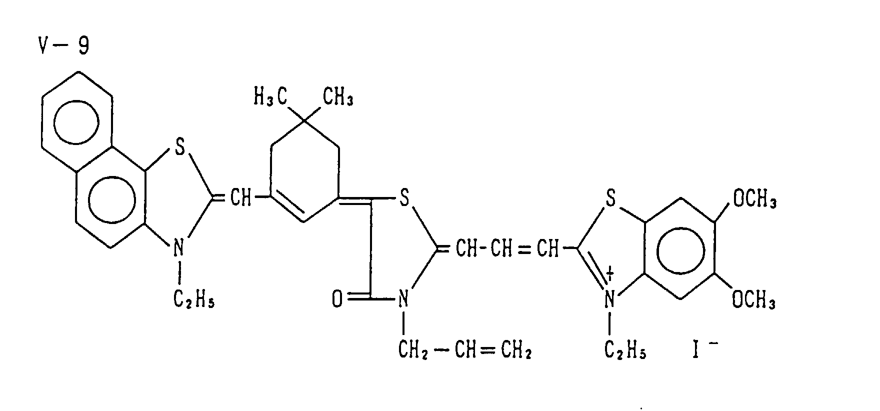

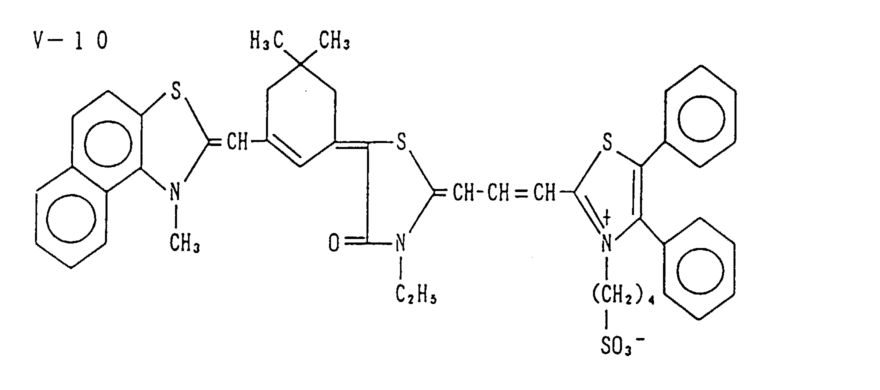

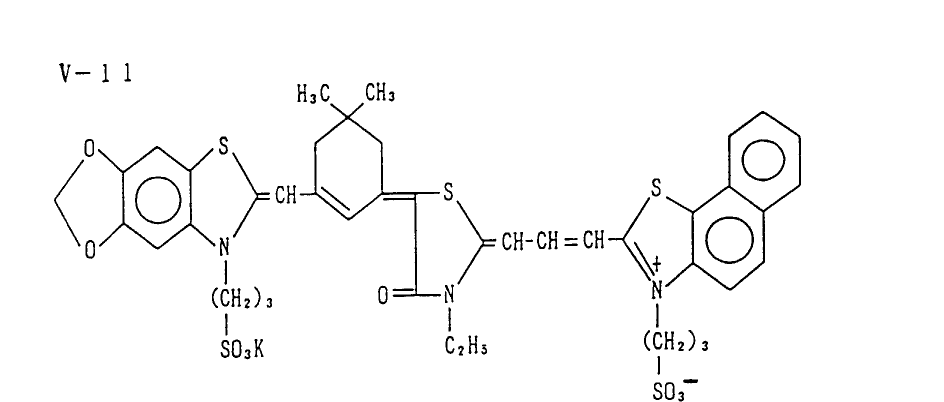

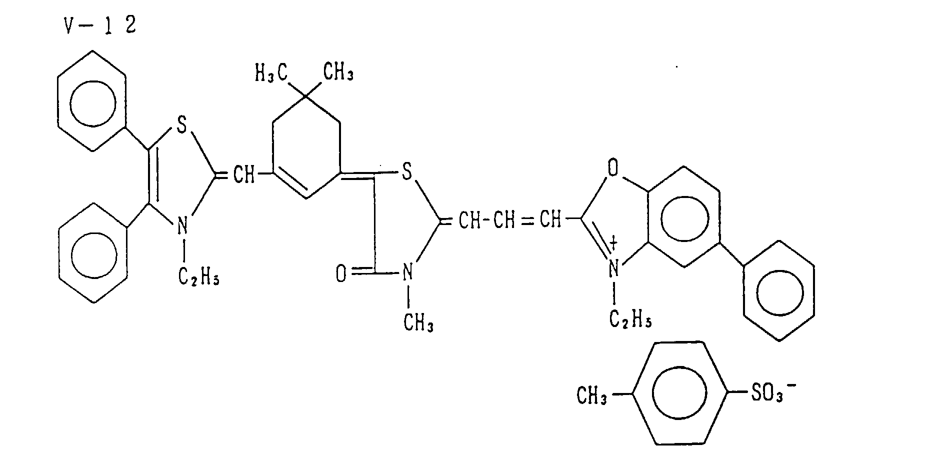

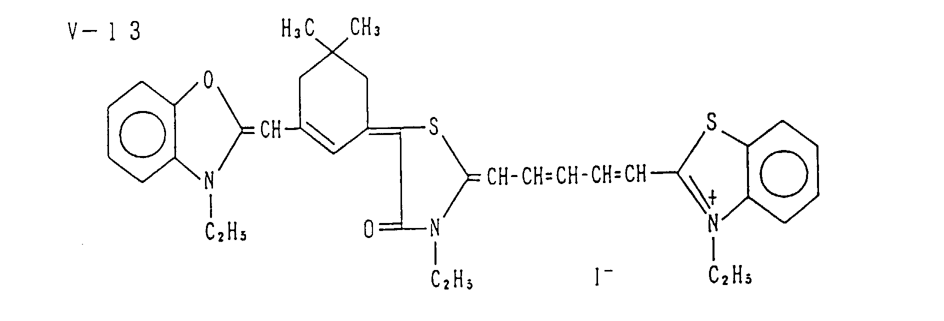

The sensitizing dyes used herein may be synthesized by commonly known techniques. The sensitizing dye may be added to a silver halide emulsion at any stage before the emulsion is coated. The sensitizing dye may be added in a varying amount although the preferred amount is from 1x10⁻⁵ to 1x10⁻² mol per mol of silver halide. The optimum amount of the sensitizing dye added varies with conditions of the silver halide emulsion including the halogen composition, the mean grain size and crystal habit of silver halide grains and the like.

In the emulsion layer or another hydrophilic colloidal layer, water-soluble dyes may be contained as the filter dye or for anti-irradiation or other purposes. Preferred filter dyes are dyes for further reducing photographic sensitivity and dyes having substantial light absorption in the range of 330 to 800 nm for increasing safety against safe light. In accordance with their purpose, these dyes are added to an emulsion layer or above a silver halide emulsion layer, that is, a non-photosensitive hydrophilic colloid layer disposed remote from the silver halide emulsion with respect to the support in a fixed manner. They are generally added in amounts of 10⁻² g/m² to 1 g/m², preferably 50 mg/m² to 500 mg/m² depending on the molar extinction coefficient thereof. Exemplary dyes are described in JP-A 064039/1988.

In the practice of the invention, various other compounds can be added to lithographic printing material for the purposes of preventing fogging and stabilizing photographic performance during preparation, storage or processing of the lithographic printing material. Such additives include azoles, for example, benzothiazolium salts, nitroindazoles, chlorobenzimidazoles, bromobenzimidazoles, mercaptothiazoles, mercaptobenzothiazoles, mercaptothiadiazoles, aminotriazoles, benzothiazoles, and nitrobenzotriazoles; mercaptopyrimidines; mercaptotriazines; thioketo compounds such as oxazolinethion; azaindenes such as triazaindenes, tetraazaindenes (e.g., 4-hydroxy substituted (1,3,3a,7)tetraazaindenes), and pentaazaindenes; benzenethiosulfonic acid, benzenesulfinic acid, and benzenesulfonic amide, which are known as antifoggants or stabilizers.

The lithographic printing material of the invention includes an emulsion layer to which an agent may be added for providing increased sensitivity, increased contrast, or accelerated development. Such agents include polyalkylene oxides or derivatives thereof such as ethers, esters and amines, thioether compounds, thiomorpholine compounds, quaternary ammonium salt compounds, urethane derivatives, urea derivatives, imidazole derivatives, and developing agents such as dihydroxybenzenes and 3-pyrazolidones. Preferred among others are dihydroxybenzenes such as hydroquinone, 2-methylhydroquinone and catechol and 3-pyrazolidones such as 1-phenyl-3-pyrazolidone and 1-phenyl-4-methyl-4-hydroxymethyl-3-pyrazolidone. They are generally used in a coverage of less than 5 g/m². Preferably the dihydroxybenzenes are used in a coverage of 0.01 to 2.5 g/m² while the pyrazolidones are used in a coverage of 0.01 to 0.5 g/m².

The lithographic printing material of the present invention is generally in the form of a silver salt offset printing material of a basic layer structure including an anti-halation layer as a substratum on a support, a photosensitive silver halide emulsion layer on the substratum, and a physical development nucleus layer on the emulsion layer. An intermediate layer may be interposed between any two adjacent layers. Preferably, the printing material of the invention has a physical development nucleus layer disposed directly on a photosensitive silver halide emulsion layer.

The anti-halation layer disposed nearest to the support is a hydrophilic colloid layer having carbon black dye or pigment dispersed therein. To impart printability to the anti-halation layer or emulsion layer, fine powder having a size of 1 to 10 µm such as silica may be added.

Included in the silver halide emulsion used herein is a hydrophilic binder which is generally gelatin. Also advantageously gelatin may be modified by partially or entirely replacing by synthetic polymers such as polyvinyl alcohol, poly-N-vinyl pyrrolidone, polyacrylic acid copolymers, and methyl vinyl ether/maleic anhydride copolymers or cellulose derivatives, gelatin derivatives or the like. Various other compounds can be added to the emulsion for the purposes of preventing fogging during development and providing stabilization during preparation or storage as previously described.

In addition to the above-mentioned compounds, there may be used various other additives such as hardeners and surfactants. Exemplary compounds are described in Product Licensing Index, Vol. 92, No. 9232, pages 107-110, I-XIII, XVI-XVII and XXIII (December 1971).

The thus prepared emulsion is coated as a layer on the anti-halation layer by a commonly known technique to form a photosensitive silver halide emulsion layer according to the present invention.

Also included in the printing material is a physical development nucleus layer. Physical development nuclei may be provided by reducing water-soluble salts of noble metals such as gold, silver, platinum and palladium or heavy metals such as zinc, lead, cadmium, nickel, cobalt, iron, chromium, tin, antimony and bismuth to form metal colloids, or by mixing water-soluble salts of such metals, for example, nitrates, acetates, borates, chlorides and hydroxides with water-soluble sulfides such as sodium sulfide.

A hydrophilic binder is used in the physical development nucleus layer. Useful binders are the same hydrophilic polymers as previously described for the photosensitive silver halide emulsion layer, with gelatin, polyvinyl alcohol or methyl vinyl ether/maleic anhydride copolymers or mixtures thereof being preferred. The amount of the hydrophilic binder used ranges from 30% to 100% based on the weight of the physical development nuclei although it varies with a particular type of noble metal or binder.

Preferably the physical development nucleus layer is coated directly on the photosensitive silver halide emulsion layer.

The support for the offset printing material of the invention includes all types of support commonly used in the art, for example, nitrate film, cellulose acetate film, cellulose acetate butyrate film, polystyrene film, polyethylene phthalate film, polycarbonate film, and laminates thereof, as well as paper. Also useful are baryta and paper coated or laminated with α-olefin polymers, especially polymers of α-olefins having 2 to 10 carbon atoms such as polyethylene, polypropylene, and ethylene-butylene copolymers. The supports may be modified by the surface roughening method for providing enhanced bond to other polymers as described in JP-B 19068/1972 or the surface roughening method of JP-B 135840/1981. Another useful support is paper laminated with metal foil such as aluminum foil for minimizing plate elongation.

Colloidal silica may be used in a coating applied to the polyolefin surface for the purposes of improving adhesion to the polyolefin coated surface or improving printability. In this regard, reference is made to US Patent No. 3,161,519.

To enhance the bonding force between the support and a coating, the support on the surface may be pretreated by corona discharge treatment, ultraviolet exposure or flame treatment. With respect to the corona discharge treatment, reference is made to US Patent No. 2,018,189.

Hardening of the silver halide emulsion and/or other layers can be achieved by conventional techniques. Useful hardeners include aldehydes such as formaldehyde and glutaraldehyde; ketones such as diacetyl and cyclopentanedione; bis(2-chloroethylurea), 2-hydroxy-4,6-dichloro-1,3,5-triazine; compounds having reactive halogen as described in USP 3,288,775 and 2,732,303 and UKP 974,723 and 1,167,207; divinyl sulfone, 5-acetyl-1,3-diacryloylhexahydro-1,3,5-triazine; compounds having reactive olefin as described in USP 3,635,718, 3,232,763, 3,490,911 and 3,642,486 and UKP 994,869; N-hydroxymethylphthalimide; N-methylol compounds as described in USP 2,732,316 and 2,586,168; isocyanates as described in USP 3,103,437; aziridines as described in USP 3,017,280 and 2,983,611; acid derivatives as described in USP 2,725,294 and 2,725,295; carbodiimides as described in USP 3,100,704; epoxy compounds as described in USP 3,091,537; isooxazoles as described in USP 3,321,313 and 3,543,292; halogenocarboxyaldehydes such as mucochloric acid; and dioxane derivatives such as dihydroxydioxane and dichlorodioxane; as well as inorganic hardeners such as chromium alum and zirconium sulfate. Instead of the foregoing compounds, there may be used precursors, for example, alkali metal bisulfite aldehyde adducts, hydantoin methylol derivatives, and primary aliphatic nitroalcohols.

If desired, well-known surfactants may be added alone or in admixture to any of the layers of the offset printing material. The surfactants may be used as coating aids and as the case may be, used for other purposes, for example, emulsifying dispersion, development acceleration, improvement of photographic properties, electric charge row adjustment, and antistatic purposes.

Included in the surfactant are natural products such as saponin; anionic or nonionic surfactants such as alkylene oxide, glycerines and glycidols; cationic surfactants such as higher alkyl amines, quaternary ammonium salts, pyridine and other heterocyclics, phosphonium and sulfonium; anionic surfactants having an acidic group such as carboxylic acids, sulfonic acids, phosphoric acids, sulfates, phosphates; and ampholytic surfactants such as sulfates and phosphates of amino acids, aminosulfonic acids, and aminoalcohols.

Examples of the surfactant used herein are described in USP 2,271,623, 2,240,472, 2,288,226, 2,739,891, 3,068,101, 3,158,484, 3,201,253, 3,210,191, 3,294,540, 3,415,649, 3,441,413, 3,442,654, 3,475,774, and 3,545,574, UKP 1,077,317 and 1,198,450, Oda Ryohei et al., "Kaimen-Kasseizai No Gosei To Sono Oyo (Synthesis of Surfactants and their Application)", Maki-Shoten, 1964, A.W. Perry, "Surface Active Agent", Interscience Publication Inc., 1958, and J.P. Sisley, "Encyclopedia of Active Agent", Vol. 2, Chemical Publish Co., 1964.

As previously described, filter dyes or anti-irradiation dyes may be contained in the offset printing material of the invention. Exemplary dyes are described in USP 2,274,782, 2,527,583, 2,956,879, 3,177,078 and 3,252,921 and JP-B 22069/1964. These dyes may be mordanted by the method described in USP 3,282,699, if desired. The anti-halation layer can be a colored layer containing a pigment such as lamp black, carbon black, fest black, ultramarine, Malachite Green, and Crystal Violet.

Any of well-known coating techniques may be used to coat layers on the support for constituting the offset printing material of the invention. Exemplary techniques include dipping, air knife, and extrusion doctor techniques, with the bead coating technique described in USP 2,761,791 being most preferred.

The layers of the offset printing material of the invention may have a silver halide developing agent incorporated therein, whereby the development after exposure can be an activating treatment with an aqueous alkaline solution.

The developing agent can be contained in a silver halide emulsion layer, an anti-halation layer or a layer adjacent thereto (a substratum or an intermediate layer), most preferably in the anti-halation layer. Understandably, the aqueous alkaline solution used for development may also contain a developing agent.

Examples of the developing agent include polyhydroxybenzenes such as hydroquinone, catechol, chlorohydroquinone, pyrogallol, bromohydroquinone, isopropylhydroquinone, toluhydroquinone, methylhydroquinone, 2,3-dichlorohydroquinone, 2,5-dimethylhydroquinone, 2,3-dibromohydroquinone, 1,4-dihydroxy-2-acetophenone, 4-phenylcatechol, 4-t-butylcatechol, 4-n-butylpyrogallol, 4,5-dibromocatechol, 2,5-diethylhydroquinone, 2,5-benzoylaminohydroquinone, 4-benzyloxycatechol, and 4-n-butoxycatechol. Preferred are hydroquinone and methylhydroquinones.

Other useful developing agents are 3-pyrazolidones such as 1-phenyl-3-pyrazolidone, 1-p-tolyl-3-pyrazolidone, 1-phenyl-4-methyl-3-pyrazolidone, 1-phenyl-4,4-dimethyl-3-pyrazolidone, 1-p-chlorophenyl-3-pyrazolidone, 1-p-methoxyphenyl-3-pyrazolidone, 1-phenyl-2-acetyl-3-pyrazolidone, 1-phenyl-5,5-dimethyl-3-pyrazolidone, 1-o-chlorophenyl-4-methyl-4-ethyl-3-pyrazolidone, 1-m-acetamidophenyl-4,4-diethyl-3-pyrazolidone, 1,5-diphenyl-3-pyrazolidone, 1-(m-tolyl)-5-phenyl-3-pyrazolidone, 4,4-dihydroxymethyl-1-phenyl-3-pyrazolidone, 4,4-dihydroxymethyl-1-tolyl-3-pyrazolidone, 4-hydroxymethyl-4-methyl-1-phenyl-3-pyrazolidone, and 4-hydroxymethyl-4-methyl-1-(p-chlorophenyl)-3-pyrazolidone.

Also useful are aminophenols such as p-(methylamino)-phenol, p-aminophenol, 2,4-diaminophenol, p-(benzylamino)-phenol, 2-methyl-4-aminophenol, and 2-hydroxymethyl-4-aminophenol.

The developing agents may be used alone or in combination. Combinations of a polyhydroxybenzene and a 3-pyrazolidone are especially preferred. The amount of the developing agent in a layer is not fixed although it is preferably in the range of 0.001 gram to 1 gram per square meter, and when added to the silver halide emulsion layer, in the range of 0.01 gram to 3 gram per gram of silver halide.

If desired, a compound, known as a complexing agent, which tends to form a soluble silver complex with silver halide in unexposed areas may be contained in any layer for advantageously accelerating physical development. The complexing agents include thiosulfates, thiocyanates, amine thiosulfates as described in USP 3,169,962, cyclic imides as described in USP 2,857,276, and mercapto compounds as described in JP-B 11957/1971.

The developing agent may be added to a coating solution by dissolving it in water or a hydrophilic solvent such as methanol or by dissolving it in a high or low-boiling organic solvent. The high-boiling organic solvents are those having a boiling point of higher than about 180°C, for example, alkyl phthalates such as ethyl phthalate and n-butyl phthalate and phosphates such as tricresyl phosphate. The low-boiling organic solvents are those having a boiling point between about 30°C and about 150°C, for example, lower alkyl acetates such as ethyl acetate and butyl acetate. These high and low-boiling organic solvents may be used in admixture. The thus dissolved developing agent can be dispersed in hydrophilic colloid by any of well-known techniques.

When the developing agent is added to any one or more of the layers of the offset printing material according to the invention, it can be added directly to the layer. Alternatively, its solution is added to gelatin or synthetic polymers such as polyvinyl alcohol, polyvinyl pyrrolidone, alkyl acrylates as described in USP 3,488,708, sulfoalkyl acrylates and copolymers of acrylic acid.

On alkali activation treatment of the offset printing material of the invention after exposure, there may be used treating solutions containing various compounds. Typical additives include alkaline agents (e.g., hydroxides, carbonates and phosphates of alkali metals and ammonium), pH adjusting or buffering agents (e.g., weak acids such as acetic acid and sulfuric acid, weak bases, and salts thereof), development accelerators (for example, pyridinium compounds and cationic compounds as described in USP 2,648,604 and 3,671,247, potassium nitrate and sodium nitrate, polyethylene glycol condensates and derivatives thereof as described in USP 2,533,990, 2,577,127, and 2,950,970, nonionic compounds such as polythio ethers as typified by the compounds described in UKP 1,020,032 and 1,020,033, polymers having a sulfite ester as typified by the compounds described in USP 3,068,097, organic amines such as pyridine, ethanol amine and cyclic amines, benzyl alcohol, and hydrazines), antifoggants (for example, alkali chlorides, alkali bromides, alkali iodides, nitrobenz-imidazoles as described in USP 2,496,940 and 2,656,271, mercaptobenzimidazole, 5-methylbenzotriazole, and 1-phenyl-5-mercaptotetrazole, compounds for rapid processing solutions as described in USP 3,113,864, 3,342,596, 3,295,976, 3,615,522, and 3,597,199, thiosulfonyl compounds as described in UKP 972,211, phenazine-N-oxides as described in JP-B 41675/1971, and fog suppressing agents as described in "Scientific Photography Manual", Mid Volume, pages 29-47), anti-stain or sludge agents as described in USP 3,161,513, 3,161,514, UKP 1,030,442, 1,144,481 and 1,251,558, and preservatives (for example, sulfites, acidic sulfites, hydroxylamine hydrochloride, formsulfite, and alkanolamine sulfite adducts). Also useful are metal blocking agents such as sodium hexametaphosphate and ethylenediaminetetraacetic acid and humectants such as saponin and ethylene glycol.

Further contained in the developer are silver halide solvents such as sodium thiosulfate, sodium thiocyanate, potassium thiocyanate, alkanol amines, cyclic imines, alkyl-substituted aminoalcohols, thiourea, meso ion, thiosalicylic acid, and compounds capable of generating thiosalicylic acid in alkaline solution, such as 5-methylcarbamoylthiosalicylic acid.

If it is desired to stop development after the offset printing material of the present invention is developed, a neutralizing solution is used. The neutralizing solution may be a conventional acidic stop bath, typically adjusted at pH 3.0 to 8.0. The neutralizing solution may contain a water softening agent, pH adjusting agent, buffer agent and hardener while colloidal silica or polyols may be added for the purpose of avoiding ink staining of the printing plate being processed therewith.

The printing material is processed as described above to obtain a printing plate which is post-treated in various ways for the purpose of improving the printability thereof. For improving ink receptivity, for example, the printing plate may be treated by the methods described in USP 3,592,647, 3,490,906, and 3,161,508, and JP-B 10910/1971, 29723/1973, 15762/1976, and 15762/1977.

### EXAMPLE

Examples of the present invention are given below by way of illustration and not by way of limitation.

### Example 1

### Preparation of emulsions

Internal latent image type silver halide emulsions A to D and surface latent image type silver halide emulsion E were prepared by the following procedures.

### Emulsion A

With vigorous stirring, an aqueous solution of potassium bromide and an aqueous solution of silver nitrate were concurrently added to an aqueous gelatin solution at 75°C over 5 minutes in the presence of 1,8-dihydroxy-3,6-dithiaoctane solvent, obtaining an emulsion of octahedral silver bromide having a mean grain size of 0.15 µm. After the emulsion was adjusted to pAg 8.20, sodium thiosulfate and chloroauric acid (tetrahydrate), each 115 mg per mol of Ag, were added to the emulsion, which was heated at 75°C for 50 minutes for chemical sensitization. A shell was formed on the thus obtained silver bromide grains serving as the core by adding the solutions to the emulsion over 40 minutes under the same precipitation environment as in the first precipitation while controlling the pAg of the emulsion at 7.50, thereby allowing the grains to further grow. There was eventually obtained a monodispersed emulsion of cubic core/shell silver bromide having a mean grain size of 0.25 µm. After water washing and desalting, sodium thiosulfate and chloroauric acid (tetrahydrate), each 3.4 mg per mol of Ag, were added to the emulsion, which was heated at 75°C for 60 minutes for chemical sensitization. There was obtained an internal latent image type silver halide emulsion designated emulsion A.

### Emulsion B

An aqueous solution of potassium bromide and an aqueous solution of silver nitrate were concurrently added to an aqueous gelatin solution at 75°C over 5 minutes, obtaining an emulsion of octahedral silver bromide having a mean grain size of 0.1 µm. After the emulsion was adjusted to pAg 8.0, 130 mg per mol of Ag of sodium thiosulfate and chloroauric acid (tetrahydrate) were added to the emulsion, which was heated at 75°C for 60 minutes for chemical sensitization. A shell was formed on the thus obtained silver bromide grains serving as the core by adding a mixed aqueous solution of sodium chloride and potassium bromide containing ammonium chloroiridate (IV) and an aqueous solution of silver nitrate to the emulsion over 60 minutes while controlling the pAg of the emulsion at 7.8, thereby allowing the grains to further grow. There was eventually obtained a monodispersed emulsion of cubic core/shell silver chlorobromide (Br 20 mol%) having a mean grain size of 0.4 µm (containing 2.1x10⁻⁸ mol of iridium per mol of Ag). After water washing and desalting, sodium thiosulfate and chloroauric acid (tetrahydrate), each 12 mg per mol of Ag, were added to the emulsion, which was heated at 75°C for 60 minutes for chemical sensitization. There was obtained an internal latent image type silver halide emulsion designated emulsion B.

### Emulsion C

The procedure of emulsion B was repeated except that the composition of the shell-forming halide solution was changed, obtaining a monodispersed emulsion of cubic core/shell silver chlorobromide (Br 5 mol%) designated emulsion C.

### Emulsion D

An aqueous solution of sodium chloride and an aqueous solution of silver nitrate were concurrently added to an aqueous gelatin solution at 50°C over 10 minutes, obtaining an emulsion of cubic silver chloride having a mean grain size of 0.3 µm. Solutions of potassium bromide and potassium iodide were added to the emulsion, which was ripened at 40°C for one hour. After sedimentation and water washing, there was obtained an emulsion of silver (iodo)chlorobromide AgBr₂₀Cl_{79.7}(I_{0.3}) having a grain size of 0.33 µm, which was an internal latent image type silver halide emulsion D of the conversion type.

### Emulsion E (comparison)

A mixed aqueous solution of sodium chloride and potassium bromide and an aqueous solution of silver nitrate were concurrently added to an aqueous gelatin solution at 50°C over one minute, obtaining an emulsion of cubic silver chlorobromide (AgCl₉₈Br₂) having a mean grain size of 0.3 µm. After sedimentation and water washing, sodium thiosulfate and chloroauric acid (tetrahydrate) were added to the emulsion, which was heated at 60°C for chemical sensitization. There was obtained a surface latent image type silver halide emulsion designated emulsion E.

### Preparation of lithographic printing plates

A pre-treated polyester film support on one surface was coated with a matte layer containing silica particles having a mean particle size of 5 µm. The support on the other surface was coated with an anti-halation undercoat layer containing carbon black and 20% by weight based on the photographic gelatin of silica powder having a mean particle size of 7 µm and a layer of emulsion A to which 2.5x10⁻⁶ mol of a nucleating agent N-I-15, 8.8x10⁻⁴ mol of a nucleation accelerating agent III-1, and 1.2x10⁻³ mol of a sensitizing dye IV-12 were added, the molar amounts being per mol of Ag. The undercoat layer contained 3.1 g/m² of gelatin, and the emulsion layer contained 1.3 g/m² of gelatin and had a silver coverage of 1.3 g/m². Both the undercoat and emulsion layers used formalin as the hardener. On the emulsion layer, a polyvinyl alcohol solution containing PdS nuclei as physical development nuclei was coated and dried, obtaining a lithographic printing plate sample (1).

The procedure of plate sample (1) was repeated except that emulsion A was replaced by emulsions B, C and D, obtaining lithographic printing plate samples (2), (3) and (4), respectively. The procedure of plate sample (1) was repeated except that emulsion A was replaced by emulsion E and the nucleating agent and the nucleation accelerating agent were omitted, obtaining a lithographic printing plate sample (5).

Using a high illuminance sensitometer, these lithographic printing plate samples (1) to (5) were exposed to a dot image having an area of 5% to 95% of a gray contact screen of 39.37 to 78.74 lines/cm (100 to 200 lines/inch) for 10⁻⁷ second through an interference filter of 488 nm. They were then processed with a developer X of the following composition at 30°C for 30 seconds. Immediately after development, the samples were treated with a neutralizing solution of the following composition at 25°C for 15 seconds, removed of excess water through squeeze rollers, and dried at room temperature.

| Developer X | |
|---|---|
| Water | 700 ml |
| Potassium hydroxide | 23 g |
| Anhydrous sodium sulfite | 50 g |
| Hydroquinone | 36 g |
| 2-mercaptobenzoic acid | 1.5 g |
| 2-methylaminoethanol | 15 g |
| 2-methylimidazole | 2.0 g |
| Uracil | 2.0 g |
| Water totaling to | 1 liter (pH 11.0) |

| Neutralizing solution | |
|---|---|
| Water | 600 ml |
| Citric acid | 11 g |
| Sodium citrate | 36 g |
| Colloidal silica (20% solution) | 6 ml |
| Ethylene glycol | 6 ml |
| Water totaling to | 1 liter |

The lithographic printing plate samples (1) to (5) were evaluated for resolving power. Using gray contact screens of 39.37, 52.36, 59.06, 68.90 and 78.74 lines/cm (100, 133, 150, 175 and 200 lines/inch), the line number of the screen at which a fine network image (5% dot) could be clearly reproduced was determined. The resolving power was evaluated 0 in five ratings from rating 1 [39.37 lines/cm] (100 lines/inch) to rating 5 [78.74 lines/cm] (200 lines/inch).

Further each lithographic printing plate prepared using a contact screen was mounted in an offset printing machine, and a desensitizing solution of the following composition was spread throughout the plate surface. The machine was operated for printing while dampening the plate with a fountain solution of the following composition.

| Desensitizing solution | |
|---|---|
| Water | 550 ml |
| Isopropyl alcohol | 450 ml |
| Ethylene glycol | 50 g |
| Compound A (below) | 1 g |

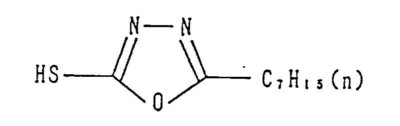

| Fountain solution | |
|---|---|
| o-phosphoric acid | 10 g |
| Nickel nitrate | 5 g |
| Sodium sulfite | 5 g |
| Ethylene glycol | 100 g |
| Colloidal silica (20% solution) | 28 g |
| Water totaling to | 2 liters |

The offset press was A. B. Dick 350CD (trade mark, by A. B. Dick Company). The printing endurance was evaluated in accordance with the following criterion based on the number of sheets at which scumming occurred or silver lack (pin hole) disabled printing.

| Printing endurance criterion | |
|---|---|
| 1 | up to 4,000 sheets |
| 2 | 4,001 to 6,000 sheets |
| 3 | 6,001 to 8,000 sheets |
| 4 | 8,001 to 10,000 sheets |
| 5 | more than 10,000 sheets |

Also ink receptivity was evaluated by starting paper feed at the same time as an inking roller was contacted against the plate and counting the number of paper sheets fed until an acceptable printed sheet was obtained. The results are shown in Table 1.

**Table 1**

| Sample | Resolving power | Printing endurance | Ink receptivity | Remarks |
|---|---|---|---|---|
| (1) | 5 | 3 | 10 | negative image |
| (2) | 5 | 4 | 8 | negative image |
| (3) | 5 | 5 | 4 | negative image |
| (4) | 4 | 3 | 12 | negative image |
| (5)* | 4 | 3 | 5 | positive image |

| | | | | |
|---|---|---|---|---|
| * comparison | | | | |

As seen from Table 1, the inventive samples using various emulsions produce acceptable negative transfer images, offering acceptable printability comparable to that from positive transfer images. The lithographic printing material for providing negative transfer images was significantly improved in performance.

### Example 2

The procedure of Example 1 was repeated except that each of lithographic printing plate samples (1) to (4) of was developed with a developer Y of the following composition at 30°C for 30 seconds and then with a developer Z of the following composition at 30°C for 30 seconds. The resulting lithographic printing plate bearing a negative transfer image was evaluated for resolving power, printing endurance and ink receptivity. The results are shown in Table 2.

| Developer | Y | Z |
|---|---|---|
| Water | 700 ml | 700 ml |
| Potassium hydroxide | 23 g | 23 g |
| Anhydrous sodium sulfite | 50 g | 50 g |
| Hydroquinone | 36 g | 36 g |
| 2-mercaptobenzoic acid | 1.5 g | 1.5 g |
| 2-methylaminoethanol | - | 15 g |
| 2-methylimidazole | 2.0 g | 2.0 g |
| Uracil | - | 10 g |
| Water totaling to | 1 liter | 1 liter |
| | pH 11.0 | pH 11.0 |

**Table 2**

| Sample | Resolving power | Printing endurance | Ink receptivity | Remarks |
|---|---|---|---|---|
| (1) | 5 | 4 | 8 | negative image |
| (2) | 5 | 5 | 5 | negative image |
| (3) | 5 | 5 | 2 | negative image |
| (4) | 4 | 3 | 9 | negative image |

As seen from Table 2, satisfactory results comparable to those of Example 1 are obtained by effecting conventional chemical development with developer Y free of a silver halide solvent and then diffusion transfer development with developer Z of high dissolving power containing a silver halide solvent although two baths were necessary.

### Example 3

Twenty three lithographic printing plate samples (3)-1 to (3)-23 were prepared by the procedure of lithographic printing plate sample (3) wherein the sensitizing dye was changed as shown in Table 3. The exposure filter used in Example 1 was changed in accordance with the sensitizing dye as shown in Table 3. The remaining conditions were the same as in Example 1. Note that sample (3)-1 is identical with sample (3).

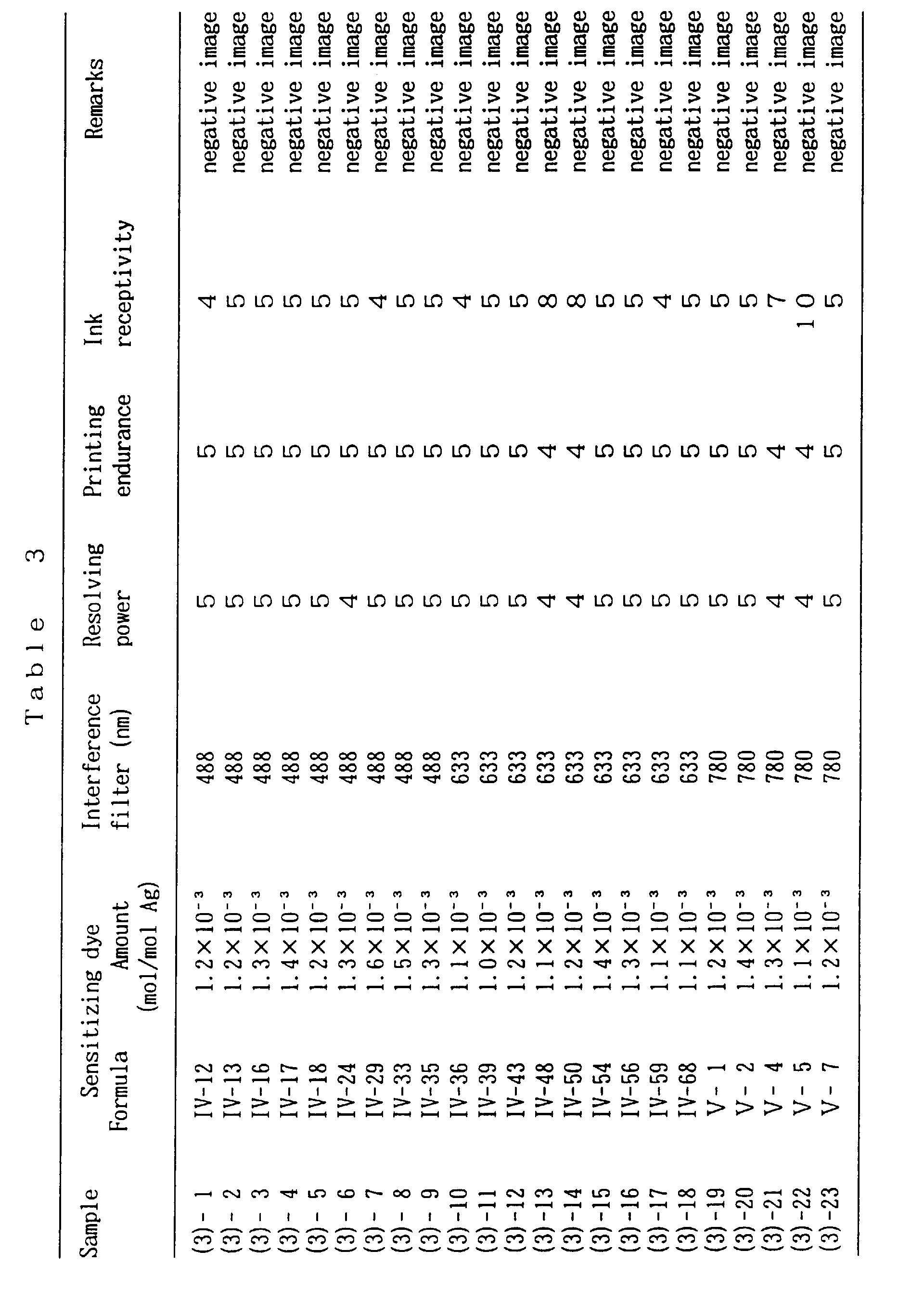

As seen from Table 3, there are obtained lithographic printing plates each having satisfactory printability matching with the wavelength of a particular light source.

### Example 4

A series of lithographic printing plate samples were prepared by repeating the procedure of plate sample (3) of Example 1 except that the nucleating agent and the nucleation accelerating agent were changed as shown in Table 4. They were treated and evaluated as in Examples 1 and 2. The results are shown in Table 4.

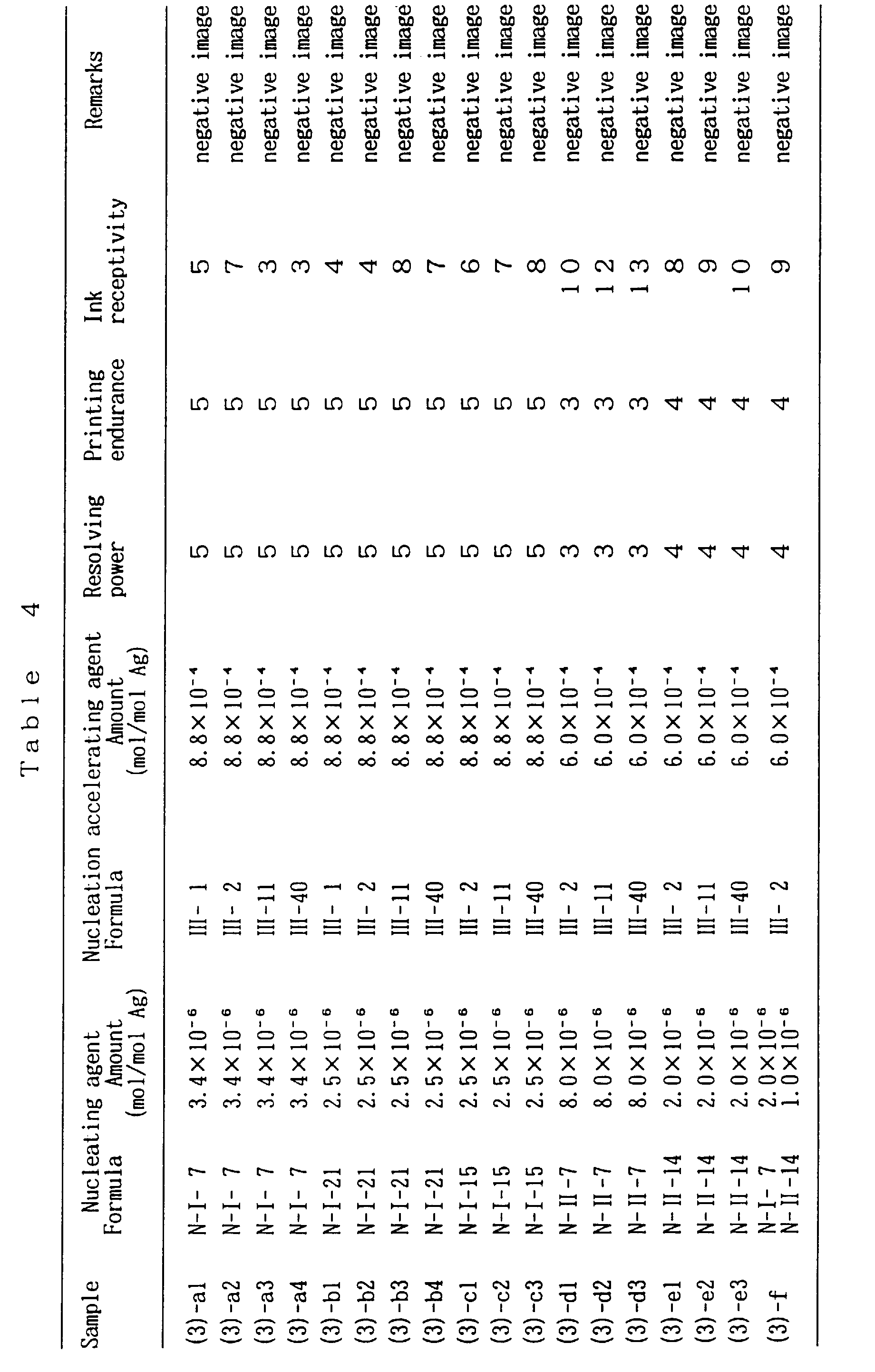

As seen from Table 4, lithographic printing plates having satisfactory printability are obtained using the nucleating agents within the scope of the invention.

There has been described a lithographic printing material wherein a negative transfer image is obtained using a silver salt diffusion transfer process. The material has high sensitivity and high resolving power and the resulting lithographic printing plate has satisfactory printability. The material can accommodate to high illuminance light sources and lend itself to various processing systems.

## Claims

1. A lithographic printing material comprising at least an undercoat layer, a silver halide emulsion layer of the internal latent image type, and a physical development nucleus layer on a support, which is processed by a silver salt diffusion transfer process to provide a negative transfer silver image, wherein
there is contained at least one nucleating agent selected from compounds of the following general formula (I): 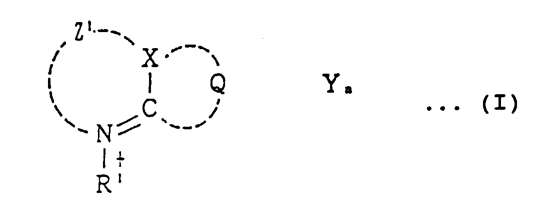 wherein
Z¹ is a group of non-metallic atoms necessary to form a five- or six-membered heterocyclic ring which may have an aromatic or heterocyclic ring fused thereto,
R¹ is an aliphatic radical,
X is a radical represented by 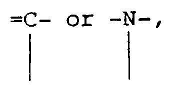
Q is a group of non-metallic atoms necessary to form a 4 to 12-membered non-aromatic hydrocarbon ring or a non-aromatic heterocyclic ring,
at least one of R¹, the substituent on Z¹, and the substituent on Q containing an alkynyl radical,
at least one of R¹, Z¹, and Q may have a radical capable of promoting adsorption to silver halide,
Y is an electric charge balancing counter ion, and
letter n has a value necessary to provide an electric charge balance, and compounds of the following general formula (II): 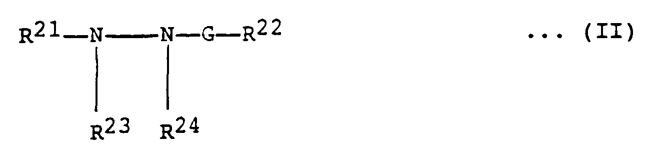 wherein
R²¹ is an aliphatic, aromatic or heterocyclic radical,
R²² is selected from the group consisting of a hydrogen atom, an alkyl, aralkyl, aryl, alkoxy, aryloxy, and amino radical,
G is selected from the group consisting of a carbonyl radical, sulfonyl radical, sulfoxy radical, phosphoryl radical, and iminomethylene radical: HN=C<,
both R²³ and R²⁴ are hydrogen atoms, or one of R²³ and R²⁴ is a hydrogen atom and the other is an alkylsulfonyl, arylsulfonyl or acyl radical, and
G, R²³, and R²⁴ may form with the hydrazine nitrogen atoms a hydrazone structure of the formula: >N-N=C<,
wherein said silver halide emulsion layer further contains at least one sensitizing dye selected from the group consisting of the compounds represented by formulae (IV) and (V): 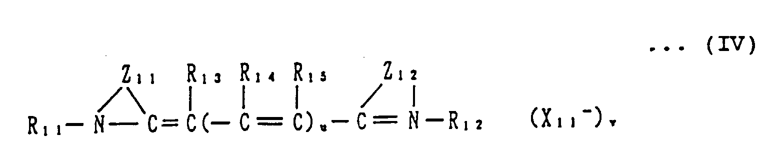 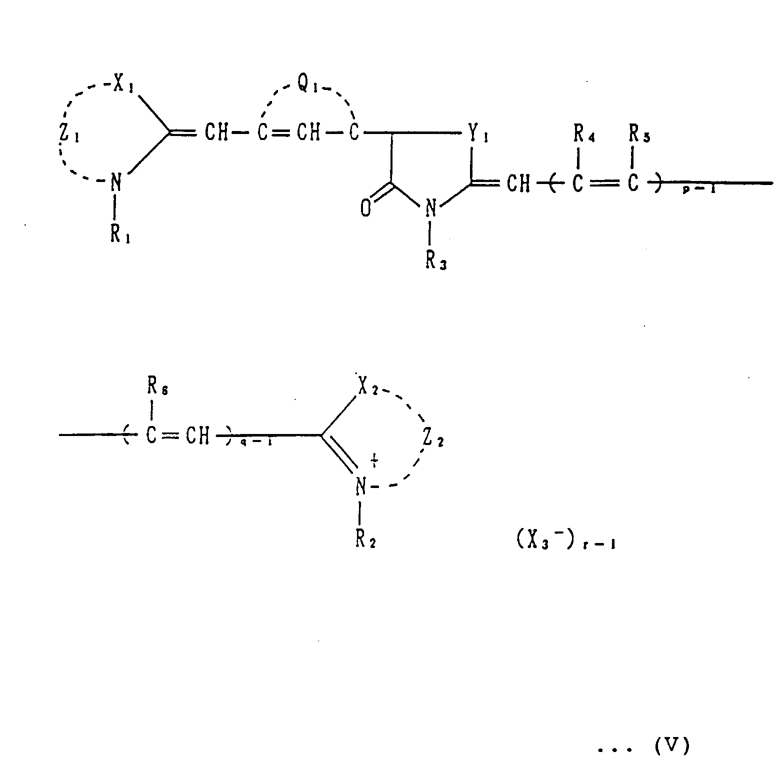
in formula (IV), Z₁₁ and Z₁₂, which may be identical or different, each represent a group of atoms forming a five or six-membered nitrogeneous heterocyclic ring with the nitrogen and carbon atoms, and letter u is equal to 0 or 1, R₁₁ and R₁₂, which may be identical or different, each represent a substituted or unsubstituted alkyl or alkenyl radical having up to 10 carbon atoms in total, R₁₃ and R₁₅ represent hydrogen atoms, or R₁₃ and R₁₁ taken together and R₁₅ and R₁₂ taken together may form a five or six-membered ring, R₁₄ is a hydrogen atom or a lower alkyl radical which may have a substituent, X₁₁ is an acid anion residue, letter v is equal to 0 or 1, and in the case of an internal salt, v is 0,
in formula (V), X₁ and X₂, which may be identical or different, each represent an oxygen atom, sulfur atom, selenium atom, a radical of the formula: >N-R₇ wherein R₇ is an alkyl radical or a radical of the formula: 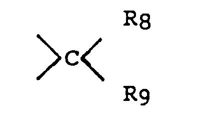 wherein R₈ and R₉ are alkyl radicals, Z₁ and Z₂, which may be identical or different, each represent a group of atoms necessary to form a five-membered nitrogenous heterocyclic ring, R₁ and R₂, which may be identical or different, each represent an alkyl or alkenyl radical, R₃ is an alkyl, alkenyl or aryl radical, R₄, R₅ and R₆, which may be identical or different, each represent a hydrogen atom, halogen atom, alkyl radical or aryl radical, Y₁ represents a sulfur atom, an oxygen atom or a radical of the formula: >N-R₁₀ wherein R₁₀ is an alkyl radical, Q₁ is a group of atoms necessary to form a five or six-membered ring by connecting to the carbon atoms of the methylene linkage, X₃ is an acid anion, and letters p, q and r each are equal to 1 or 2.

2. The lithographic printing material of claim 1 wherein said silver halide emulsion layer contains said nucleating agent.

## Patentansprüche

1. Lithographisches Druckmaterial, umfassend mindestens eine Grundschicht, eine Schicht mit einer Silberhalogenidemulsion vom innenlatenten Bildtyp und eine Schicht mit Keimen für die physikalische Entwicklung, die auf einem Träger aufgebracht sind, das mit einem Silbersalz-Diffusionsübertragungsverfahren verarbeitet wird, um ein negatives Silber-Übertragungsbild zu erzeugen, wobei das Material mindestens einen Keimbildner enthält, ausgewählt aus Verbindungen der folgenden allgemeinen Formel (I): 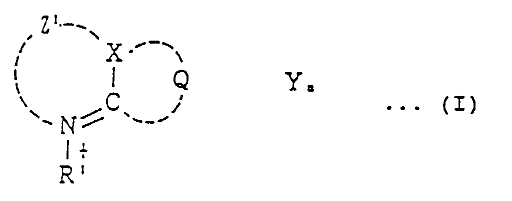
worin Z¹ eine Gruppe aus Nichtmetallatomen ist, die erforderlich ist, um einen 5-oder 6-gliedrigen heterocyclischen Ring zu bilden, an den ein aromatischer oder heterocyclischer Ring gebunden sein kann,
R¹ ist eine aliphatische Gruppe,
X ist eine Gruppe, dargestellt durch 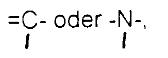
Q ist eine Gruppe aus Nichtmetallatomen, die erforderlich ist, um einen 4- bis 12-gliedrigen nichtaromatischen Kohlenwasserstoffring oder einen nichtaromatischen heterocyclischen Ring zu bilden,
mindestens eine der Gruppen, ausgewählt aus R¹, einem Substituenten an Z¹ und einem Substituenten an Q, enthält eine Alkinylgruppe,
mindestens eine der Gruppen R¹, Z¹ und Q kann eine Gruppe enthalten, welche die Adsorption an Silberhalogenid fördert,
Y ist ein Gegenion zum Ausgleich der elektrischen Ladung, und
n ist eine Zahl, die erforderlich ist, um die elektrische Ladung auszugleichen,
und Verbindungen der folgenden allgemeinen Formel (II): 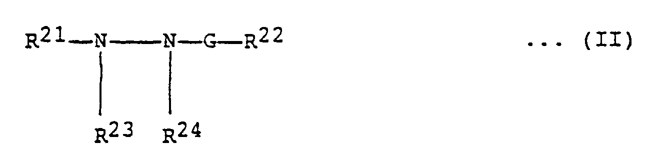 worin R²¹ eine aliphatische, aromatische oder heterocyclische Gruppe ist,
R²² ist ausgewählt aus der Gruppe, bestehend aus einem Wasserstoffatom, einer Alkylgruppe, einer Aralkylgruppe, einer Arylgruppe, einer Alkoxygruppe, einer Aryloxygruppe und einer Aminogruppe,
G ist ausgewählt aus der Gruppe, bestehend aus einer Carbonylgruppe, einer Sulfonylgruppe, einer Sulfoxygruppe, einer Phosphorylgruppe und einer Iminomethylengruppe: HN=C<,
R²³ und R²⁴ sind jeweils Wasserstoffatome, oder eine der Gruppen R²³ und R²⁴ ist ein Wasserstoffatom und die andere Gruppe ist eine Alkylsulfonylgruppe, eine Arylsulfonylgruppe oder eine Acylgruppe, und
G, R²³ und R²⁴ können mit den Hydrazin-Stickstoffatomen eine Hydrazonstruktur der Formel: >N-N=C< bilden,
wobei die Silberhalogenidemulsionsschicht weiterhin mindestens einen sensibilisierenden Farbstoff enthält, ausgewählt aus der Gruppe, bestehend aus den Verbindungen, die durch die Formeln (IV) und (V) dargestellt sind: 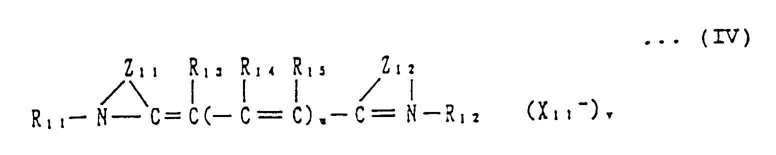 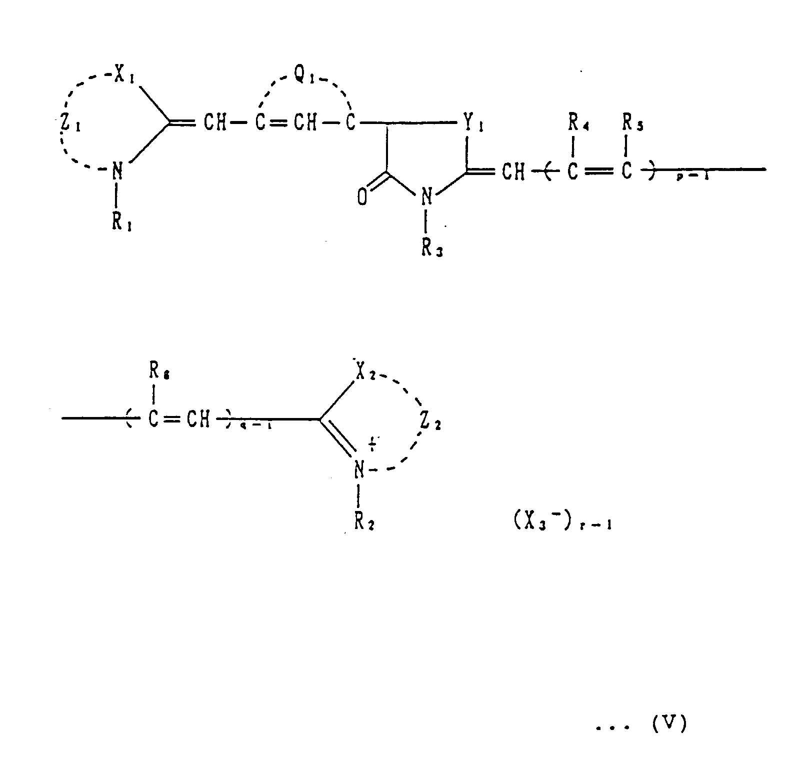
in Formel (IV) bedeuten Z₁₁ und Z₁₂, die gleich oder verschieden sein können, jeweils eine Gruppe aus Atomen, die erforderlich ist, um mit den Stickstoff- und Kohlenstoffatomen einen 5- oder 6-gliedrigen Stickstoff enthaltenden heterocyclischen Ring zu bilden, u ist 0 oder 1, R₁₁ und R₁₂, die gleich oder verschieden sein können, bedeuten jeweils eine substituierte oder unsubstituierte Alkyl- oder Alkenylgruppe mit bis zu insgesamt 10 Kohlenstoffatomen, R₁₃ und R₁₅ bedeuten Wasserstoffatome, oder R₁₂ und R₁₁ oder R₁₅ und R₁₂ können miteinander verbunden sein, um einen 5- oder 6-gliedrigen Ring zu bilden, R₁₄ ist ein Wasserstoffatom oder eine niedere Alkylgruppe, die substituiert sein kann, X₁₁ ist ein anionischer Säurerest, v ist 0 oder 1, und wenn die Verbindung ein inneres Salz bildet, ist v = 0,
in Formel (V) bedeuten X₁ und X₂, die gleich oder verschieden sein können, jeweils ein Sauerstoffatom, ein Schwefelatom, ein Selenatom, eine Gruppe der Formel: >N-R₇, worin R₇ eine Alkylgruppe ist, oder eine Gruppe der Formel: 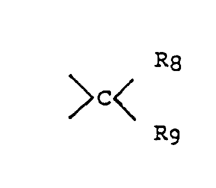
worin R₈ und R₉ Alkylgruppen sind, Z₁ und Z₂, die gleich oder verschieden sein können, bedeuten jeweils eine Gruppe aus Atomen, die erforderlich ist, um einen 5-gliedrigen Stickstoff enthaltenden heterocyclischen Ring zu bilden, R₁ und R₂, die gleich oder verschieden sein können, bedeuten jeweils eine Alkyl- oder Alkenylgruppe, R₃ ist eine Alkylgruppe, eine Alkenylgruppe oder eine Arylgruppe, R₄, R₅ und R₆, die gleich oder verschieden sein können, bedeuten jeweils ein Wasserstoffatom, ein Halogenatom, eine Alkylgruppe oder eine Arylgruppe, Y₁ ist ein Schwefelatom, ein Sauerstoffatom oder eine Gruppe der Formel:
>N-R₁₀, worin R₁₀ eine Alkylgruppe ist, Q₁ ist eine Gruppe aus Atomen, die erforderlich ist, um zusammen mit den Kohlenstoffatomen der Methylenverbindungsgruppe einen 5- oder 6-gliedrigen Ring zu bilden, X₃ ist ein Säureanion, und p, q und r bedeuten jeweils 1 oder 2.

2. Lithographisches Druckmaterial nach Anspruch 1, worin der Keimbildner in der Silberhalogenidemulsionsschicht enthalten ist.

## Revendications

1. Matériau d'impression lithographique comprenant au moins une sous-couche, une couche d'émulsion d'halogénure d'argent du type à image latente interne, et une couche de noyau de développement physique sur un support, qui est traité par un procédé de transfert par diffusion de sel d'argent pour donner une image négative d'argent par transfert, où
il comprend au moins un agent de nucléation choisi parmi les composés de la formule générale suivante (I): 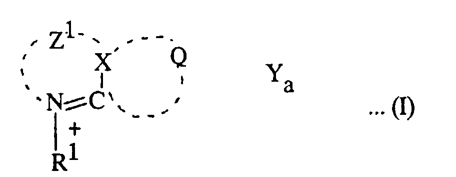 où Z¹ est un groupe d'atomes non métalliques nécessaires pour former un cycle hétérocyclique de 5 ou 6 maillons qui peut avoir un cycle aromatique ou hétérocyclique fusionné avec lui,
R¹ est un radical aliphatique,
X est un radical représenté par 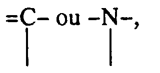
Q est un groupe d'atomes non métalliques nécessaires pour former un cycle hydrocarbure non aromatique de 4 à 12 maillons ou un cycle hétérocyclique non aromatique,
au moins l'un des groupes R¹, le substituant sur Z¹, et le substituant sur Q contient un radical alcynyle,
au moins l'un des groupes R¹, Z¹ et Q peut avoir un radical capable de favoriser l'adsorption sur l'halogénure d'argent,
Y est un ion de signe opposé pour compenser la charge électrique, et
la lettre n a une valeur nécessaire pour former un équilibre de charge électrique, et des composés de la formule générale suivante (II): 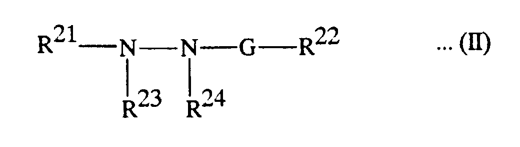 où R²¹ est un radical aliphatique, aromatique ou hétérocyclique,
R²² est choisi dans le groupe constitué d'un atome d'hydrogène, un radical alkyle, aralkyle, aryle, alcoxy, aryloxy et amino,
G est choisi dans le groupe constitué d'un radical carbonyle, un radical sulfonyle, un radical sulfoxy, un radical phosphoryle et un radical iminométhylène : HN=C<,
les deux groupes R²³ et R²⁴ sont des atomes d'hydrogène, ou l'un des groupes R²³ et R²⁴ est un atome d'hydrogène et l'autre est un radical alkylsulfonyle, arylsulfonyle ou acyle, et
G, R²³ et R²⁴ peuvent former avec les atomes d'azote de l'hydrazine une structure hydrazone de formule : >N-N=C<,
où ladite couche d'émulsion d'halogénure d'argent contient en outre au moins un colorant sensibilisant choisi dans le groupe constitué des composés représentés par les formules (IV) et (V) : 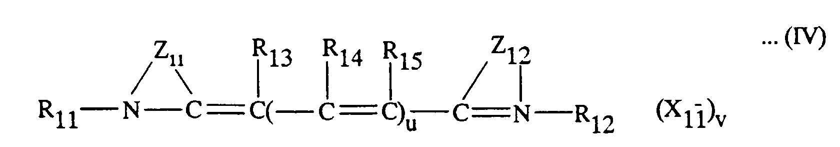 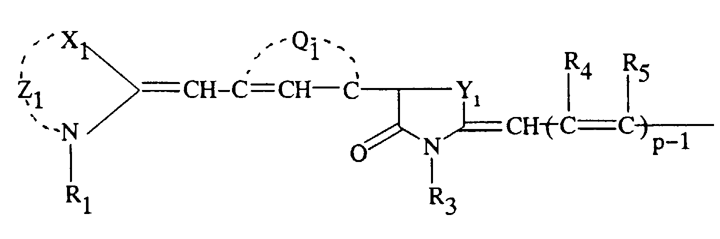 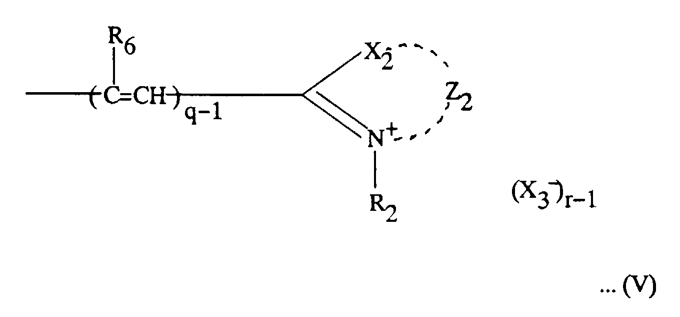
dans la formule (IV), Z₁₁ et Z₁₂ qui peuvent être identiques ou différents, chacun représente un groupe d'atomes formant un cycle hétérocyclique azoté à 5 ou 6 maillons avec l'azote et des atomes de carbone, et la lettre u est égale à 0 ou 1, R₁₁ et R₁₂, qui peuvent être identiques ou différents, représentent chacun un radical alkyle ou alcényle substitué ou non substitué ayant jusqu'à 10 atomes de carbone en tout, R₁₃ et R₁₅ représentent des atomes d'hydrogène, ou R₁₃ et R₁₁ pris ensemble et R₁₅ et R₁₂ pris ensemble peuvent former un cycle à 5 ou 6 maillons, R₁₄ est un atome d'hydrogène ou un radical alkyle inférieur qui peut avoir un substituant, X₁₁ est un reste anion acide, la lettre v est égale à 0 ou 1, et dans le cas d'un sel interne, v est 0,
dans la formule (V), X₁ et X₂ qui peuvent être identiques ou différents, représentent chacun un atome d'oxygène, un atome de soufre, un atome de sélénium, un radical de formule : >N-R₇ où R₇ est un radical alkyle ou un radical de formule : 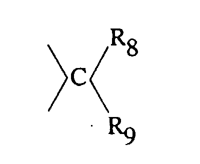 où R₈ et R₉ sont des radicaux alkyle, Z₁ et Z₂, qui peuvent être identiques ou différents, représentent chacun un groupe d'atomes nécessaires pour former un cycle hétérocyclique azoté à 5 maillons, R₁ et R₂, qui peuvent être identiques ou différents, représentent chacun un radical alkyle ou alcényle, R₃ est un radical alkyle, alcényle ou aryle, R₄, R₅ et R₆, qui peuvent être identiques ou différents, représentent chacun un atome d'hydrogène, un atome d'halogène, un radical alkyle ou un radical aryle, Y₁ représente un atome de soufre, un atome d'oxygène ou un radical de formule : >N-R₁₀ où R₁₀ est un radical alkyle, Q₁ est un groupe d'atomes nécessaires pour former un cycle de 5 ou 6 maillons en reliant aux atomes de carbone de la liaison méthylène, X₃ est un anion acide, et les lettres p, q et r représentent respectivement 1 ou 2.

2. Matériau d'impression lithographique selon la revendication 1 où ladite couche d'émulsion à l'halogénure d'argent contient ledit agent de nucléation.
